(19) Europäisches Patentamt
European Patent Office
Office européen des brevets

(11) EP 3 298 638 B1

(12) **EUROPEAN PATENT SPECIFICATION**

(45) Date of publication and mention of the grant of the patent:
**25.08.2021 Bulletin 2021/34**

(21) Application number: **16719212.9**

(22) Date of filing: **27.04.2016**

(51) Int Cl.:
***H01L 51/50*** (2006.01)

(86) International application number:
**PCT/EP2016/000673**

(87) International publication number:
**WO 2016/188604 (01.12.2016 Gazette 2016/48)**

(54) **COMPOSITION COMPRISING AN ORGANIC SEMICONDUCTOR AND A METAL COMPLEX**

MIT EINEM METALLKOMPLEX DOTIERTES ORGANISCHES HALBLEITERMATERIAL

COMPOSITION COMPRENANT UN SEMI-CONDUCTEUR ORGANIQUE ET UN COMPLEXE MÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.05.2015 EP 15001557**

(43) Date of publication of application:
**28.03.2018 Bulletin 2018/13**

(73) Proprietor: **Merck Patent GmbH**
**64293 Darmstadt (DE)**

(72) Inventors:
- **STOESSEL, Philipp**
**60389 Frankfurt am Main (DE)**
- **STEGMAIER, Katja**
**64287 Darmstadt (DE)**
- **HEIL, Holger**
**60316 Frankfurt am Main (DE)**
- **BURKHART, Beate**
**64293 Darmstadt (DE)**
- **VOGES, Frank**
**67098 Bad Duerkheim (DE)**
- **SEIM, Henning**
**64289 Darmstadt (DE)**

(56) References cited:
**WO-A1-2005/061654**

- **GÜNTER SCHMID ET AL: "Fluorinated Copper(I) Carboxylates as Advanced Tunable p-Dopants for Organic Light-Emitting Diodes", ADVANCED MATERIALS, vol. 26, no. 6, 20 December 2013 (2013-12-20), pages 878-885, XP55107776, ISSN: 0935-9648, DOI: 10.1002/adma.201303252**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 298 638 B1

## Description

The present invention relates to a composition comprising at least one hole-transport or/and one hole-injection material and at least one metal complex as a p-dopant. The present invention furthermore relates to electronic devices and to a process for the production thereof.

Electronic devices which comprise organic, organometallic and/or polymeric semiconductors are increasing in importance; they are employed in many commercial products for cost reasons and owing to their performance. Examples which may be mentioned here are organic-based charge-transport materials (for example triarylamine-based hole transporters) in photocopiers, organic or polymeric light-emitting diodes (OLEDs or PLEDs) and in display devices, or organic photoreceptors in photocopiers. Organic solar cells (O-SC), organic field-effect transistors (O-FET), organic thin-film transistors (O-TFT), organic integrated circuits (O-IC), organic optical amplifiers and organic laser diodes (O-lasers) are at an advanced stage of development and may achieve major importance in the future.

Generally, an OLED comprises an anode, a cathode and an organic light emitting unit. The last one comprises several functional layers like hole- or electron-injection layers, hole- or electron-transport layers and organic light emitting layers.

Nowadays, there are two main techniques for the formation of the different functional layers in an OLED device: vacuum evaporation techniques and solution-based coating methods.

The evaporation techniques are the most common technique for the production of OLEDs devices. However, this represents a major cost disadvantage, in particular for large-area devices, since a multistep vacuum process in various chambers is very expensive and must be controlled very precisely. Less expensive and established solution-based coating method, such as, for example, ink-jet printing, airbrush methods, roll-to-roll processes would be a major advantage here.

Thus, for example, WO 2009/021107 A1 and WO 2010/006680 A1 describe organic compounds which are suitable for the production of electronic devices, where these compounds can be processed both via gas-phase deposition and also from solution. However, the electronic devices which are obtained via gas-phase deposition exhibit a more favourable property profile.

In any cases, it is important that the electronic devices obtainable by the different existing processes should have excellent properties.

These properties include, in particular, the lifetime of the electronic devices. A further problem is, in particular, the energy efficiency with which an electronic device achieves the specified object. In the case of organic light-emitting diodes, which may be based both on low-molecular-weight compounds and also on polymeric materials, the light yield, in particular, should be high, so that as little electrical power as possible has to be applied in order to achieve a certain light flux. Furthermore, the lowest possible voltage should also be necessary in order to achieve a specified luminous density. Accordingly, these properties should not be adversely affected by the process.

More particularly, layers which are directly connected to emitting layers, especially hole-transport layers have a great influence on the properties of the adjacent emitting layer. The quality of the hole-injection layer, which is directly connected to the hole-transport layer, plays also a significant role in the performance of the OLED.

Compositions, which comprise an organic semiconductor and a metal complex like in WO2013/182389, can be successfully used as a hole-injection and/or a hole-transport layer for the production of organic electronic components. These kind of compositions can be deposited using either a vacuum evaporation technique or a solution-based coating method. Suitable solution-based coating method are spin-coating methods and methods based on printing processes, such as, for example, screen printing, flexographic printing, nozzle printing or offset printing, LITI (light induced thermal imaging, thermal transfer printing) or ink-jet printing. Document WO 2005/061654 A1 discloses a metal diketonato complex as a light emitting compound for OLEDs.

Although such compositions are known, there is still a need for further compositions, which can be used as hole-injection and/or a hole-transport layers for the production of organic electronic components and which can be deposited using either a vacuum evaporation technique or a solution-based coating method.

It has now been found that compositions comprising at least one hole-transport or/and one hole-injection material and at least one particular metal complex as a p-dopant, lead to very homogenous hole-transport or hole-injection layers for the production of electronic devices, which can be efficiently deposited using a solution-based coating method.

This advantageously lead to electronic devices, which exhibit excellent performance in terms of lifetime, energy efficiency, light yield and working voltage.

Accordingly, the first object of the present invention is a composition comprising at least one hole-transport or/and one hole-injection material which is a polymer comprising a structural unit according formula (I) or a compound according formula (I') as defined in claim 1 and at least one metal complex as a p-dopant, wherein the metal complex is a compound of formula (MC-1):

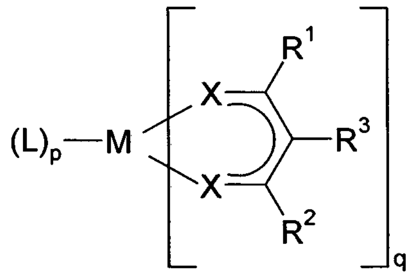

formula (MC-1)

where

M is selected from Ga, In, Ge, Sn, Pb, Sb, Bi, Se or Te;

X is O, $NR^0$ or S;

$R^0$ is selected from H, a straight-chain alkyl having 1 to 40 C atoms or a branched or cyclic alkylhaving 3 to 40 C atoms, each of which may be substituted by one or more radicals $R^4$, where one or more non-adjacent $CH_2$ groups may be replaced by $R^4C=CR^4$, C≡C, $Si(R^4)_2$, C=O, C=S, $C=NR^4$, $P(=O)(R^4)$, SO, $SO_2$, $NR^4$, O, S or $CONR^4$ and where one or more H atoms may be replaced by D, F, Cl, Br, I or CN, or a mono- or polycyclic, aromatic or heteroaromatic ring system having 5 to 60 aromatic ring atoms, which may in each case be substituted by one or more radicals $R^4$;

L is a neutral ligand;

$R^1$, $R^2$ are on each occurrence, identically or differently, F, Cl, Br, I, CN, $NO_2$, a straight-chain alkyl group having 2 to 40 C atoms, a branched or cyclic alkyl group having 3 to 40 C atoms, a straight-chain fluoroalkyl group having 1 to 40 C atoms, or a branched or cyclic fluoroalkyl group having 3 to 40 C atoms, each of which may be substituted by one or more radicals $R^4$, where one or more non-adjacent $CH_2$ groups may be replaced by $R^4C=CR^4$, C≡C, $Si(R^4)_2$, C=O, C=S, $C=NR^4$, $P(=O)(R^4)$, SO, $SO_2$, $NR^4$, O, S or $CONR^4$ and where one or more H atoms may be replaced by D, Cl, Br, I or CN, or a mono- or polycyclic, aromatic or heteroaromatic ring system having 5 to 60 aromatic ring atoms, which may in each case be substituted by one or more radicals $R^4$, where the radicals $R^1$ and $R^3$ or the radicals $R^2$ and $R^3$ may form a mono- or polycyclic, aliphatic, aromatic and/or benzo-fused ring system with one another;

$R^3$ is selected from the group consisting of H, D, a straight-chain alkyl group having 1 to 40 C atoms or a branched or cyclic alkyl having 3 to 40 C atoms, each of which may be substitu-ted by one or more radicals $R^4$, where one or more non- adjacent $CH_2$ groups may be replaced by $R^4C=CR^4$, C≡C, $Si(R^4)_2$, C=O, C=S, $C=NR^4$, $P(=O)(R^4)$, SO, $SO_2$, $NR^4$, O, S or $CONR^4$ and where one or more H atoms may be replaced by D, F, Cl, Br, I or CN, or a mono- or polycyclic, aromatic or heteroaromatic ring system having 5 to 60 aromatic ring atoms, which may in each case be substituted by one or more radicals $R^4$;

$R^4$ is on each occurrence, identically or differently, H, D, F or an aliphatic, aromatic or heteroaromatic organic radical having 1 to 20 C atoms, in which, in addition, one or more H atoms may be replaced by D or F; two or more substituents $R^5$ here may be linked to one another and may form a ring;

p is 0, 1 or 2;

q is a number equal to 1, 2, 3 or 4, which corresponds to the oxidation number of M.

For the purposes of this application, a hole-injection material is a material that simplifies or facilitates the transfer of holes, i.e. positive charges, from the anode into an organic layer and a hole-transport material is a material that is capable of transporting holes, i.e. positive charges, which are generally injected from the anode or an adjacent layer, for example a hole-injection layer.

These materials are frequently described via the properties of the frontier orbitals, which are described in greater

detail below. Molecular orbitals, in particular also the highest occupied molecular orbital (HOMO) and the lowest unoccupied molecular orbital (LUMO), their energy levels and the energy of the lowest triplet state $T_1$ or of the lowest excited singlet state $S_1$ of the materials are determined via quantum-chemical calculations. In order to calculate organic substances without metals, firstly a geometry optimisation is carried out using the "Ground State/Semi-empirical/Default Spin/AM1/Charge 0/Spin Singlet" method. An energy calculation is subsequently carried out on the basis of the optimised geometry. The "TD-SCF/ DFT/Default Spin/B3PW91" method with the "6-31 G(d)" base set (charge 0, spin singlet) is used here. For metal-containing compounds, the geometry is optimised via the "Ground State/ Hartree-Fock/Default Spin/LanL2MB/ Charge 0/Spin Singlet" method. The energy calculation is carried out analogously to the above-described method for the organic substances, with the difference that the "LanL2DZ" base set is used for the metal atom and the "6-31 G(d)" base set is used for the ligands. The energy calculation gives the HOMO energy level HEh or LUMO energy level LEh in hartree units. The HOMO and LUMO energy levels in electron volts calibrated with reference to cyclic voltammetry measurements are determined therefrom as follows:

$$HOMO(eV) = ((HEh*27.212)-0.9899)/1.1206$$

$$LUMO(eV) = ((LEh*27.212)-2.0041)/1.385$$

For the purposes of this application, these values are to be regarded as HOMO and LUMO energy levels respectively of the materials.

The lowest triplet state $T_1$ is defined as the energy of the triplet state having the lowest energy which arises from the quantum-chemical calculation described.

The lowest excited singlet state $S_1$ is defined as the energy of the excited singlet state having the lowest energy which arises from the quantum-chemical calculation described.

The method described herein is independent of the software package used and always gives the same results. Examples of frequently used programs for this purpose are "Gaussian09W" (Gaussian Inc.) and Q-Chem 4.1 (Q-Chem, Inc.).

In general, a hole-injection material has an HOMO level which is in the region of or above the level of the anode, i.e. in general is at least -5.3 eV. A hole-transport material generally has a high HOMO level of preferably at least -5.4 eV. Depending on the structure of an electronic device, it may also be possible to employ a hole-transport material as hole-injection material.

The hole-injection and/or hole-transport material can be a compound having a low molecular weight or a polymer, where the hole-injection material and/or hole-transport material may also be in the form of a mixture. Thus, the formulations according to the invention may comprise two compounds as hole-injection material and/or hole-transport material having a low molecular weight, one compound having a low molecular weight and one polymer or two polymers (blend).

The preferred hole-injection materials and/or hole-transport materials include, for example, triarylamine, benzidine, tetraaryl-para-phenylenediamine, triarylphosphine, phenothiazine, phenoxazine, dihydrophenazine, thianthrene, dibenzo-para-dioxin, phenoxathiyne, carbazole, azulene, thiophene, pyrrole and furan derivatives and further O-, S- or N-containing heterocycles having a high HOMO (HOMO = highest occupied molecular orbital).

For the purposes of the present application, a p-dopant material is a material, which exhibits a lewis-acidity and/or which are able to form a complex with the matrix material, in which these materials act as Lewis-acids (also wenn only formal).

For the purposes of the present application, the following definitions of chemical groups apply:

An aryl group in the sense of this invention contains 6 to 60 aromatic ring atoms; a heteroaryl group in the sense of this invention contains 5 to 60 aromatic ring atoms, at least one of which is a heteroatom. The heteroatoms are preferably selected from N, O and S. This represents the basic definition. If other preferences are indicated in the description of the present invention, for example with respect to the number of aromatic ring atoms or the heteroatoms present, these apply.

An aryl group or heteroaryl group here is taken to mean either a simple aromatic ring, i.e. benzene, or a simple heteroaromatic ring, for example pyridine, pyrimidine or thiophene, or a condensed (annellated) aromatic or heteroaromatic polycycle, for example naphthalene, phenanthrene, quinoline or carbazole. A condensed (annellated) aromatic or heteroaromatic polycycle in the sense of the present application consists of two or more simple aromatic or heteroaromatic rings condensed with one another.

An aryl or heteroaryl group, which may in each case be substituted by the above-mentioned radicals and which may be linked to the aromatic or heteroaromatic ring system via any desired positions, is taken to mean, in particular,

groups derived from benzene, naphthalene, anthracene, phenanthrene, pyrene, dihydropyrene, chrysene, perylene, fluoranthene, benzanthracene, benzophenanthrene, tetracene, pentacene, benzopyrene, furan, benzofuran, isobenzofuran, dibenzofuran, thiophene, benzothiophene, isobenzothiophene, dibenzothiophene, pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthimidazole, phenanthrimidazole, pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, pyrazine, phenazine, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole.

An aryloxy group in accordance with the definition of the present invention is taken to mean an aryl group, as defined above, which is bonded via an oxygen atom. An analogous definition applies to heteroaryloxy groups.

An aromatic ring system in the sense of this invention contains 6 to 60 C atoms in the ring system. A heteroaromatic ring system in the sense of this invention contains 5 to 60 aromatic ring atoms, at least one of which is a heteroatom. The heteroatoms are preferably selected from N, O and/or S. An aromatic or heteroaromatic ring system in the sense of this invention is intended to be taken to mean a system which does not necessarily contain only aryl or heteroaryl groups, but instead in which, in addition, a plurality of aryl or heteroaryl groups may be connected by a non-aromatic unit (preferably less than 10% of the atoms other than H), such as, for example, an $sp^3$-hybridised C, Si, N or O atom, an $sp^2$-hybridised C or N atom or an sp-hybridised C atom. Thus, for example, systems such as 9,9'-spirobifluorene, 9,9'-diarylfluorene, triarylamine, diaryl ether, stilbene, etc., are also intended to be taken to be aromatic ring systems in the sense of this invention, as are systems in which two or more aryl groups are connected, for example, by a linear or cyclic alkyl, alkenyl or alkynyl group or by a silyl group. Furthermore, systems in which two or more aryl or heteroaryl groups are linked to one another via single bonds are also taken to be aromatic or heteroaromatic ring systems in the sense of this invention, such as, for example, systems such as biphenyl, terphenyl or diphenyltriazine.

An aromatic or heteroaromatic ring system having 5 - 60 aromatic ring atoms, which may in each case also be substituted by radicals as defined above and which may be linked to the aromatic or heteroaromatic group via any desired positions, is taken to mean, in particular, groups derived from benzene, naphthalene, anthracene, benzanthracene, phenanthrene, benzophenanthrene, pyrene, chrysene, perylene, fluoranthene, naphthacene, pentacene, benzopyrene, biphenyl, biphenylene, terphenyl, terphenylene, quaterphenyl, fluorene, spirobifluorene, dihydrophenanthrene, dihydropyrene, tetrahydropyrene, cis- or trans-indenofluorene, truxene, isotruxene, spirotruxene, spiroisotruxene, furan, benzofuran, isobenzofuran, dibenzofuran, thiophene, benzothiophene, isobenzothiophene, dibenzothiophene, pyrrole, indole, isoindole, carbazole, indolocarbazole, indenocarbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthimidazole, phenanthrimidazole, pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, 1,5-diazaanthracene, 2,7-diazapyrene, 2,3-diazapyrene, 1,6-diazapyrene, 1,8-diazapyrene, 4,5-diazapyrene, 4,5,9,10-tetraazaperylene, pyrazine, phenazine, phenoxazine, phenothiazine, fluorubin, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole, or combinations of these groups.

For the purposes of the present invention, a straight-chain alkyl group having 1 C atom, in which, in addition, individual H atoms may be substituted by the groups mentioned above under the definition of the radicals, is taken to mean the radical methyl. A straight-chain alkyl group having 2 to 40 C atoms or a branched or cyclic alkyl group having 3 to 40 C atoms or an alkenyl or alkynyl group having 2 to 40 C atoms, in which, in addition, individual H atoms or $CH_2$ groups may be substituted by the groups mentioned above under the definition of the radicals, is preferably taken to mean the radicals ethyl, n-propyl, i-propyl, n-butyl, i-butyl, s-butyl, t-butyl, 2-methylbutyl, n-pentyl, s-pentyl, cyclopentyl, neopentyl, n-hexyl, cyclohexyl, neohexyl, n-heptyl, cycloheptyl, n-octyl, cyclooctyl, 2-ethylhexyl, trifluoromethyl, pentafluoroethyl, 2,2,2-trifluoroethyl, ethenyl, propenyl, butenyl, pentenyl, cyclopentenyl, hexenyl, cyclohexenyl, heptenyl, cyclo-heptenyl, octenyl, cyclooctenyl, ethynyl, propynyl, butynyl, pentynyl, hexynyl or octynyl. An alkoxy or thioalkyl group having 1 to 40 C atoms is preferably taken to mean methoxy, trifluoromethoxy, ethoxy, n-propoxy, i-propoxy, n-butoxy, i-butoxy, s-butoxy, t-butoxy, n-pentoxy, s-pentoxy, 2-methyl-butoxy, n-hexoxy, cyclohexyloxy, n-heptoxy, cycloheptyloxy, n-octyloxy, cyclooctyloxy, 2-ethylhexyloxy, pentafluoroethoxy, 2,2,2-trifluoroethoxy, methylthio, ethylthio, n-propylthio, i-propylthio, n-butylthio, i-butylthio, s-butylthio, t-butylthio, n-pentylthio, s-pentylthio, n-hexylthio, cyclohexylthio, n-heptylthio, cycloheptylthio, n-octylthio, cyclooctylthio, 2-ethylhexylthio, trifluoromethylthio, pentafluoroethylthio, 2,2,2-trifluoroethylthio, ethenylthio, propenylthio, butenylthio, pentenylthio, cyclopentenylthio, hexenylthio, cyclohexenylthio, heptenylthio, cycloheptenylthio, octenylthio, cyclooctenylthio, ethynylthio, propynylthio, butynylthio, pentynylthio, hexynylthio, heptynylthio or octynylthio.

The formulation that two or more radicals may form a ring with one another is, for the purposes of the present application, intended to be taken to mean, inter alia, that the two radicals are linked to one another by a chemical bond. This is illustrated by the following schemes:

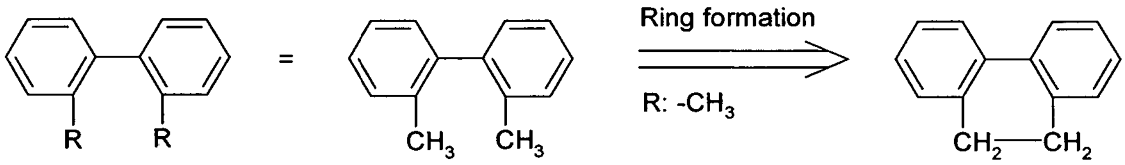


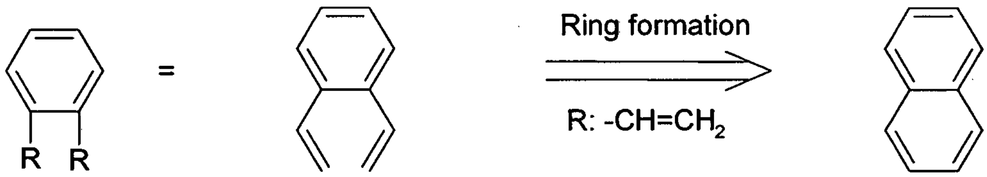


Furthermore, however, the above-mentioned formulation is also intended to be taken to mean that, in the case where one of the two radicals represents hydrogen, the second radical is bonded at the position to which the hydrogen atom was bonded, with formation of a ring. This is illustrated by the following scheme:

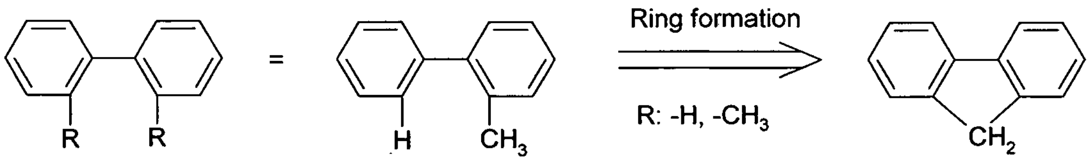


The composition of the present invention comprises at least one metal complex of formula (MC-1):

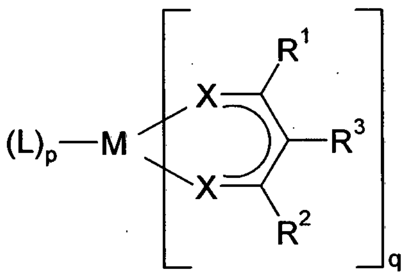

formula (MC-1)

In accordance with a preferred embodiment, M is selected from Sn, Bi and Te. More preferably, M is selected from Bi.

In accordance with a further preferred embodiment, X is equal to O.

It is furthermore preferred for $R^3$ to be selected from the group consisting of H, D, a straight-chain alkyl group having 1 to 4 C atoms or a branched or cyclic alkyl having 3 to 4 C atoms, each of which may be substituted by one or more radicals $R^4$, or an aryl or heteroaryl group having 5 to 14 aromatic ring atoms, which may in each case be substituted by one or more radicals $R^4$. It is particularly preferred that $R^3$ stands for H, a methyl group or a phenyl group.

In accordance with a further preferred embodiment, at least one of the radicals $R^1$ and $R^2$ stands F, CN, $NO_2$, a straight-chain fluoroalkyl group having 1 to 40 C atoms or a branched or cyclic fluoroalkyl group having 3 to 40 C atoms, each of which may be substituted by one or more radicals $R^4$, or an aryl or heteroaryl group having 5 to 30 aromatic ring atoms, which may in each case be substituted by one or more radicals $R^4$.

It is particularly preferred that at least one of the radicals $R^1$ and $R^2$ stands for F, CN, $NO_2$, a straight-chain perfluoroalkyl group having 1 to 14 C atoms or a branched or cyclic perfluoroalkyl group having 3 to 14 C atoms, or an aryl or heteroaryl group having 5 to 14 aromatic ring atoms, which may in each case be substituted by one or more radicals $R^4$.

Even more particularly preferred is that both radicals $R^1$ and $R^2$ stands, identically or differently, for F, CN, $NO_2$, a straight-chain perfluoroalkyl group having 1 to 14 C atoms or a branched or cyclic perfluoroalkyl group having 3 to 14 C atoms, or an aryl or heteroaryl group having 5 to 14 aromatic ring atoms, which may in each case be substituted by one or more radicals $R^4$.

It is furthermore preferred for L to be selected from the group of neutral ligands consisting of bipyridine, phenanthroline, phosphine oxide, phosphonimido ligands and sulfoxide, each of which may be substituted by one or more radicals $R^4$ as defined above.

In a further preferred embodiment, p is equal to 0 or 1. It is even more preferred that p is equal to 0 and q is equal to 1, 2 or 3, depending on the oxidation number of M.

Examples of metal complexes of formula (MC-I) that are suitable for the compositions according to the invention are the following ones:

| | |
|---|---|
| 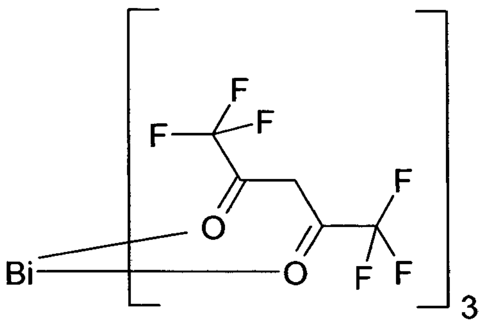 | 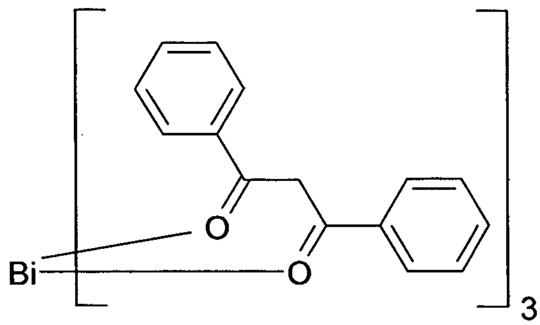 |
| 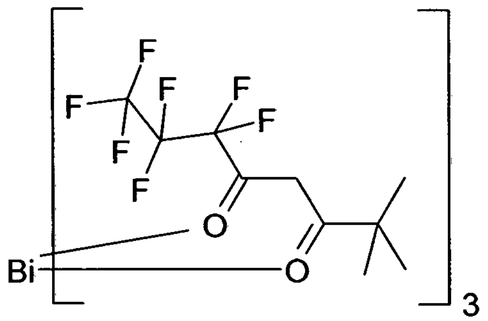 | 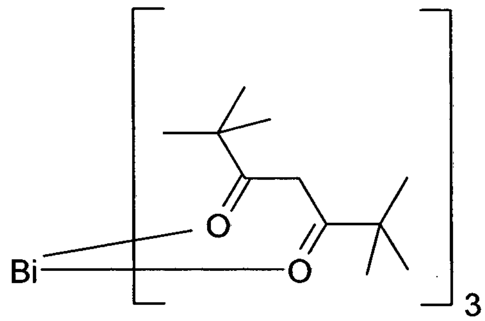 |
| 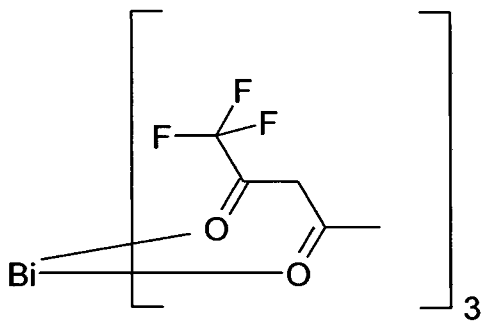 | |

The concentration of the at least one metal complex of formula (MC-1) in the composition according to the invention is preferably in the range of from 1 to 60 wt.%, more preferably 2 to 50 wt.%, and most preferably from 3 to 30 wt.%, based on the total composition.

The compositions according to the present invention comprise at least one hole-transport or/and one hole-injection material.

In accordance with the embodiment of the present invention, the at least one hole-transport or/and one hole-injection material is a polymer compound, or an oligomer compound.

The polymer compound preferably has 10 to 10000, more preferably 10 to 5000 and most preferably 10 to 2000 structural units (i.e. repetitive units). The oligomer compound preferably has 3 to 9 structural units. The branching factor of the polymer is between 0 (linear polymer, no branching) and 1 (polymer completely branched).

Polymers according to the disclosure have a molecular weight ($M_w$) in the range of 10,000 to 2,000,000 g/mol, preferably in the range of 50,000 to 1,500,000 g/mol, and more preferably in the range of 100,000 to 1,000,000 g/mol. The molecular weight ($M_w$) is determined by means of GPC (Gel Permeation Chromatography) using an internal polystyrene standard.

Polymers according to the disclosure are either conjugated, partly conjugated or non-conjugated polymers, preferably conjugated or partly conjugated.

The polymer comprises a structural unit, which is a triarylamine unit having three aromatic or heteroaromatic ring systems $Ar^1$, $Ar^2$, $Ar^3$, wherein at least one of $Ar^1$, $Ar^2$, $Ar^3$ is substituted by $Ar^4$ in at least one, preferably in one of the two ortho positions, where $Ar^4$ is a mono- or polycyclic , aromatic or heteroaromatic ring system having 5 to 60 aromatic ring atoms, which may be substituted by one or more radicals R.

The triarylamine unit has the following formula (I):

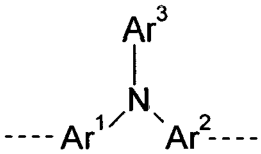

(I)

where

| | |
|---|---|
| $Ar^1$ to $Ar^3$ | is on each occurrence, in each case identically or differently, a mono- or polycyclic, aromatic or heteroaromatic ring system having 5 to 60 aromatic ring atoms, which may be substituted by one or more radicals R; |
| R | is on each occurrence, identically or differently, H, D, F, Cl, Br, I, $N(R^1)_2$, CN, $NO_2$, $Si(R^1)_3$, $B(OR^1)_2$, $C(=O)R^1$, $P(=O)(R^1)_2$, $S(=O)R^1$, $S(=O)_2R^1$, $OSO_2R^1$, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^1$, where one or more non- adjacent $CH_2$ groups may be replaced by $R^1C=CR^1$, $C\equiv C$, $Si(R^1)_2$, C=O, C=S, $C=NR^1$, $P(=O)(R^1)$, SO, $SO_2$, $NR^1$, O, S or $CONR^1$ and where one or more H atoms may be replaced by D, F, Cl, Br, I or CN, or a mono- or polycyclic, aromatic or heteroaromatic ring system having 5 to 60 aromatic ring atoms, which may in each case be substituted by one or more radicals $R^1$, or an aryloxy or hetero-aryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$, or a diarylamino group, diheteroarylamino group or arylheteroarylamino group having 10 to 40 aromatic ring atoms, which may be substituted by one or more radicals $R^1$, or a crosslinkable group Q, where two or more radicals R may also form a mono- or polycyclic, aliphatic, aromatic and/or benzo-fused ring system with one another; |
| $R^1$ | is on each occurrence, identically or differently, H, D, F or an aliphatic hydrocarbon radical having 1 to 20 C atoms, an aromatic and/or a heteroaromatic hydrocarbon radical having 5 to 20 C atoms, in which, in addition, one or more H atoms may be replaced by F; where two or more substituents $R^1$ may also form a mono- or polycyclic, aliphatic or aromatic ring system with one another; and |

the dashed lines represent bonds to adjacent structural units in the polymer,
and where at least one of $Ar^1$, $Ar^2$ and/or $Ar^3$ is substituted by a radical R comprising at least 2 C atoms, preferably at least 4 C atoms and more preferably at least 6 C atoms. Advantageously, R exhibit a C-C-Doppelbond or R is a part of a mono- or polycyclic, aromatic or heteroaromatic ring system with 5 to 60 aromatic ring atoms.

In a preferred embodiment, $Ar^3$ according to formula (I) is in at least one, preferably in one of the two ortho-positions relating to the Nitrogen atom represented in formula (I), substituted by $Ar^4$, where $Ar^4$ is a mono- or polycyclic, aromatic or heteroaromatic ring system with 5 to 60 aromatic ring atoms, which may be substituted by one or more radical R, where R can adopt the meanings indicated above.

$Ar^4$ here may either be linked directly, i.e. via a single bond, to $Ar^3$, or alternatively via a linking group X.

The compound of formula (I) thus preferably has the following formula (Ia).

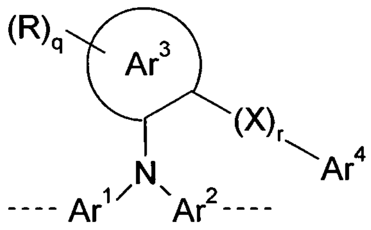

(Ia)

where $Ar^1$, $Ar^2$, $Ar^3$, $Ar^4$ and R can adopt the meanings indicated above,

q = 0, 1, 2, 3, 4, 5 or 6, preferably 0, 1, 2, 3 or 4,
X = $CR_2$, NR, $SiR_2$, O, S, C=O or P=O, preferably $CR_2$, NR, O or S, and
r = 0 or 1, preferably 0.

According to the disclosure, structural units of formula (I) can be comprised In the main chain or in the side chain. Structural units of formula (I) are preferably comprised in the main chain of the polymer. When present in the side chain, structural units of formula (I) are either mono- or bivalent, i.e. they either exhibit one or two bonds to the adjacent structural units in the polymer.

The term "mono- or polycyclic, aromatic ring system" in the present application is taken to mean an aromatic ring system having 6 to 60, preferably 6 to 30 and particularly preferably 6 to 24 aromatic ring atoms, which does not necessarily contain only aromatic groups, but instead in which a plurality of aromatic units may also be interrupted by a short non-aromatic unit (< 10% of the atoms other than H, preferably < 5% of the atoms other than H), such as, for example, an $sp^3$-hybridised C atom or O or N atom, a CO group, etc. Thus, for example, systems such as, for example, 9,9'-spirobifluorene, 9,9-diarylfluorene and 9,9-dialkylfluorene are also intended to be taken to be aromatic ring systems.

The aromatic ring systems may be mono- or polycyclic, i.e. they may contain one ring (for example phenyl) or a plurality of rings, which may also be condensed (for example naphthyl) or covalently linked (for example biphenyl), or contain a combination of condensed and linked rings.

Preferred aromatic ring systems are, for example, phenyl, biphenyl, terphenyl, [1,1':3',1"]terphenyl-2'-yl, quaterphenyl, naphthyl, anthracene, binaphthyl, phenanthrene, dihydrophenanthrene, pyrene, dihydropyrene, chrysene, perylene, tetracene, pentacene, benzopyrene, fluorene, indene, indenofluorene and spirobifluorene.

The term "mono- or polycyclic, heteroaromatic ring system" in the present application is taken to mean an aromatic ring system having 5 to 60, preferably 5 to 30 and particularly preferably 5 to 24 aromatic ring atoms, where one or more of these atoms is (are) a heteroatom. The "mono- or polycyclic, heteroaromatic ring system" does not necessarily contain only aromatic groups, but instead may also be interrupted by a short non-aromatic unit (< 10% of the atoms other than H, preferably < 5% of the atoms other than H), such as, for example, an $sp^3$-hybridised C atom or O or N atom, a CO group, etc.

The heteroaromatic ring systems may be mono- or polycyclic, i.e. they may contain one ring or a plurality of rings, which may also be condensed or covalently linked (for example pyridylphenyl), or contain a combination of condensed and linked rings. Preference is given to fully conjugated heteroaryl groups.

Preferred heteroaromatic ring systems are, for example, 5-membered rings, such as pyrrole, pyrazole, imidazole, 1,2,3-triazole, 1,2,4-triazole, tetrazole, furan, thiophene, selenophene, oxazole, isoxazole, 1,2-thiazole, 1,3-thiazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 6-membered rings, such as pyridine, pyridazine, pyrimidine, pyrazine, 1,3,5-triazine, 1,2,4-triazine, 1,2,3-triazine, 1,2,4,5-tetrazine, 1,2,3,4-tetrazine, 1,2,3,5-tetrazine, or groups having a plurality of rings, such as carbazole, indenocarbazole, indole, isoindole, indolizine, indazole, benzimidazole, benzotriazole, purine, naphthimidazole, phenanthrimidazole, pyridimidazole, pyrazinimidazole, quinoxalinimidazole, benzoxazole, naphthoxazole, anthroxazole, phenanthroxazole, isoxazole, benzothiazole, benzofuran, isobenzofuran, dibenzofuran, quinoline, isoquinoline, pteridine, benzo-5,6-quinoline, benzo-6,7-quinoline, benzo-7,8-quinoline, benzoisoquinoline, acridine, phenothiazine, phenoxazine, benzopyridazine, benzopyrimidine, quinoxaline, phenazine, naphthyridine, azacarbazole, benzocarboline, phenanthridine, phenanthroline, thieno[2,3b]thiophene, thieno-[3,2b]thiophene, dithienothiophene, isobenzothiophene, dibenzothiophene, benzothiadiazothiophene or combinations of these groups.

The mono- or polycyclic, aromatic or heteroaromatic ring system may be unsubstituted or substituted. Substituted in the present application means that the mono- or polycyclic, aromatic or heteroaromatic ring system contains one or more substituents R.

R is on each occurrence preferably, identically or differently, H, D, F, Cl, Br, I, $N(R^1)_2$, CN, $NO_2$, $Si(R^1)_3$, $B(OR^1)_2$,

$C(=O)R^1$, $P(=O)(R^1)_2$, $S(=O)R^1$, $S(=O)_2R^1$, $OSO_2R^1$, a straight-chain alkyl, alkoxy or thioalkoxy group having 1 to 40 C atoms or an alkenyl or alkynyl group having 2 to 40 C atoms or a branched or cyclic alkyl, alkoxy or thioalkoxy group having 3 to 40 C atoms, each of which may be substituted by one or more radicals $R^1$, where one or more non-adjacent $CH_2$ groups may be replaced by $R^1C=CR^1$, C≡C, $Si(R^1)_2$, C=O, C=S, $C=NR^1$, $P(=O)(R^1)$, SO, $SO_2$, $NR^1$, O, S or $CONR^1$ and where one or more H atoms may be replaced by D, F, Cl, Br, I or CN, or an aromatic or heteroaromatic ring system having 5 to 60 aromatic ring atoms, which may in each case be substituted by one or more radicals $R^1$, or an aryloxy or heteroaryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$, or a diarylamino group, diheteroarylamino group or arylheteroarylamino group having 10 to 40 aromatic ring atoms, which may be substituted by one or more radicals $R^1$, or a crosslinkable group Q; two or more radicals R here may also form a mono- or polycyclic, aliphatic, aromatic and/or benzo-fused ring system with one another.

R is on each occurrence particularly preferably, identically or differently, H, D, F, Cl, Br, I, $N(R^1)_2$, $Si(R^1)_3$, $B(OR^1)_2$, $C(=O)R^1$, $P(=O)(R^1)_2$, a straight-chain alkyl or alkoxy group having 1 to 20 C atoms or an alkenyl or alkynyl group having 2 to 20 C atoms or a branched or cyclic alkyl or alkoxy group having 3 to 20 C atoms, each of which may be substituted by one or more radicals $R^1$, where one or more non-adjacent $CH_2$ groups may be replaced by $R^1C=CR^1$, C≡C, $Si(R^1)_2$, C=O, $C=NR^1$, $P(=O)(R^1)$, $NR^1$, O or $CONR^1$ and where one or more H atoms may be replaced by F, Cl, Br or I, or an aromatic or heteroaromatic ring system having 5 to 30 aromatic ring atoms, which may in each case be substituted by one or more radicals $R^1$, or an aryloxy or heteroaryloxy group having 5 to 30 aromatic ring atoms, which may be substituted by one or more radicals $R^1$, or an aralkyl or heteroaralkyl group having 5 to 30 aromatic ring atoms, which may be substituted by one or more radicals $R^1$, or a diarylamino group, diheteroarylamino group or arylheteroarylamino group having 10 to 20 aromatic ring atoms, which may be substituted by one or more radicals $R^1$, or a crosslinkable group Q; two or more radicals R here may also form a mono- or polycyclic, aliphatic, aromatic and/or benzo-fused ring system with one another.

R is on each occurrence very particularly preferably, identically or differently, H, a straight-chain alkyl or alkoxy group having 1 to 10 C atoms or an alkenyl or alkynyl group having 2 to 10 C atoms or a branched or cyclic alkyl or alkoxy group having 3 to 10 C atoms, each of which may be substituted by one or more radicals $R^1$, where one or more non-adjacent $CH_2$ groups may be replaced by $R^1C=CR^1$, C≡C, C=O, $C=NR^1$, $NR^1$, O or $CONR^1$, or an aromatic or heteroaromatic ring system having 5 to 20 aromatic ring atoms, which may in each case be substituted by one or more radicals $R^1$, or an aryloxy or heteroaryloxy group having 5 to 20 aromatic ring atoms, which may be substituted by one or more radicals $R^1$, or an aralkyl or heteroaralkyl group having 5 to 20 aromatic ring atoms, which may be substituted by one or more radicals $R^1$, or a diarylamino group, diheteroarylamino group or arylheteroarylamino group having 10 to 20 aromatic ring atoms, which may be substituted by one or more radicals $R^1$, or a crosslinkable group Q; two or more radicals R here may also form a mono- or polycyclic, aliphatic, aromatic and/or benzo-fused ring system with one another.

In another preferred embodiment of the present invention, the compound of. formula (I) is characterised in that $Ar^3$ is substituted by $Ar^4$ in one of the two ortho positions, and $Ar^3$ is additionally linked to $Ar^4$ in the meta position that is adjacent to the substituted ortho position.

The compound of formula (I) thus preferably has the following formula (Ib):

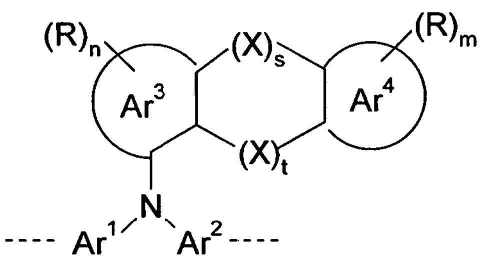

(Ib)

where $Ar^1$, $Ar^2$, $Ar^3$, $Ar^4$ and R can adopt the meanings indicated above,

m = 0, 1, 2, 3 or 4,
n = 0, 1, 2 or 3,
X = $CR_2$, NR, $SiR_2$, O, S, C=O or P=O, preferably $CR_2$, NR, O or S, and s and t are each 0 or 1, where the sum (s + t) = 1 or 2, preferably 1.

In a first more preferred embodiment, the compound of formula (I) is selected from the following formulae (II), (III) and (IV):

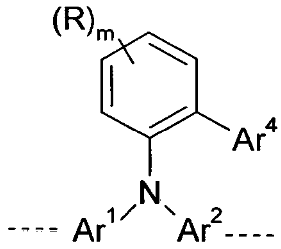

(II)

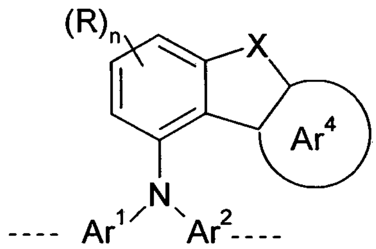

(III)

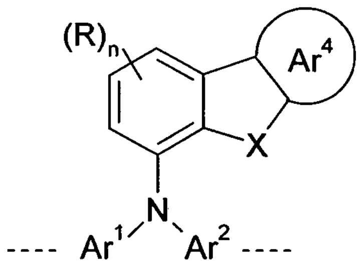

(IV)

where $Ar^1$, $Ar^2$, $Ar^4$ and R can adopt the meanings indicated above,

m = 0, 1, 2, 3 or 4,
n = 0, 1, 2 or 3, and
X = $CR_2$, NR, $SiR_2$, O, S, C=O or P=O, preferably $CR_2$, NR, O or S.

In a particularly preferred embodiment, the compound of formula (II) is selected from the following formula (V):

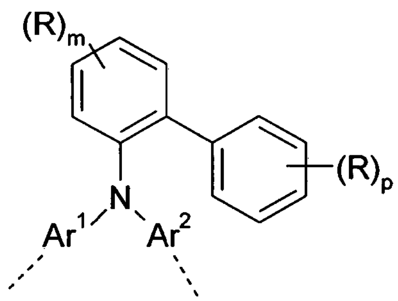

(V)

where $Ar^1$, $Ar^2$, R and m can adopt the meanings indicated above, and

p = 0, 1, 2, 3, 4 or 5.

Examples of preferred structural units of formula (V) are depicted in the following table:

| | | |
|---|---|---|
| 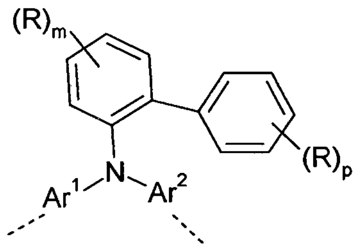 | 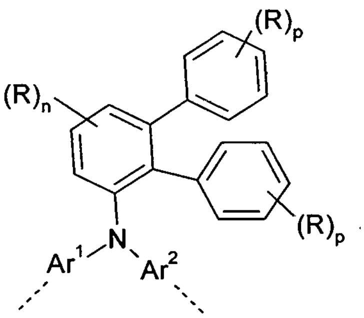 | 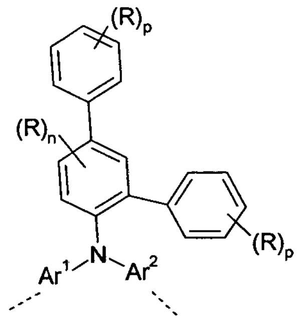 |
| (Va) | (Vb) | (Vc) |
| 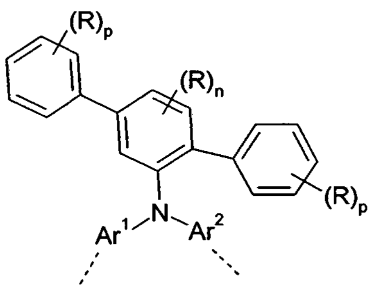 | 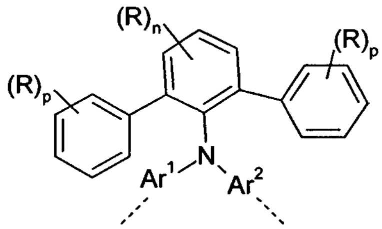 | 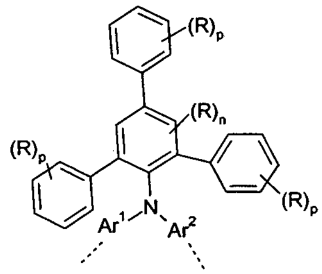 |
| (Vd) | (Ve) | (Vf) |
| 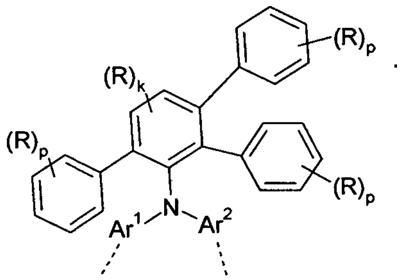 | 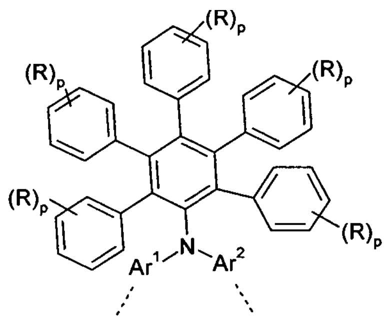 | |
| (Vg) | (Vh) | |

where $Ar^1$, $Ar^2$, R, m, n and p can adopt the meanings indicated above, and k = 0, 1 or 2.

In a further particularly preferred embodiment, the compound of formula (III) is selected from the following formula (VI):

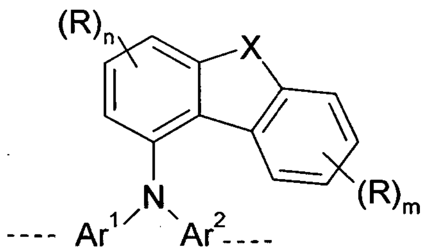

(VI)

where $Ar^1$, $Ar^2$, R, m and n can adopt the meanings indicated above.

Examples of preferred structural units of formula (VI) are depicted in the following table:

| | | |
|---|---|---|
| 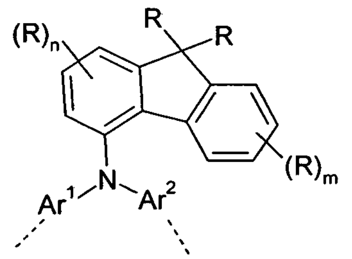 | 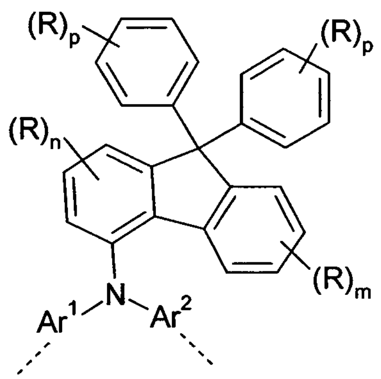 | 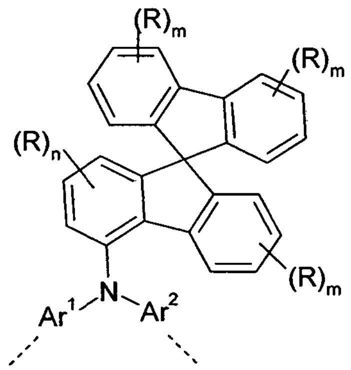 |
| (VIa) | (VIb) | (VIc) |
| 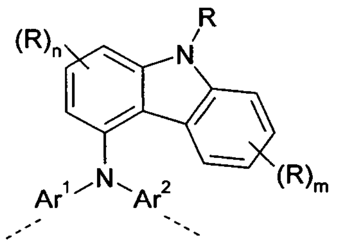 | 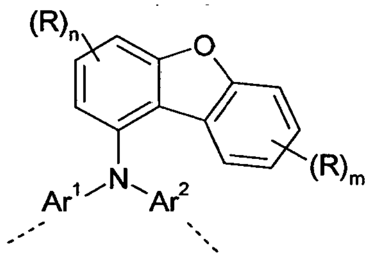 | 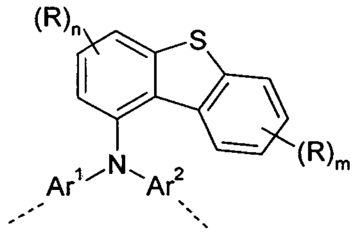 |
| (VId) | (VIe) | (VIf) |

where $Ar^1$, $Ar^2$, R, m, n and p can adopt the meanings indicated above.

In still a further particularly preferred embodiment, the compound of formula (IV) is selected from the following formula (VII):

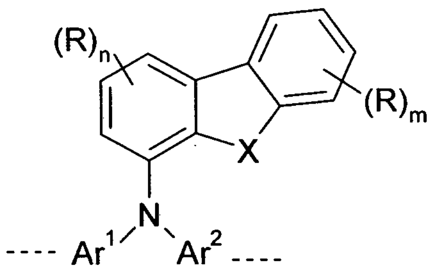

(VII)

where $Ar^1$, $Ar^2$, R, m and n can adopt the meanings indicated above.

Examples of preferred structural units of formula (VII) are depicted in the following table:

| | | |
|---|---|---|
| 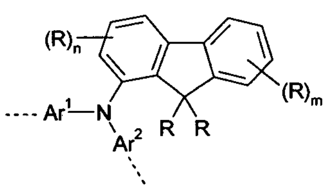 | 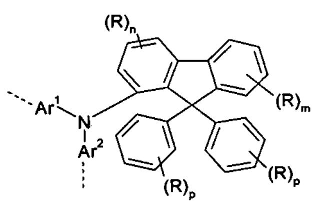 | 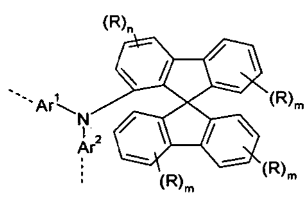 |
| (VIIa) | (VIIb) | (VIIc) |

(continued)

| | | |
|---|---|---|
| 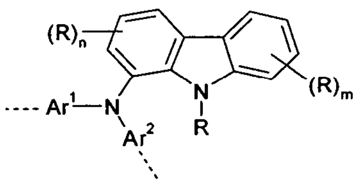 | 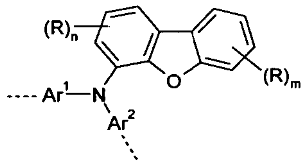 | 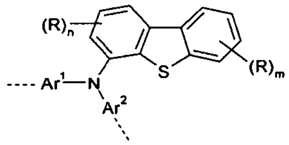 |
| (VIId) | (VIIe) | (VIIf) |

where $Ar^1$, $Ar^2$, R, m, n and p can adopt the meanings indicated above.

In a very particularly preferred embodiment, the compound of formula (V) is selected from the following formula (Vg):

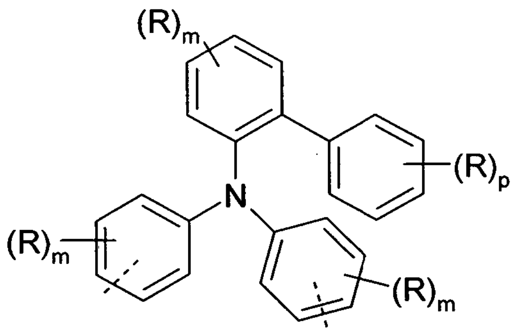

(Vg)

where R, m and p can adopt the meanings indicated above.

Examples of preferred structural units of formula (Vg) are depicted in the following table:

| | |
|---|---|
| 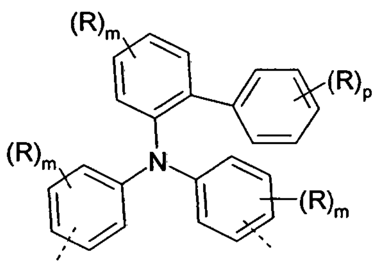 | 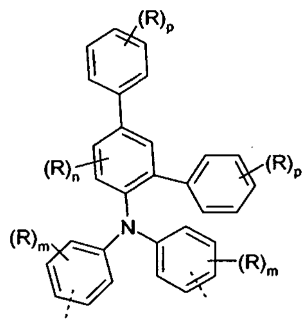 |
| (Vg-1) | (Vg-2) |
| 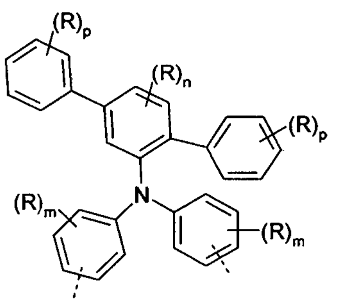 | 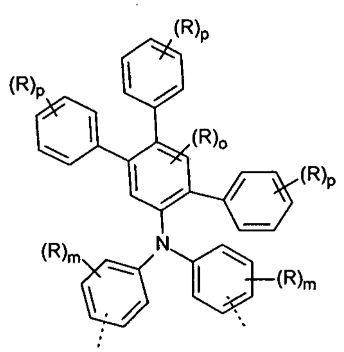 |
| (Vg-3) | (Vg-4) |

| | |
|---|---|
| 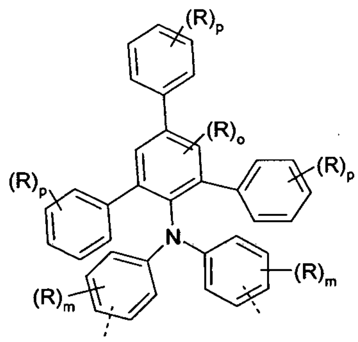 | 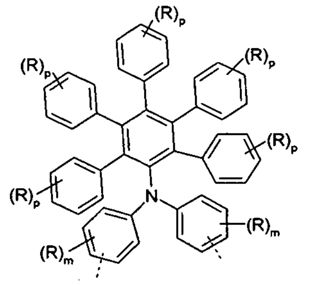 |
| (Vg-5) | (Vg-6) |
| 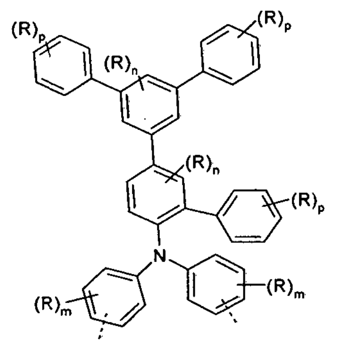 | 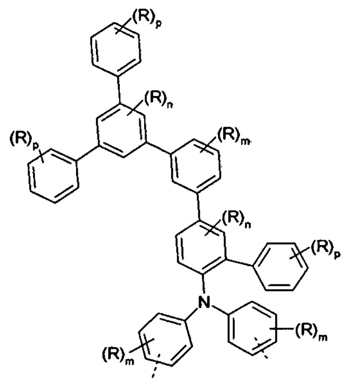 |
| (Vg-7) | (Vg-8) |

where R, k, m, n and p can adopt the meanings indicated above and o is 0, 1 or 2.

In a further very particularly preferred embodiment, the compound of formula (VI) is selected from the following formula (VIg):

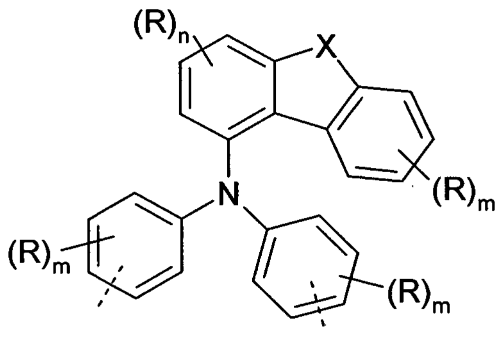

(VIg)

where R, X, m and n can adopt the meanings indicated above.

Examples of preferred structural units of formula (IX) are depicted in the following table:

| | | |
|---|---|---|
| 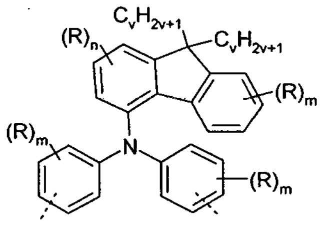 | 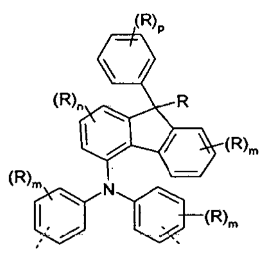 | |

(continued)

| (VIg-1) | (VIg-2) | |
|---|---|---|
| 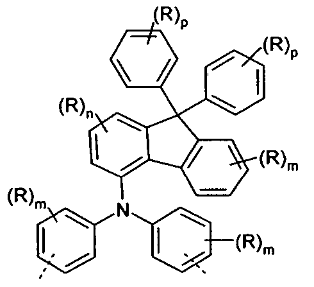 | 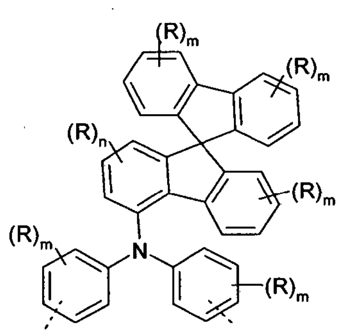 | |
| (VIg-3) | (VIg-4) | |
| 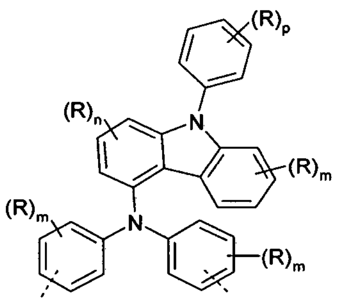 | 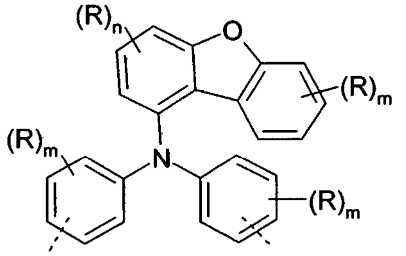 | 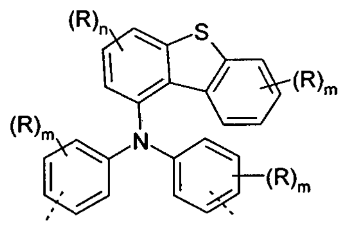 |
| (VIg-5) | (VIg-6) | (VIg-7) |

where R, m, n and p can adopt the meanings indicated above, and v = 1 to 20, preferably 1 to 10.

In still a further very particularly preferred embodiment, the compound of formula (VII) is selected from compounds of the following formula (VIIg):

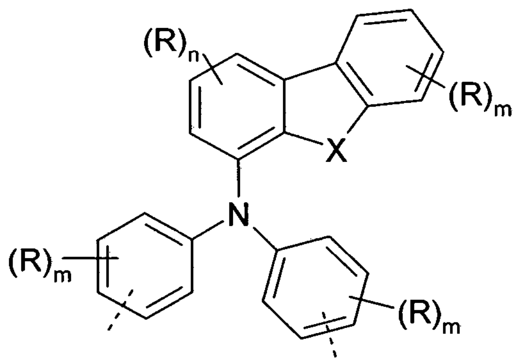

(VIIg)

where R, X, m and n can adopt the meanings indicated above.

Examples of preferred structural units of formula (VIIg) are depicted in the following table:

| | | |
|---|---|---|
| 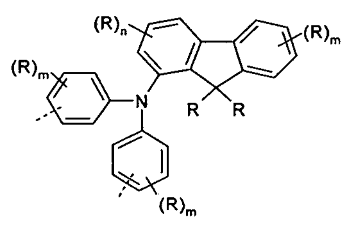 | 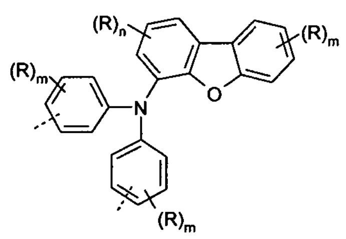 | 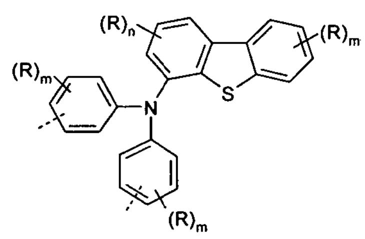 |

(continued)

| (VIIg-1) | (VIIg-2) | (VIIg-3) |
|---|---|---|

where R, m and n can adopt the meanings indicated above.

In formulae (Ia), (Ib), (II), (III), (IV), (V) and preferred compound of formula (V), (VI) and preferred compounds of formula (VI), (VII) and preferred compounds of formula (VII), (Vg) and preferred compounds of formula (Vg), (VIg) and preferred compounds of formula (VIg), (VIIg) and preferred compounds of formula (VIIg), the dashed lines represent bonds to adjacent structural units in the polymer. They can be, independently from each other, identically or differently, in ortho-, meta- or para-position, preferably identically in ortho-, meta- or para-position, more preferably in meta- or para-position and most preferably in para-position.

According to an alternative preferred embodiment of the invention, the polymer comprises at least one structural unit of formula (I), selected from structural units of the following formula (VIIIa):

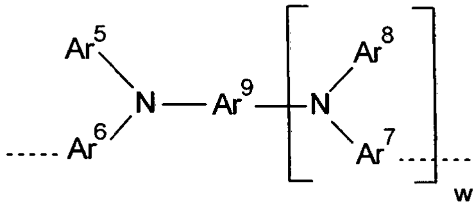

(VIIIa)

or from structural units oft he following formula (VIIIb):

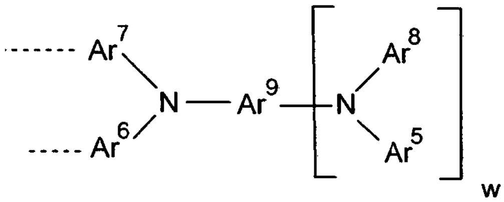

(VIIIb)

where w is 1, 2 or 3, $Ar^5$ to $Ar^9$ is on each occurence, in each case identically or differently, a mono- or polycyclic, aromatic or heteroaromatic ring system having 5 to 60 aromatic ring atoms, which may be substituted by one or more radicals R; where R can adopt the meaning indicated in formula (I); the dashed lines represent bonds to adjacent structural units in the polymer; and at least one of $Ar^5$ to $Ar^9$ is substituted by a radical R comprising at least 2 C atoms, preferably at least 4 C atoms and more preferably at least 6 C atoms.

At least one of $Ar^5$ and/or $Ar^8$ according to formulae (VIIIa) and/or (VIIIb) is substituted by $Ar^4$ in at least one, preferably in one of the two ortho-positions relating to the Nitrogen atom represented in formula (VIIIa) and/or (VIIIb), where $Ar^4$ is a mono- or polycyclic, aromatic or heteroaromatic ring system having 5 to 60 aromatic ring atoms, which may be substituted by one or more radicals R, where R can adopt the meaning indicated above, in particular for formula (I).

$Ar^4$ here may either be linked directly, i.e. via a single bond, to $Ar^5$ and/or $Ar^8$ according to formulae (VIIIa) and/or (VIIIb) or alternatively via a linking group X.

The structural unit of formula (VIIIa) and/or (VIIIb) is therefore preferably selected from the structures of following formulae (VIIIa-1a), (VIIIa-1b), (VIIIa-1c) and/or (VIIIa-1d).

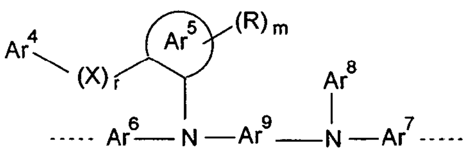

(VIIIa-1a)

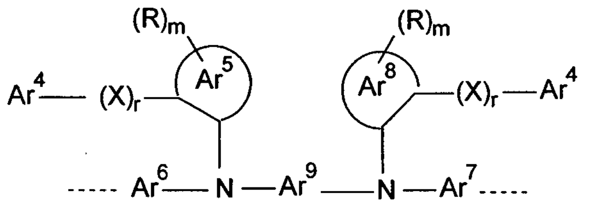

(VIIIa-1b)

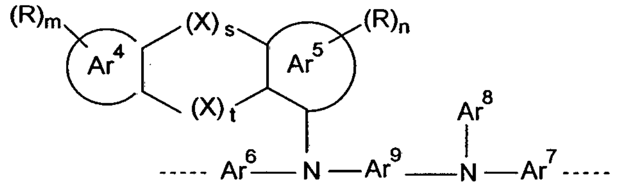

(VIIIa-1c)

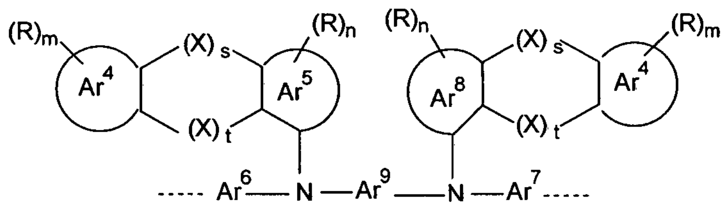

(VIIIa-1d)

where Ar4, Ar5, Ar6, Ar7, Ar8, Ar9, X, m, n, r, s, t and R can adopt the meaning indicated above, in particular for formulae (I), (Ia), (Ib), (VIIIa) and/or (VIIIb).

Moreover, the structural unit of formulae (VIIIa) and/or (VIIIb) can be selected from the structural units of formulae (VIIIb-a), (VIIIb-b), (VIIIb-c) and/or (VIIIb-d).

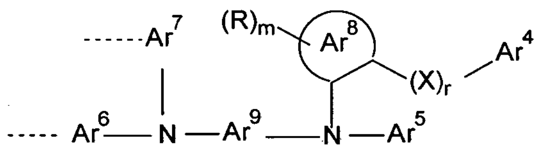

(VIIIb-a)

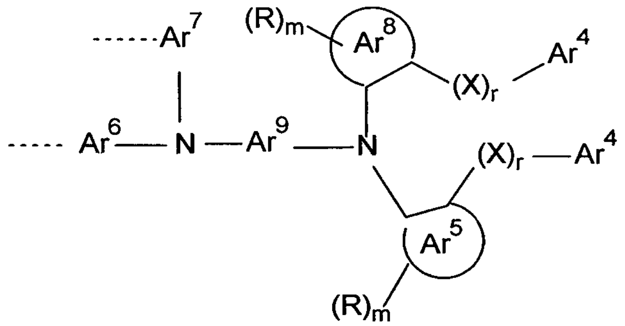

(VIIIb-b)

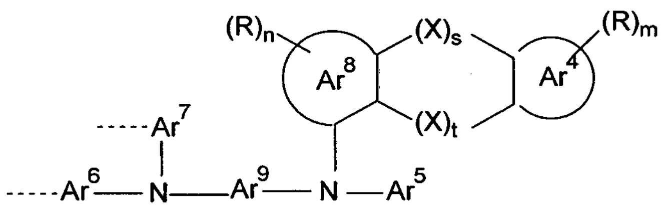

(VIIIb-c)

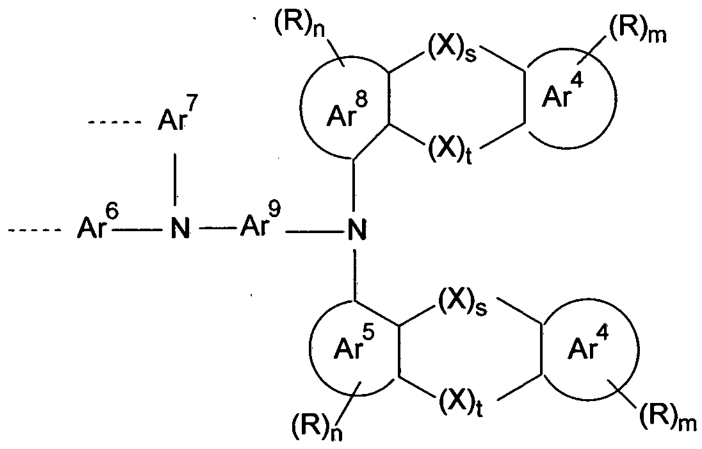

(VIIIb-d)

where $Ar^4$, $Ar^5$, $Ar^6$, $Ar^7$, $Ar^8$, $Ar^9$, X, m, n, s, t and R can adopt the meaning indicated above, in particular for formulae (I), (Ia), (Ib), (VIIIa) and/or (VIIIb).

In a preferred embodiment, the at least one structural unit of formula (VIIIa) is selected from the structural units of the following formulae (IX), (X), (XI), (XII), (XIII), (XIV), (XV) and (XVI):

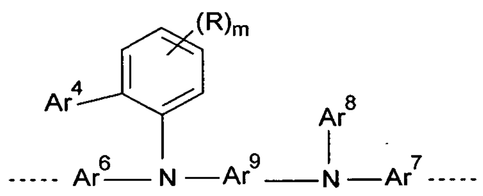

(IX)

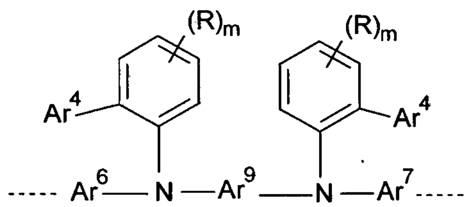

(X)

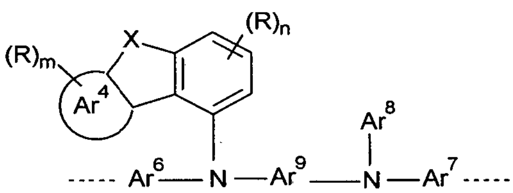

(XI)

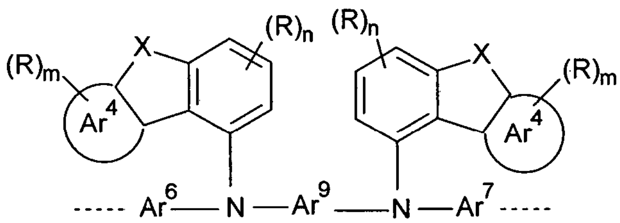

(XII)

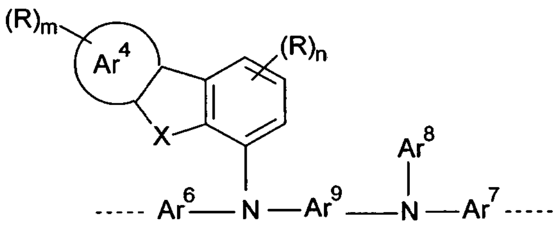

(XIII)

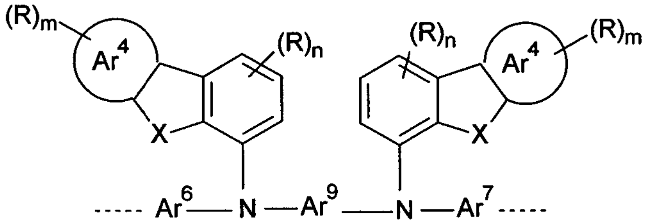

(XIV)

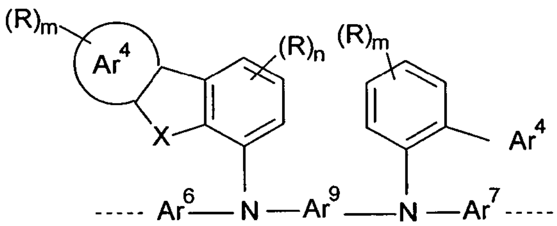

(XV)

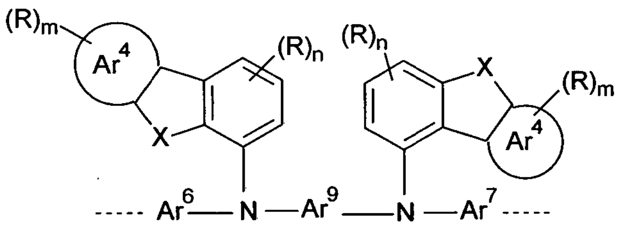

(XVI)

$Ar^4$, $Ar^5$, $Ar^6$, $Ar^7$, $Ar^8$, $Ar^9$, X, m, n, p, R and the dashed lines can adopt the meaning indicated above, in particular for formulae (I), (Ia), (Ib), (VIIIa) and/or (VIIIb).

In an example, the structural units of formulae (IX) and (X) are selected from the structural units of the following formulae (IXa) and (Xa):

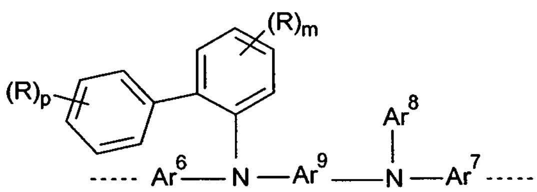

(IXa)

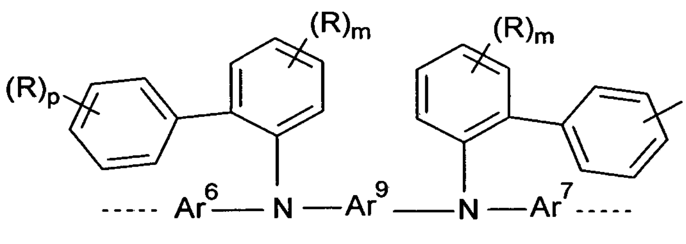

(Xa)

where $Ar^6$, $Ar^7$, $Ar^8$, $Ar^9$, R, m, p and the dashed lines can adopt the meaning indicated above, in particular for formulae (I), (Ia), (Ib), (VIIIa) and/oder (VIIIb).

Examples of preferred structural units of formulae (IXa) and (Xa) are depicted in the following table:

| | |
|---|---|
| 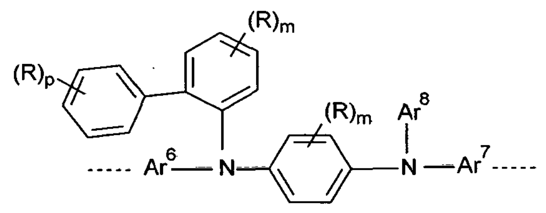 | 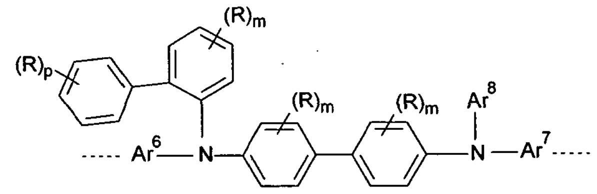 |
| 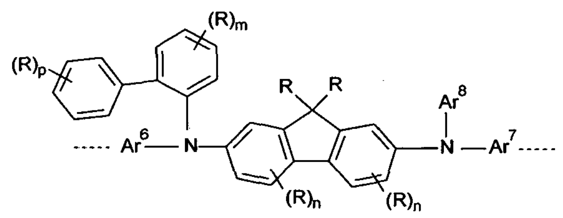 | 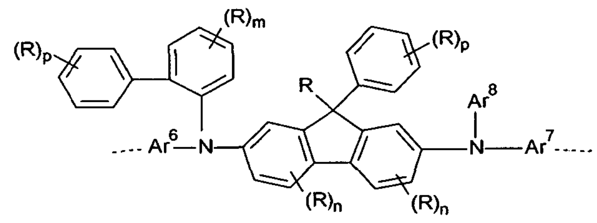 |
| 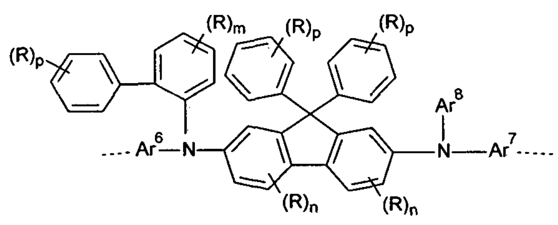 | 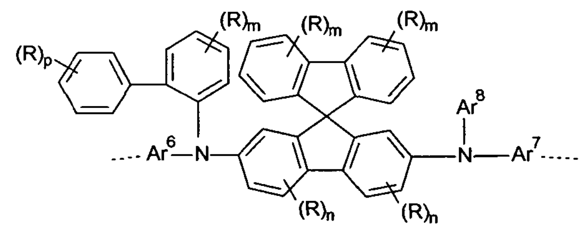 |
| 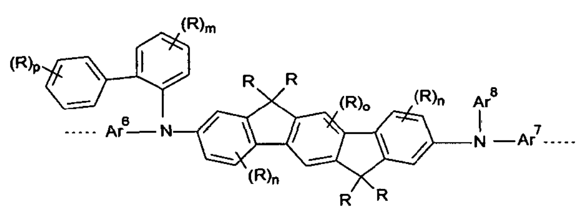 | 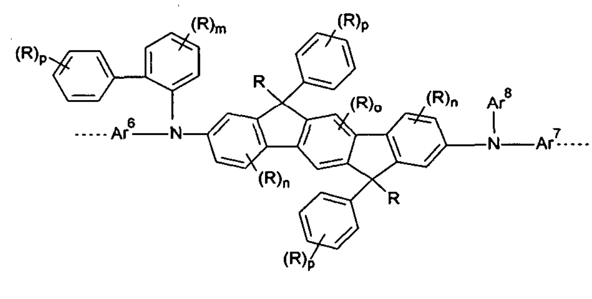 |
| 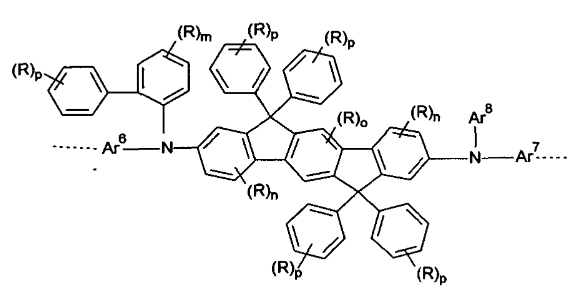 | 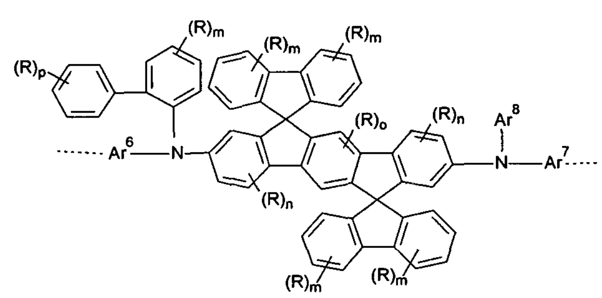 |

| | |
|---|---|
| 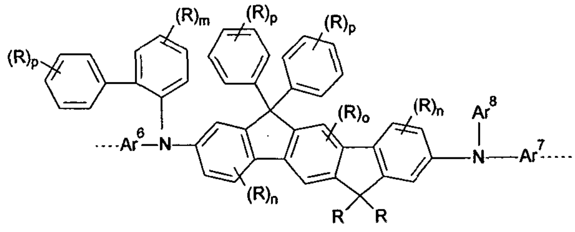 | 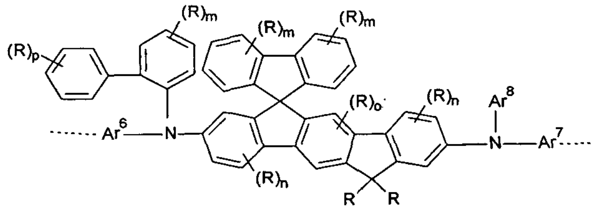 |
| 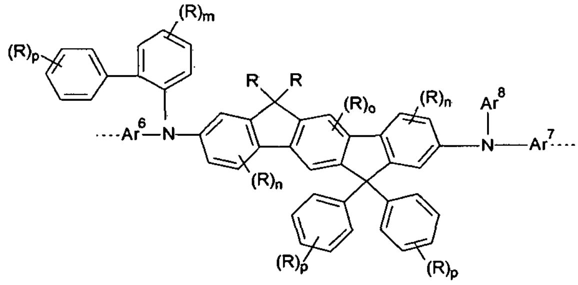 | 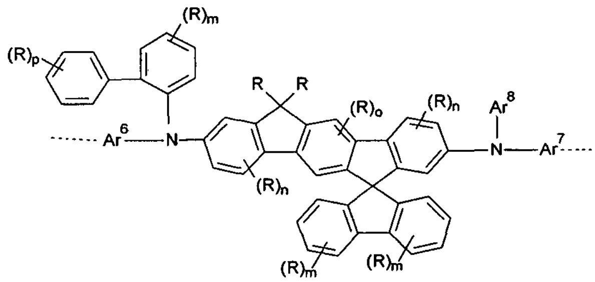 |
| 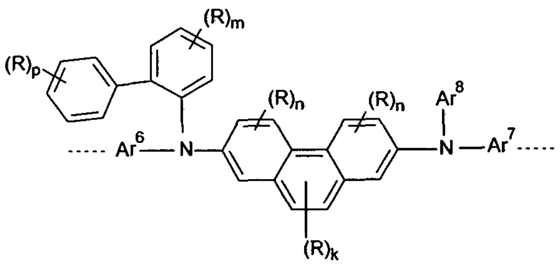 | 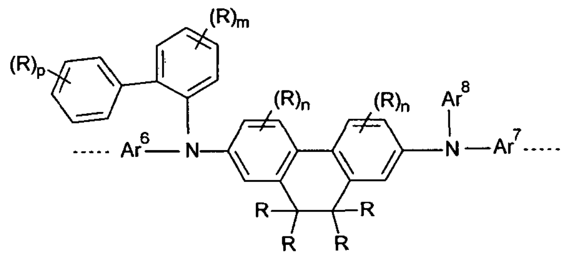 |
| 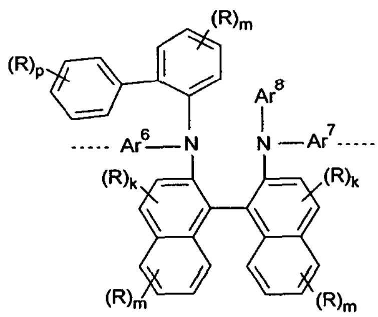 | |
| 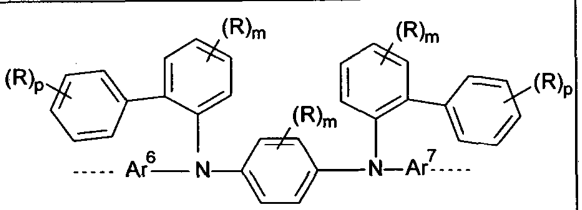 | 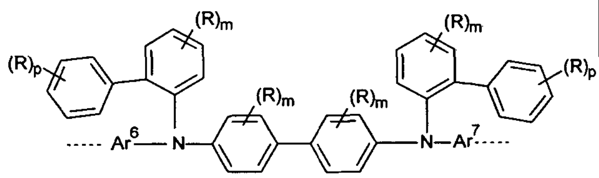 |

| | |
|---|---|
| 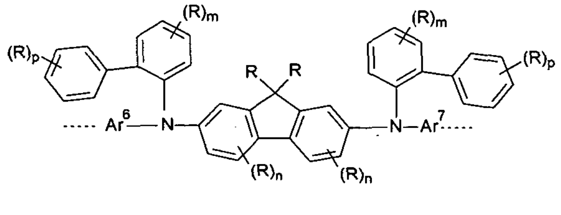 | 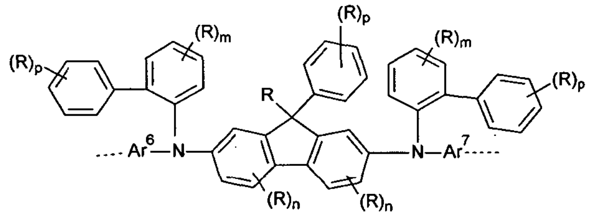 |
| 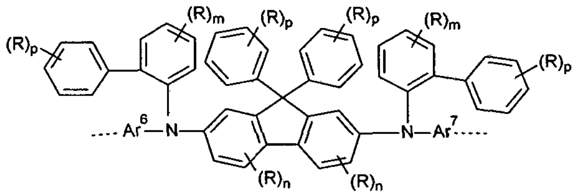 | 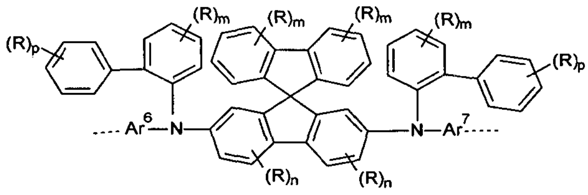 |
| 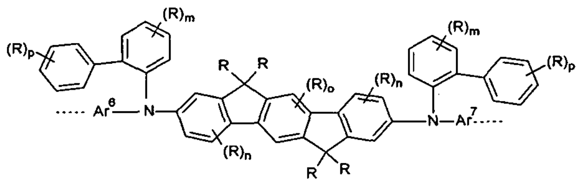 | 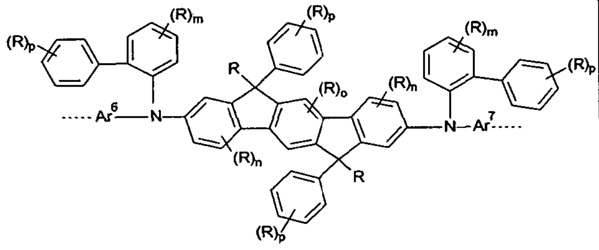 |
| 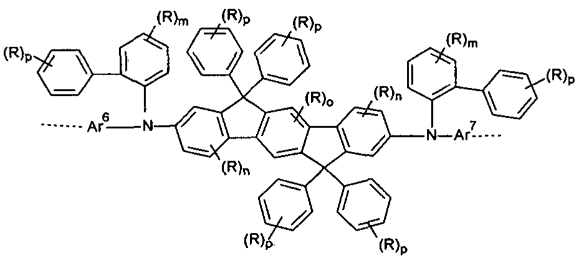 | 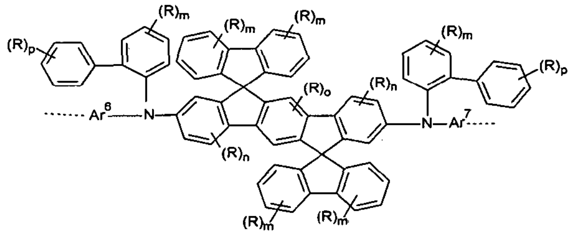 |
| 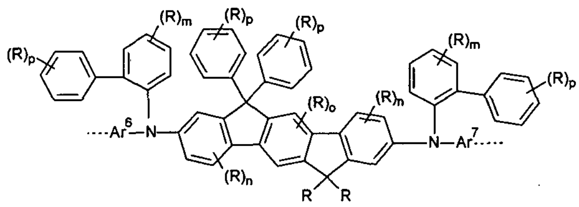 | 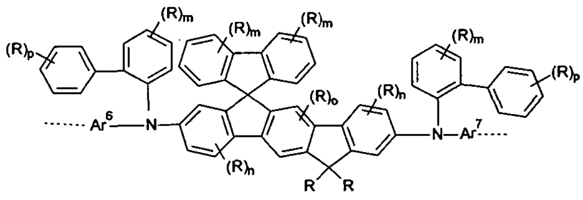 |
| 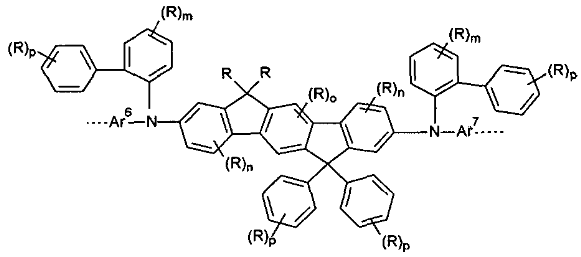 | 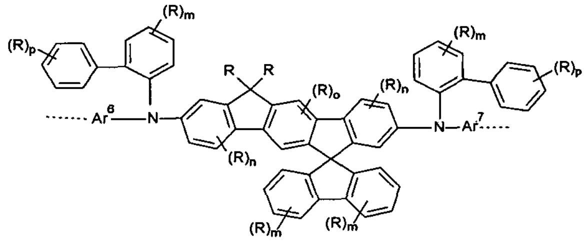 |

| | |
|---|---|
| 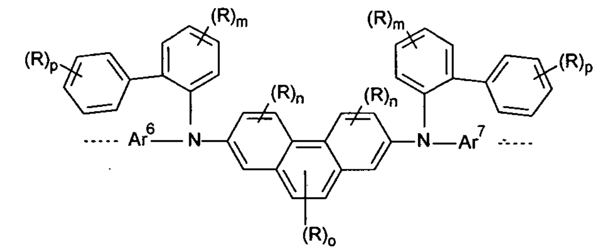 | 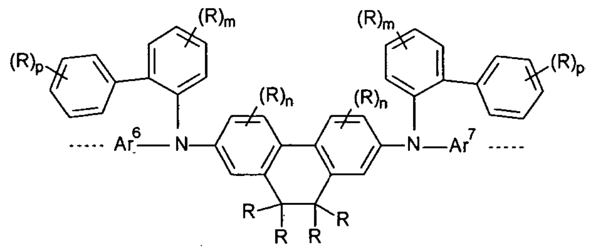 |
| 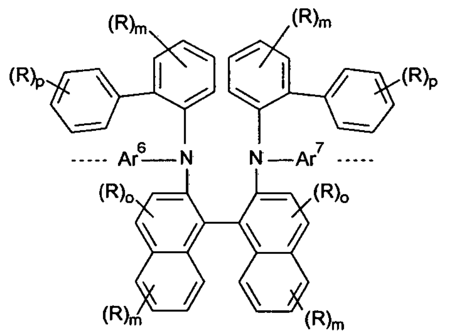 | |

where $Ar^6$, $Ar^7$, $Ar^8$, R, m, n, p and the dashed lines can adopt the meaning indicated above, in particular for formulae (I), (Ia), (Ib), (VIIIa) and/or (VIIIb), and o is 0, 1 or 2.

In a further particularly example, the structural units of formulae (XI) and (XII) are selected from the structural units of the following formulae (XIa) and (XIIa):

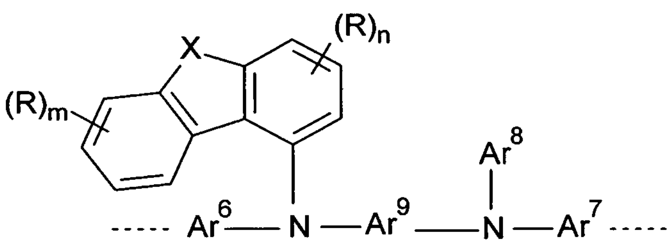

(XIa)

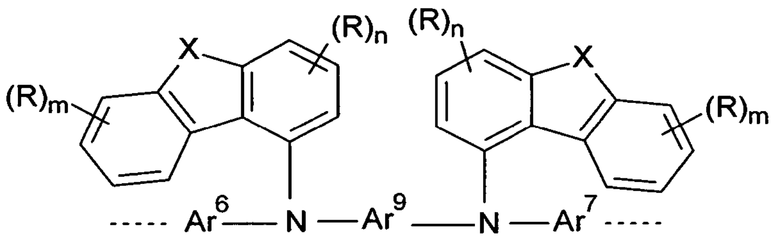

(XIIa)

where $Ar^6$, $Ar^7$, $Ar^8$, $Ar^9$, R, m, n and X can adopt the meaning indicated above, in particular for formulae (I), (Ia), (Ib), (VIIIa) and/or (VIIIb).

Examples of preferred structural units of formulae (XIa) and (XIIa) are depicted in the following table:

| | |
|---|---|
| 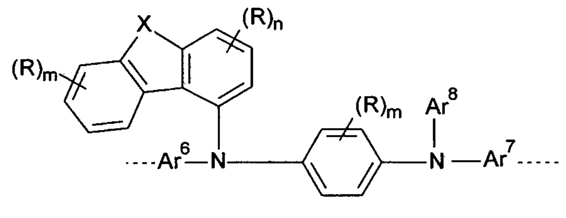 | 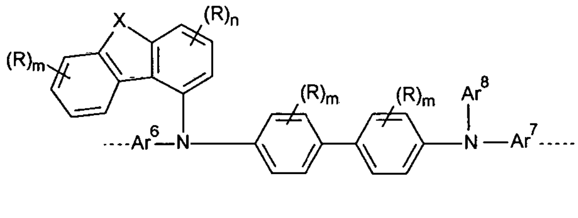 |
| 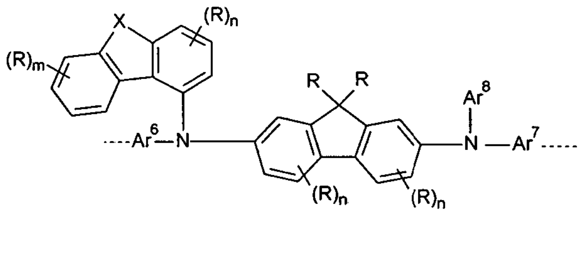 | 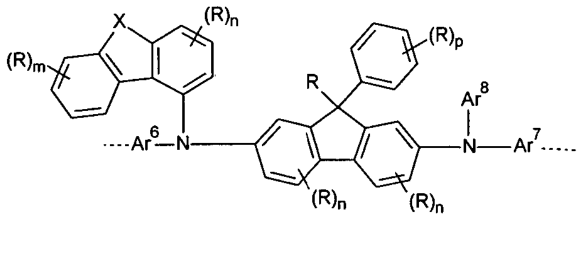 |
| 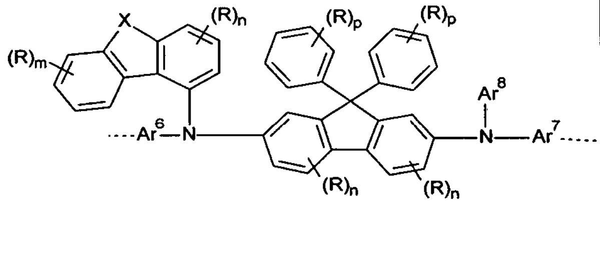 | 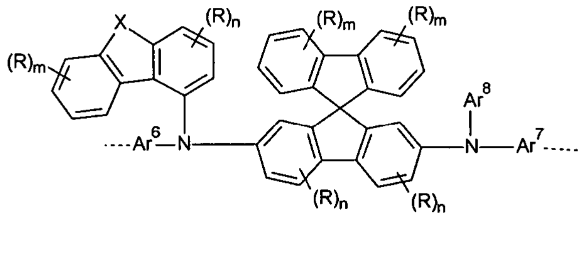 |
| 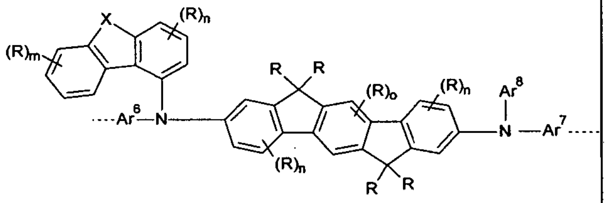 | 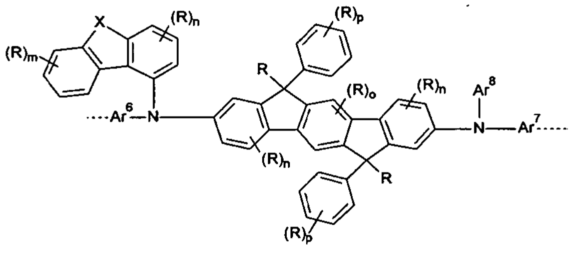 |
| 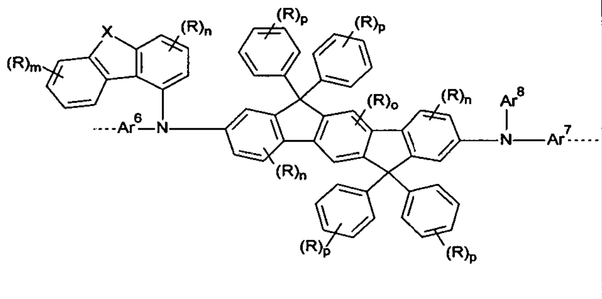 | 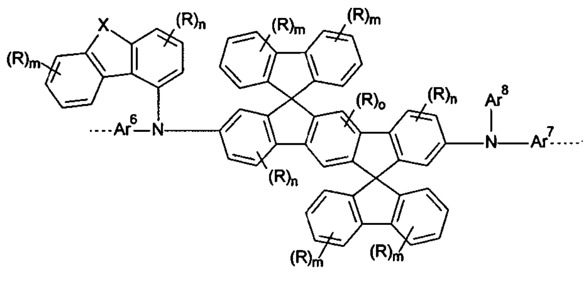 |

| | |
|---|---|
| 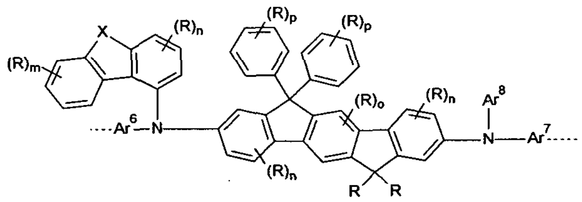 | 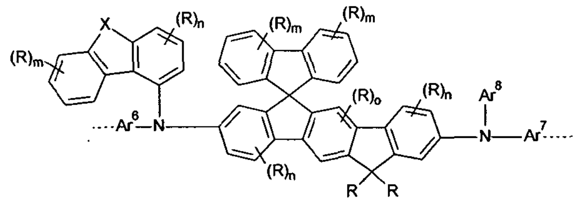 |
| 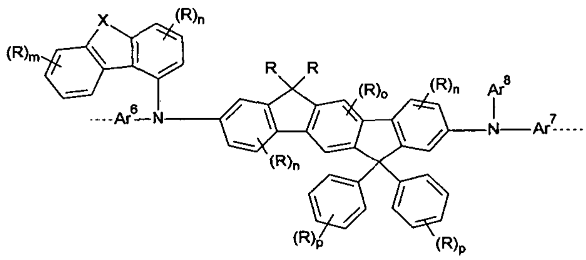 | 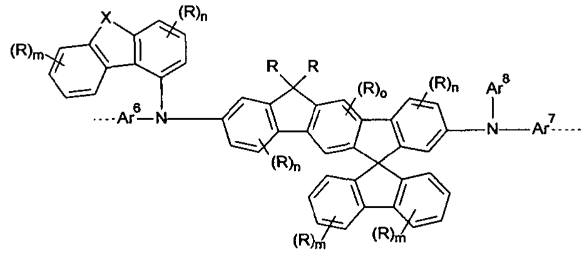 |
| 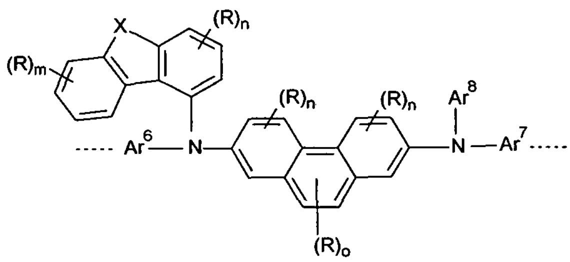 | 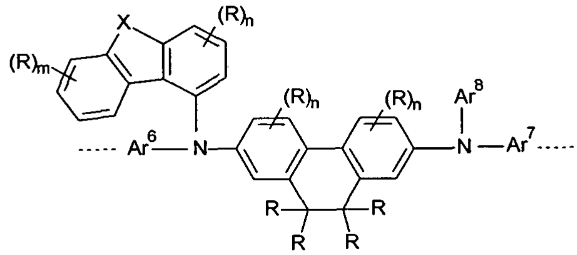 |
| 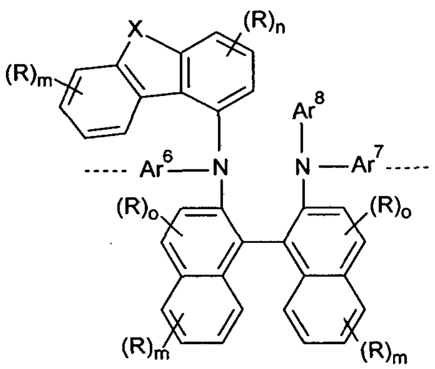 | |
| 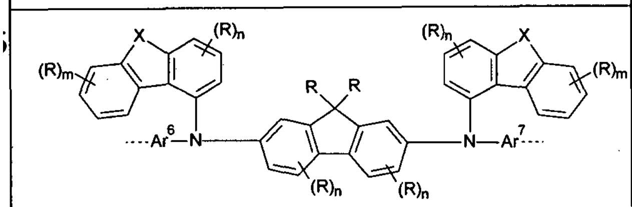 | 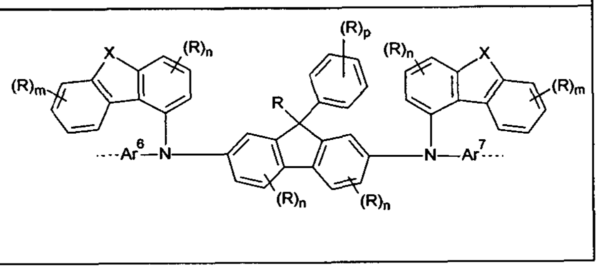 |

| | |
|---|---|
| 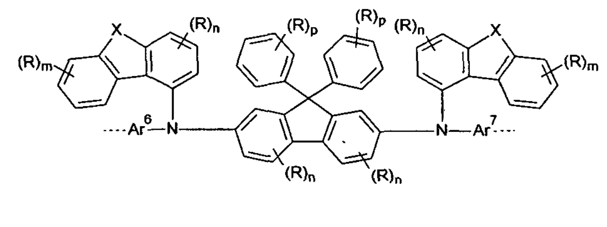 | 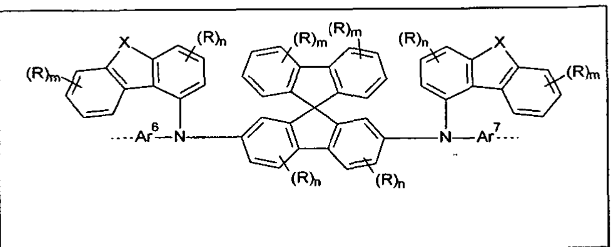 |
| 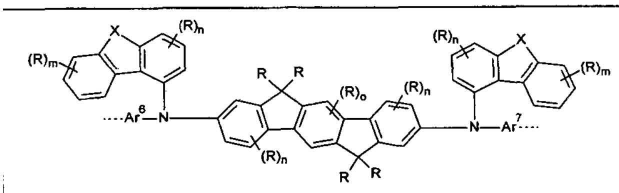 | 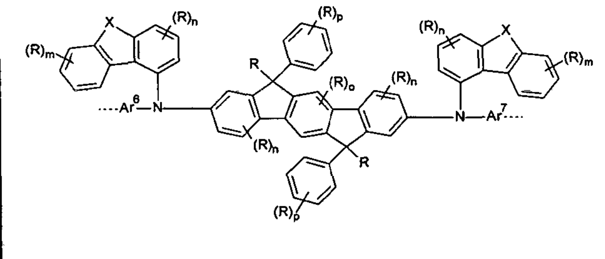 |
| 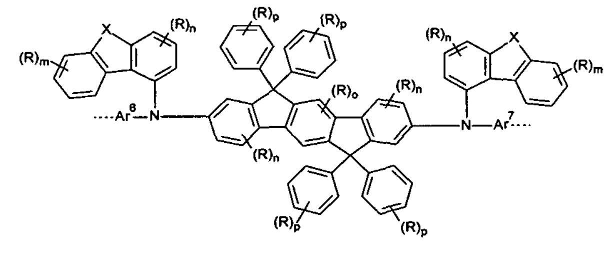 | 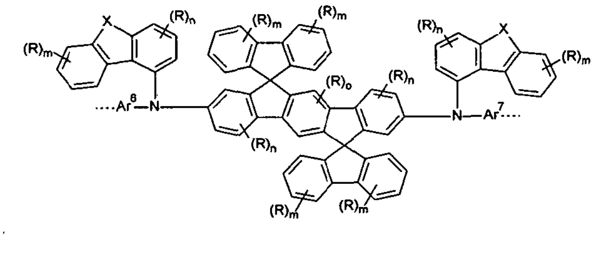 |
| 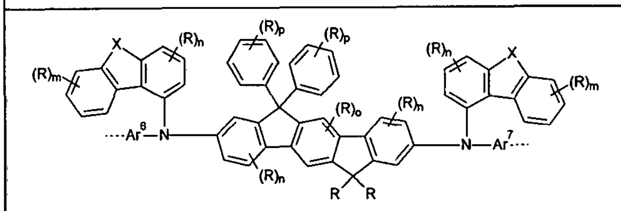 | 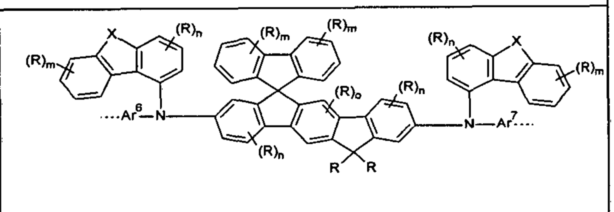 |
| 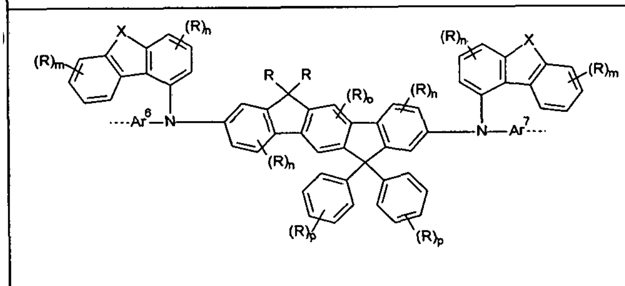 | 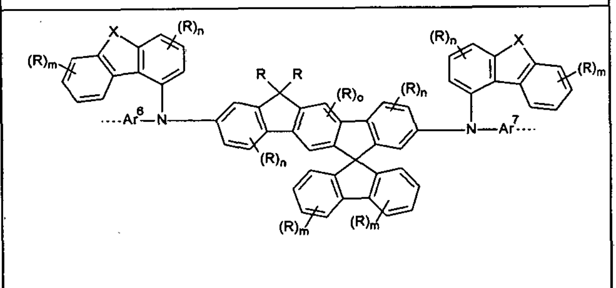 |
| 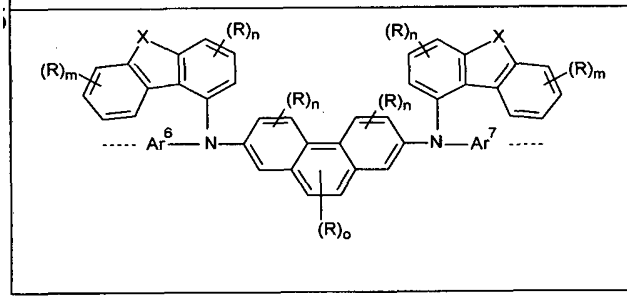 | 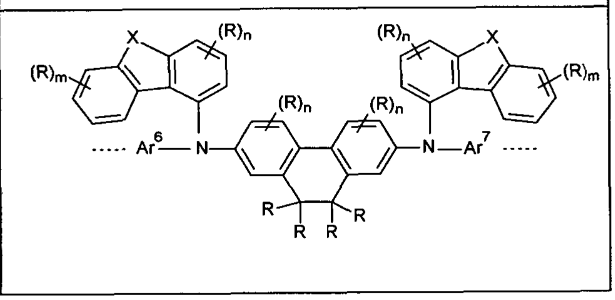 |

| | |
|---|---|
| 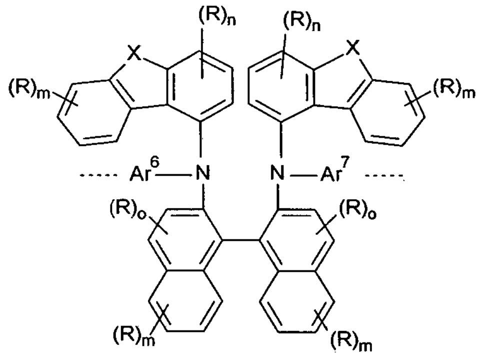 | |

where $Ar^6$, $Ar^7$, $Ar^8$, R, m, n and p can adopt the meaning indicated above, in particular for formulae (I), (Ia), (Ib), (VIIIa) and/or (VIIIb), and o is 0, 1 or 2.

In a further particularly example, the structural units of formulae (XIII) and (XIV) are selected from the structural formulae of the following formulae (XIIIa) and (XIVa):

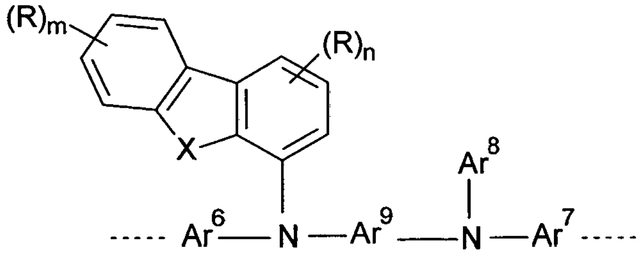

(XIIIa)

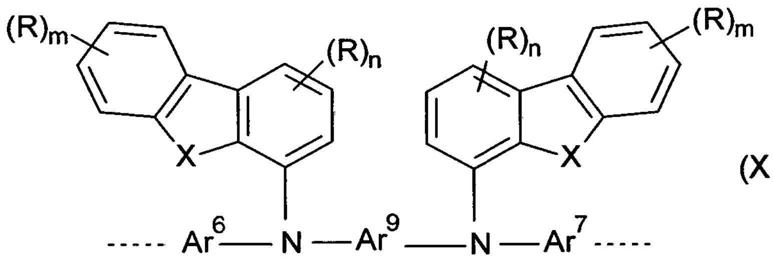

(XIVa)

where $Ar^6$, $Ar^7$, $Ar^8$, $Ar^9$, R, m, n and X can adopt the meaning indicated above, in particular for formulae (I), (Ia), (Ib), (VIIIa) and/or (VIIIb).

Examples of preferred structural units of formulae (XIIIa) and (XIVa) are depicted in the following table:

| | |
|---|---|
| 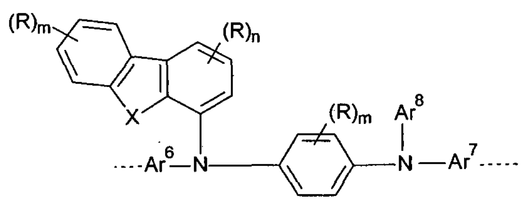 | 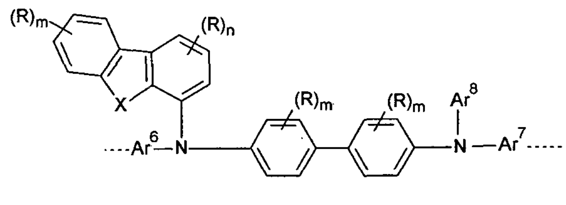 |
| 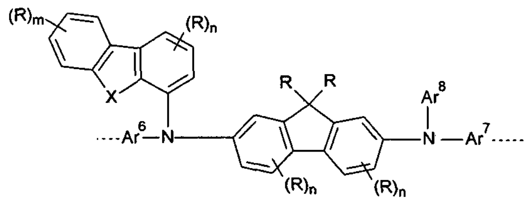 | 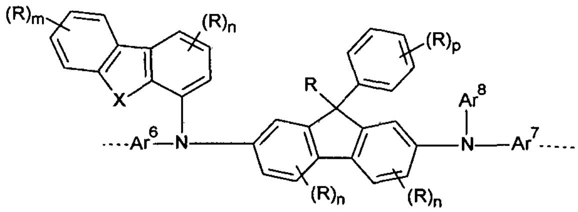 |
| 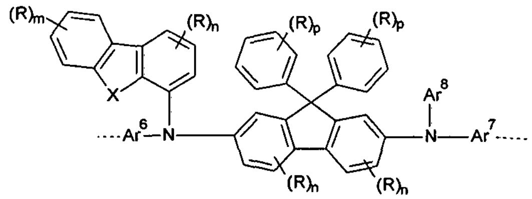 | 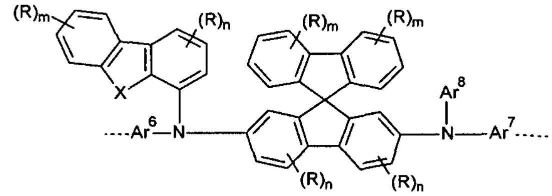 |
| 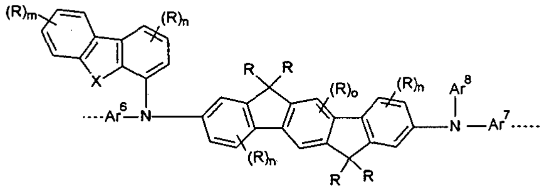 | 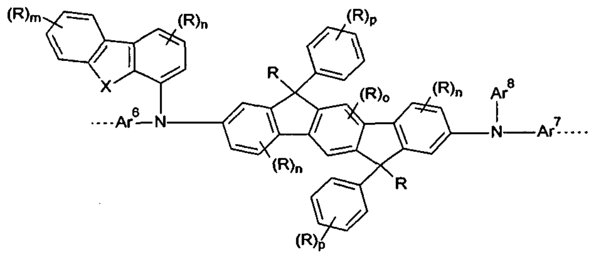 |
| 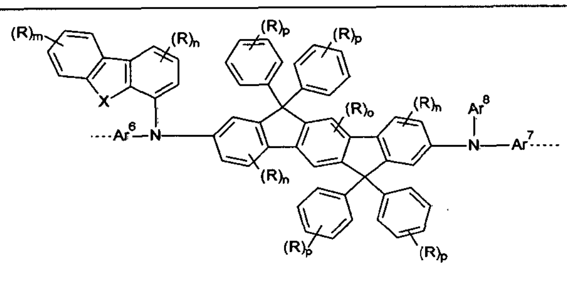 | 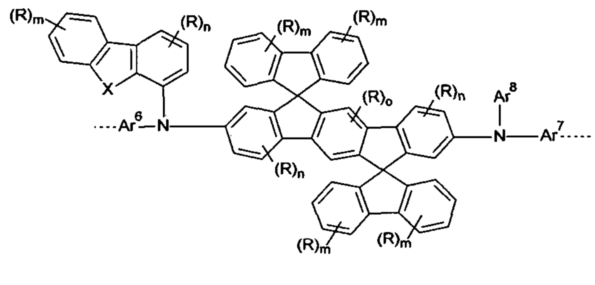 |
| 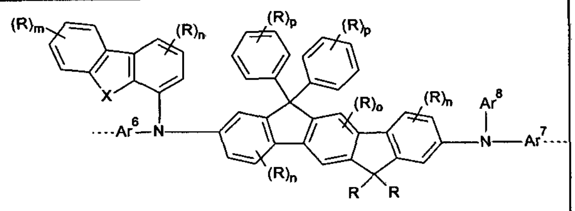 | 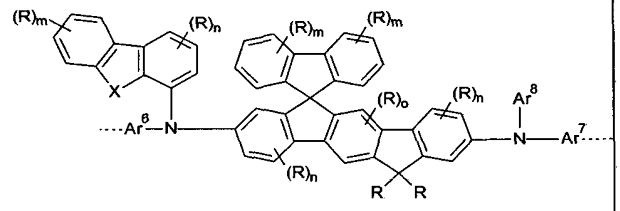 |

| | |
|---|---|
| 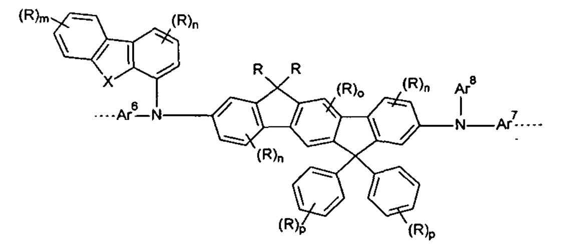 | 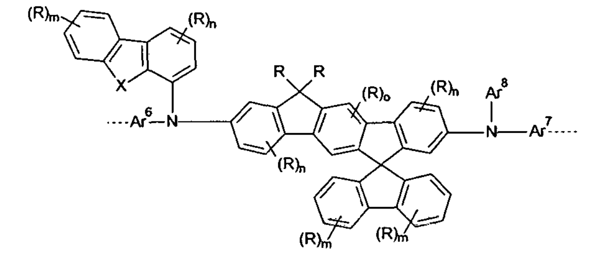 |
| 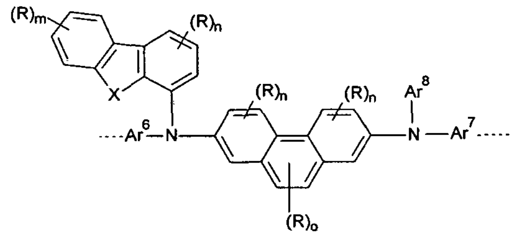 | 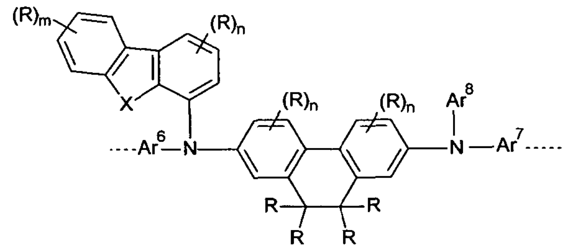 |
| 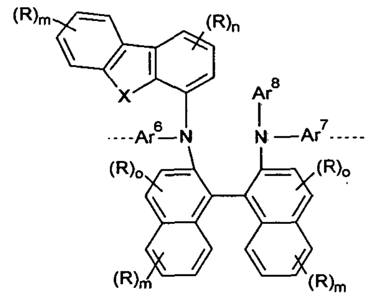 | |
| 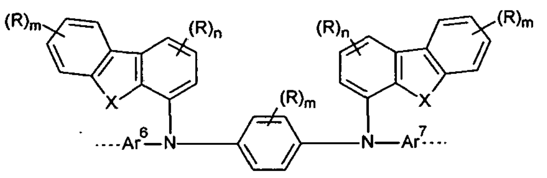 | 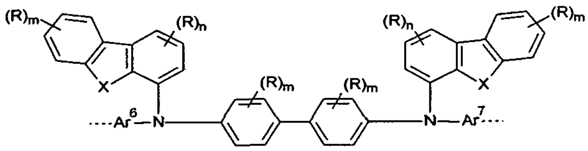 |
| 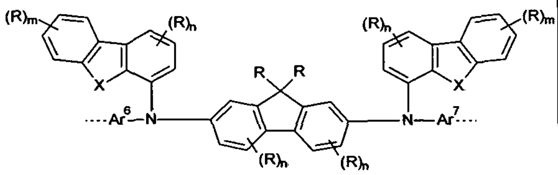 | 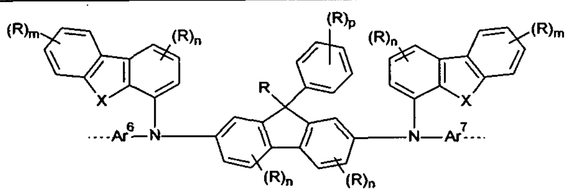 |
| 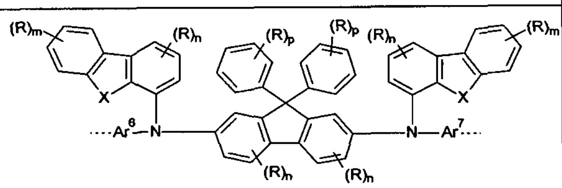 | 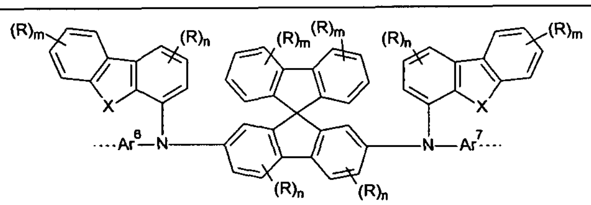 |

| | |
|---|---|
| 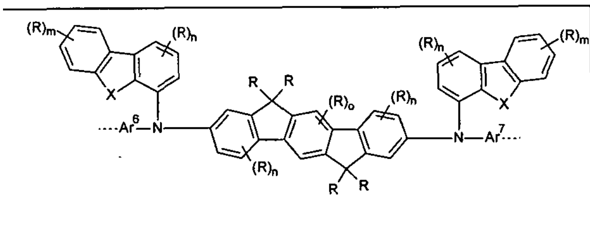 | 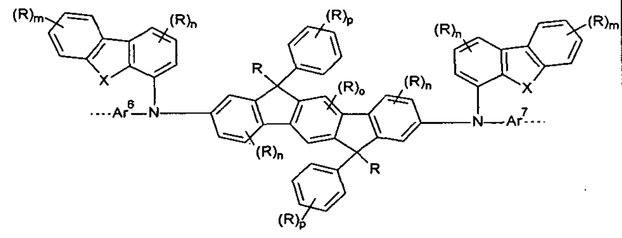 |
| 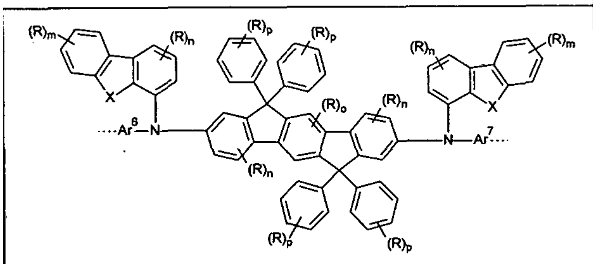 | 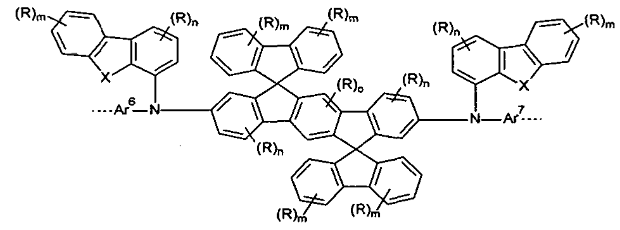 |
| 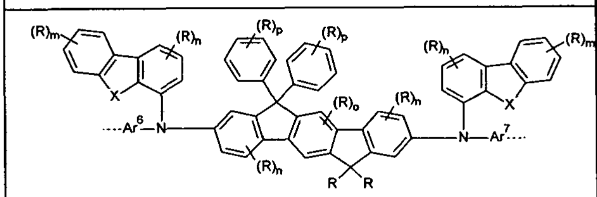 | 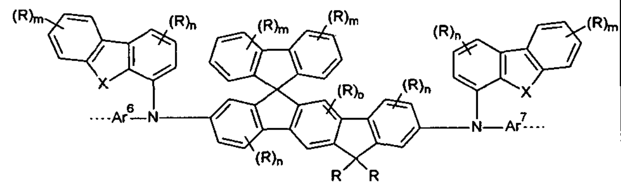 |
| 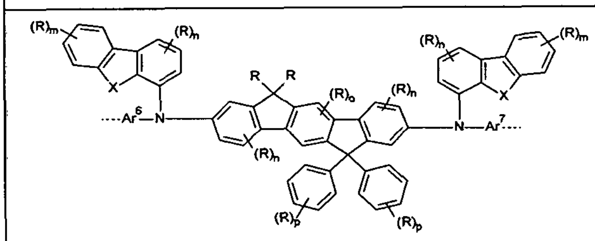 | 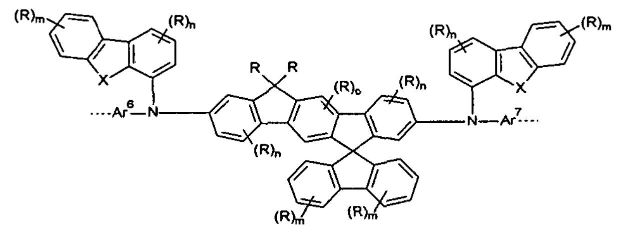 |
| 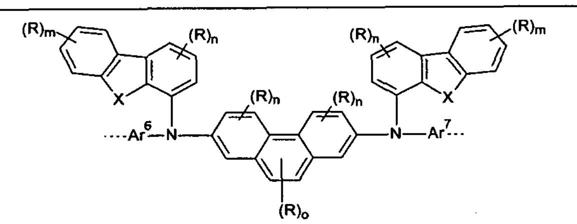 | 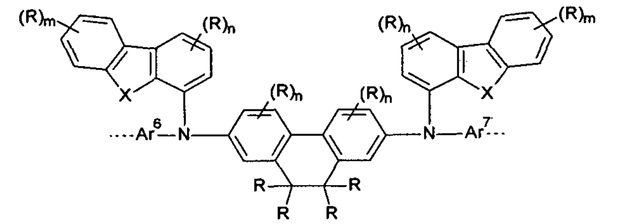 |
| 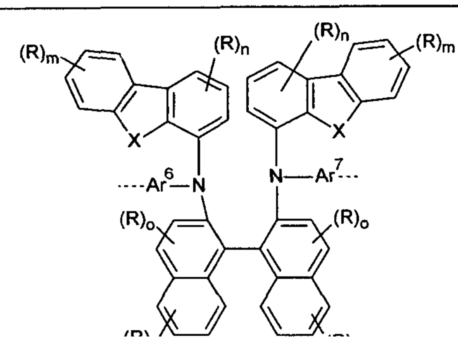 | |

where $Ar^6$, $Ar^7$, $Ar^8$, R, m, n and p can adopt the meaning indicated above, in particular for formulae (I), (Ia), (Ib), (VIIIa) and/or (VIIIb) and, o is 0, 1 oder 2.

In a very particularly example, the structural units of formulae (IXa) and (Xa) are selected from the structural

units of the following formulae (IXb) and (Xb):

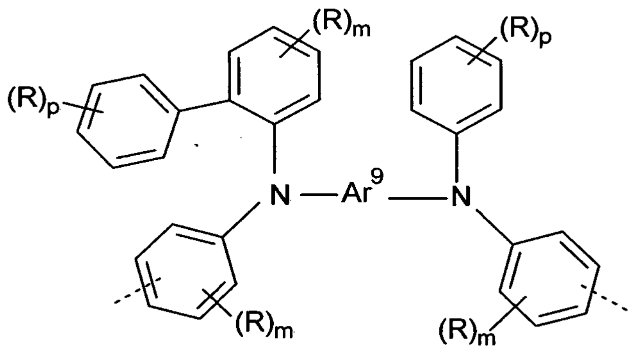

(IXb)

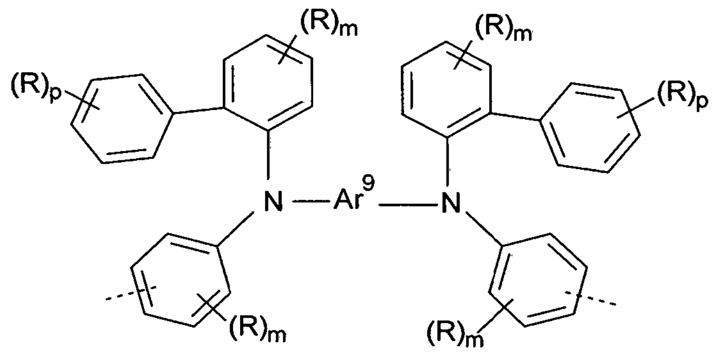

(Xb)

where $Ar^9$, R, m and p can adopt the meaning indicated above, in particular for formulae (I), (Ia), (Ib), (VIIIa) and/or (VIIIb).

Example of preferred structural units of formulae (IXb) and (Xb) are depicted in the following table:

| | |
|---|---|
| 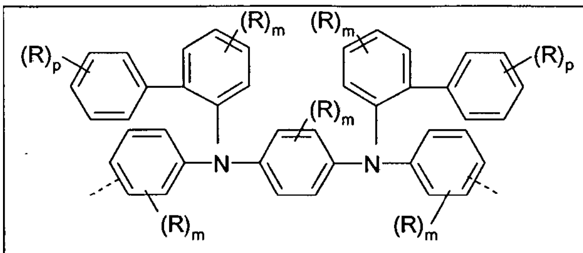 | 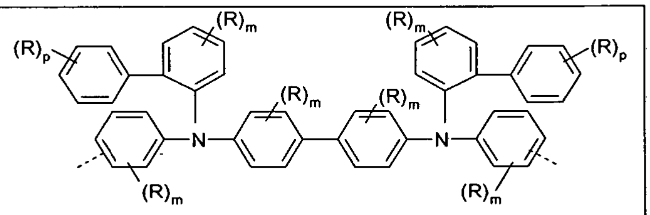 |
| 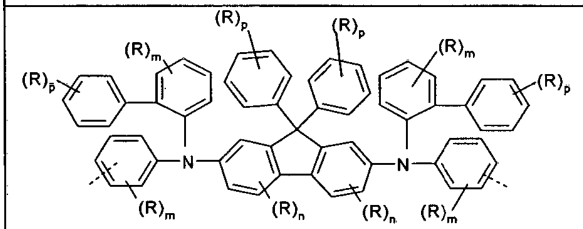 | 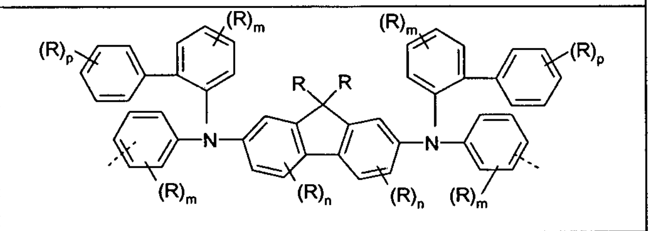 |
| 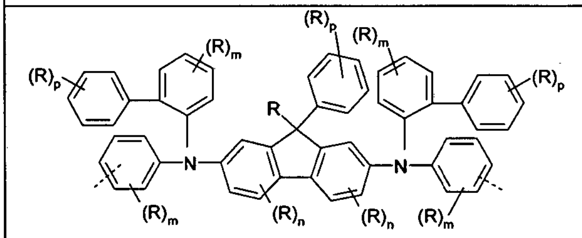 | 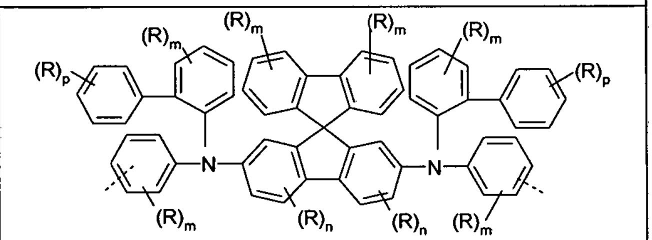 |
| 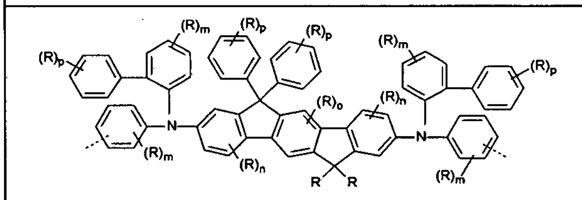 | 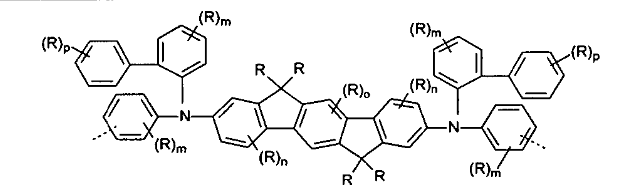 |
| 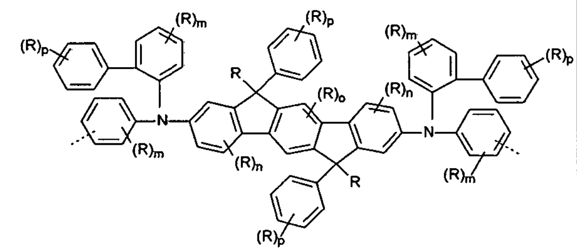 | 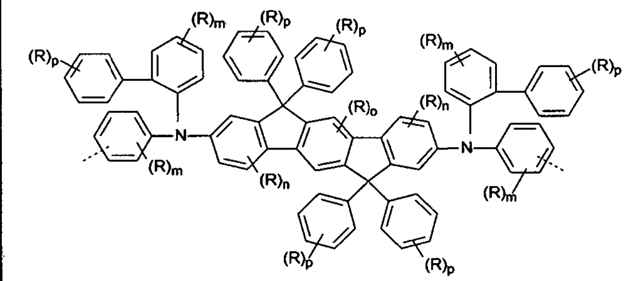 |
| 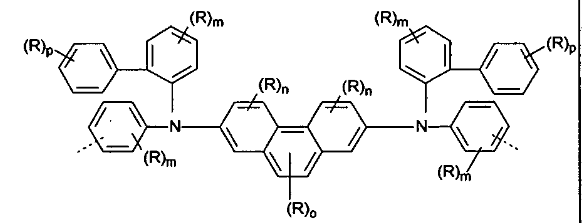 | 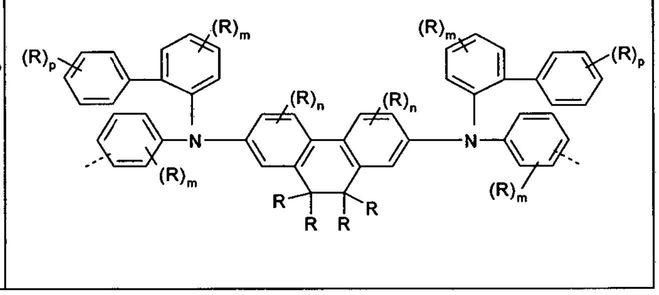 |

| | |
|---|---|
| 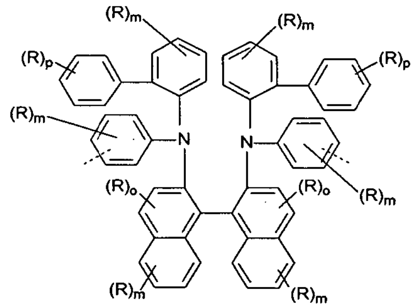 | |

where R, m, n and p can adopt the meaning indicated above, in particular for formulae (I), (Ia), (Ib), (VIIIa) and/or (VIIIb) and, o is 0, 1 or 2.

In a further example, the structural units of formulae (XIa) and (XIIa) are selected from the structural units of the following formulae (XIb) and (XIIb):

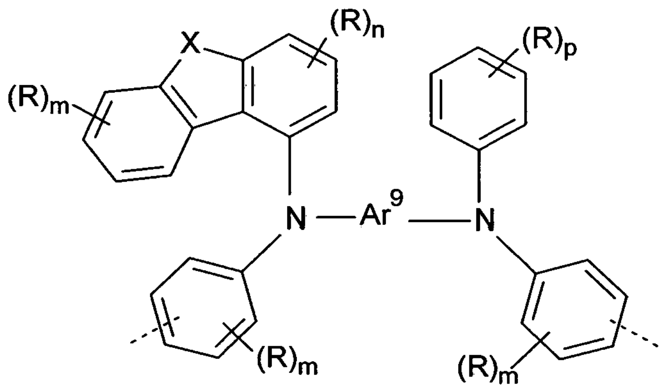

(XIb)

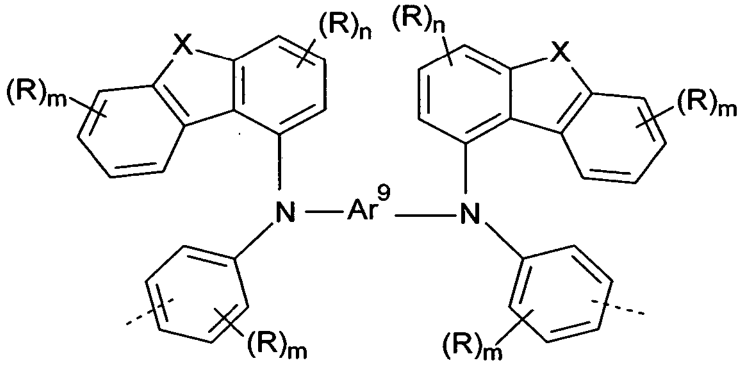

(XIIb)

where $Ar^9$, R, X, m, n and p can adopt the meaning indicated above, in particular for formulae (I), (Ia), (Ib), (VIIIa) and/or (VIIIb).

Examples of preferred structural units of formulae (XIb) and (XIIb) are depicted in the following table:

| | |
|---|---|
| 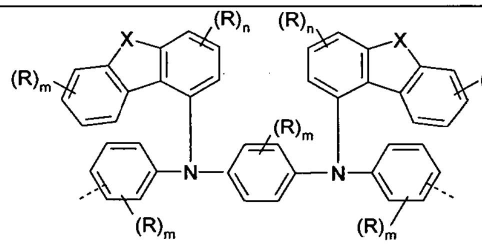 | 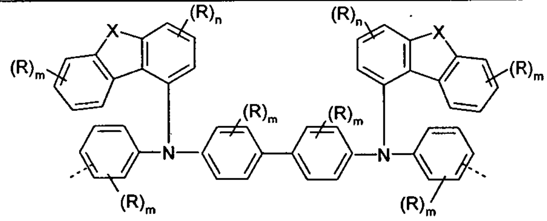 |
| 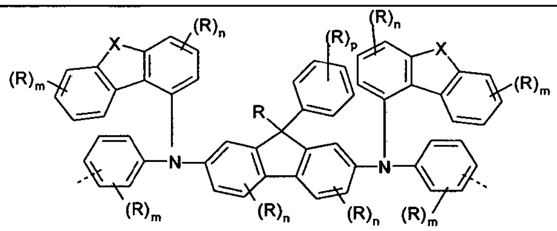 | 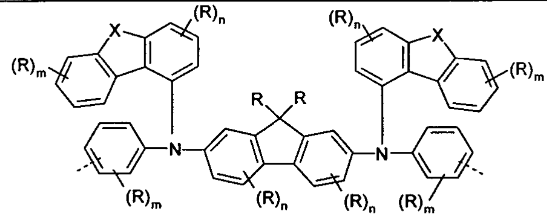 |
| 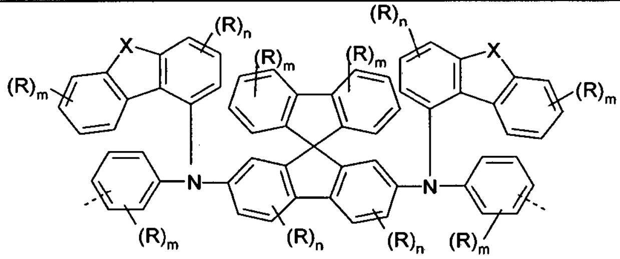 | 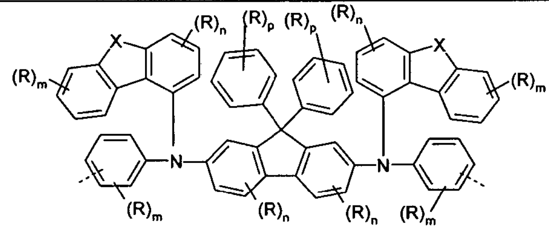 |
| 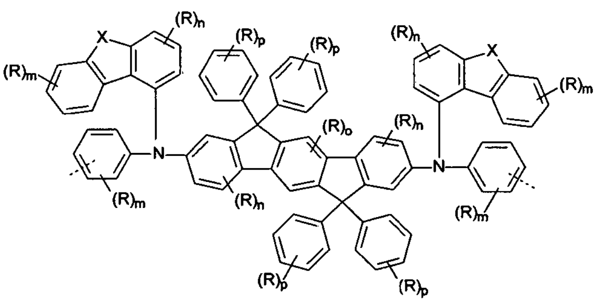 | 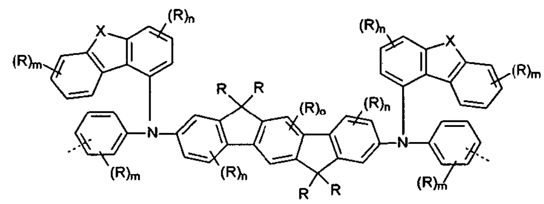 |
| 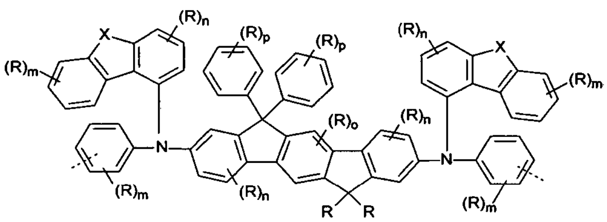 | 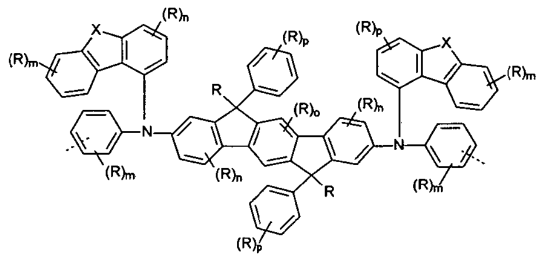 |

| | |
|---|---|
| 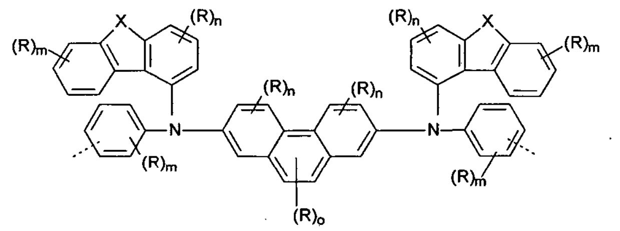 | 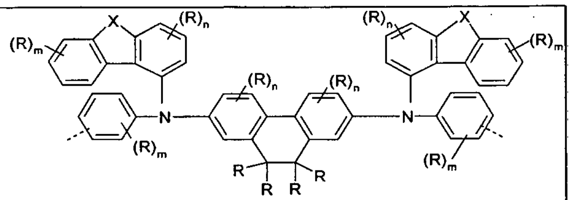 |
| 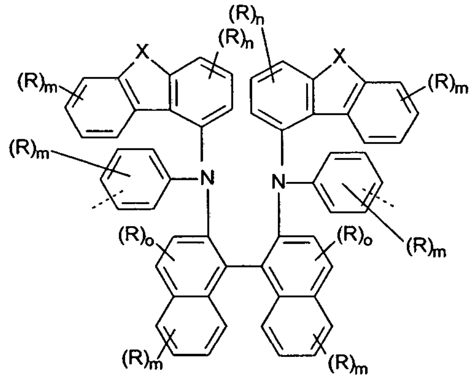 | |

where R, X, m, n and p can adopt the same meaning indicated above, in particular for formulae (I), (Ia), (Ib), (VIIIa) and/or (VIIIb), and o is 0, 1 oder 2.

In a further very particularly example, the structural units of formulae (XIIIa) and (XIVa) are selected from the structural units of the following formulae (XIIIb) and (XIVb):

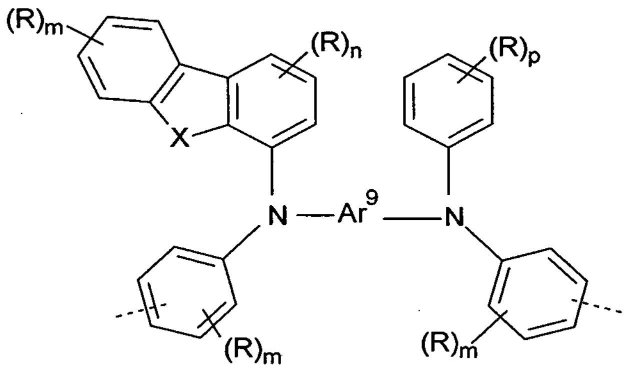

(XIIIb)

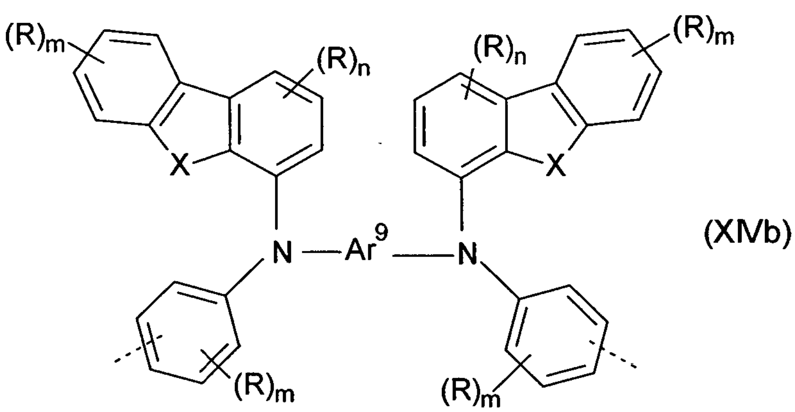

(XIVb)

where R, X, m, n and p can adopt the meaning indicated above, in particular for formulae (I), (Ia), (Ib), (VIIIa) and/or (VIIIb).

Examples of preferred structural units of formulae (XIIIb) and (XIVb) are depicted in the following table:

| | |
|---|---|
| 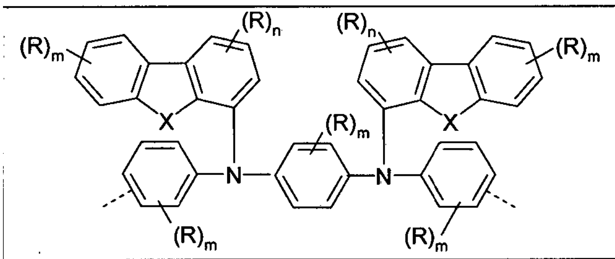 | 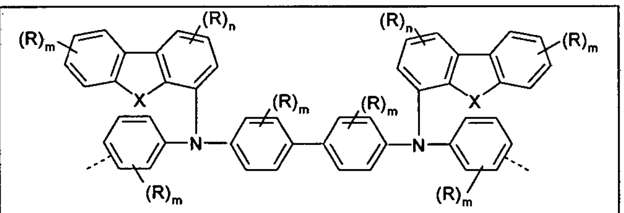 |
| 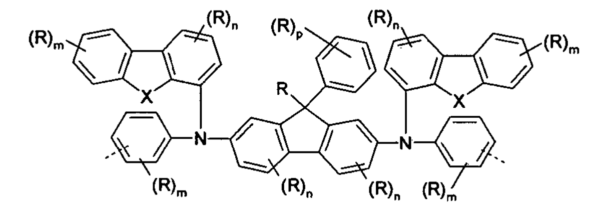 | 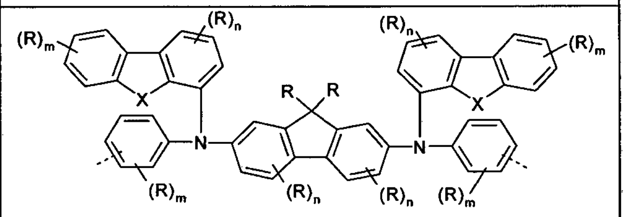 |
| 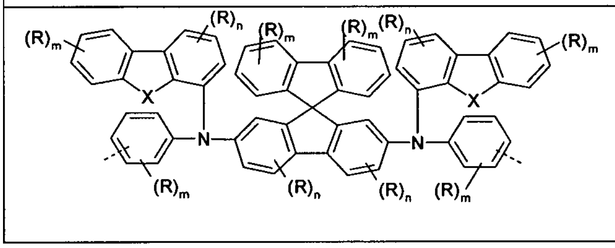 | 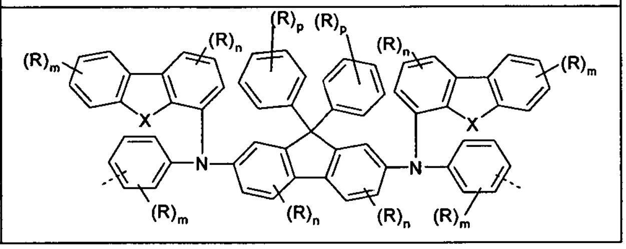 |

| | |
|---|---|
| 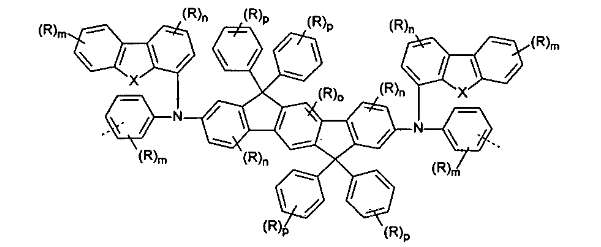 | 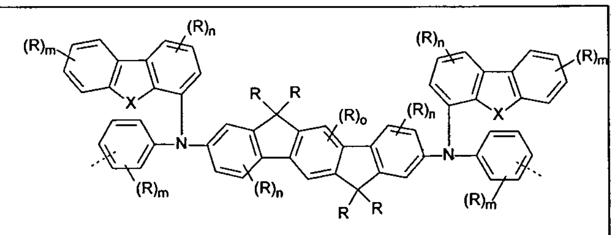 |
| 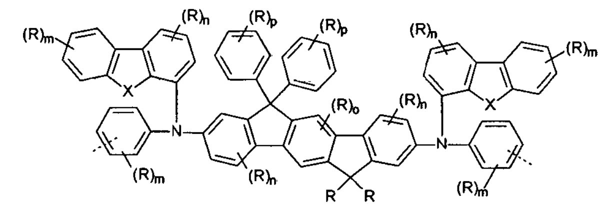 | 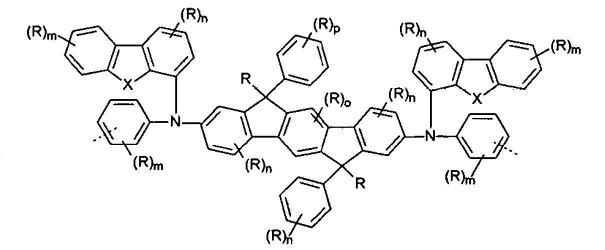 |
| 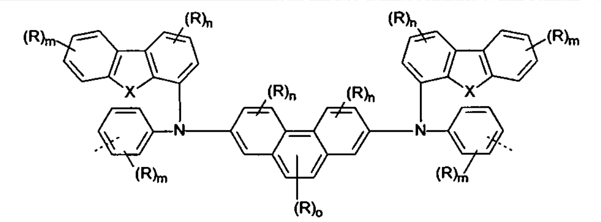 | 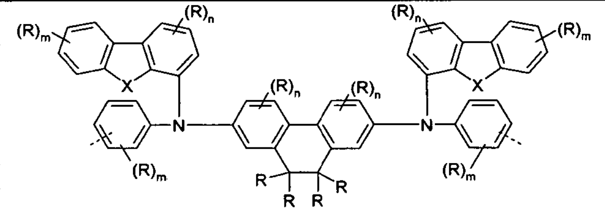 |
| 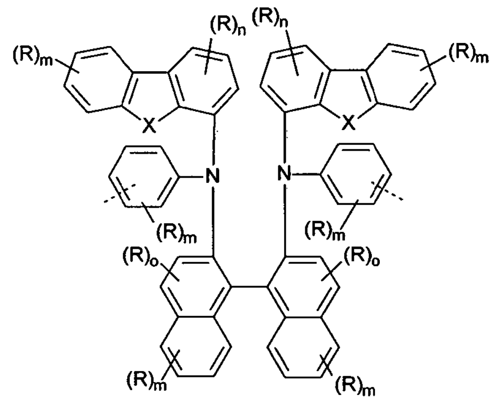 | |

where R, X, m, n and p can adopt the meaning indicated above, in particular fort he formulae (I), (Ia), (Ib), (VIIIa) and/or (VIIIb), and o is 0, 1 oder 2.

In formulae (IXa) to (XIVa) and (IXb) to (XIVb), the dashed lines represent bonds to adjacent structural units in the polymer. They can be, independently from each other, identically or differently, in ortho-, meta- or para-position, preferably identically in ortho-, meta- or para-position, more preferably in meta- or para-position and most preferably in para-position.

According to a further alternative example, at least one of the structural units of formulae (I), (Ia), (Ib), (II), (III), (IV), (V), (VI), (VII), (VIIIa), (VIIIb), (IX), (X), (XI), (XII), (XIII), (XIV), (XV), (XVI) and/or one preferred embodiment of these structural units has at least one group Q, which is crosslinkable.

According to the example, a "crosslinkable group Q" is a functional group, which is able to react and to form a non-soluble bond. The reaction can take place with a further, identical group Q, a further, different group Q or any other part of the same or of another polymer chain. Crosslinkable groups are this reactive groups. The result of the reaction of the crosslinkable groups is a corresponding crosslinked compound. The chemical reaction can also take place in the layer, where an unsoluble layer is produced as a result. The crosslinking can usually be supported with heat or with UV-, microwave-, X-Ray- or electron radiation, optionally in the presence of an initiator. "Unsoluble" in the context of the present invention means preferably, that the polymer according to the present invention exhibits, after the crosslinking reaction, thus after the reaction of the crosslinkable groups, a solubility at room temperature in an organic solvent, which is at least reduced with a factor 3, preferably with a factor 10, in comparison with the corresponding non-crosslinked

polymer of the invention in the same organic solvent.

In the context of the example, at least one crosslinkable group means that one structural unit has one or more crosslinkable groups. One structural unit preferably has exactly one crosslinkable group.

If the structural unit of formula (I) has a crosslinkable group, then this group can be linked to $Ar^1$, $Ar^2$ or $Ar^3$. Preferably, the crosslinkable group is linked to the monovalent linked, mono- or polycyclic, aromatic or heteroaromatic $Ar^3$.

If a structural unit of formulae (VIIIa) or (VIIIb) has a crosslinkable group, then this group can be linked to $Ar^5$, $Ar^6$, $Ar^7$, $Ar^8$ or $Ar^9$. The crosslinkable group is preferably linked to one of the monovalent linked, mono- or polycyclic, aromatic or heteroaromatic ring system, that is $Ar^5$ or $Ar^8$.

Preferred mono- or polycyclic, aromatic or heteroaromatic groups $Ar^3$ in formula (I), $Ar^4$ in formulae (Ia), (Ib), (II), (III), (IV), (V), (VI), (VII), (VIIIa), (VIIIb), (IX), (X), (XI), (XII), (XIII), (XIV), (XV) and/or (XVI), $Ar^5$ and $Ar^8$ in formulae (VIIIa) and/or (VIIIb), as well as the corresponding preferred embodiment are the following:

| | | |
|---|---|---|
| 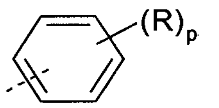 | 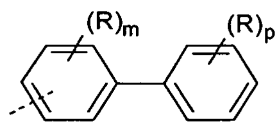 | 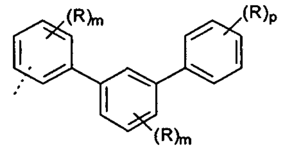 |
| E1 | E2 | E3 |
| 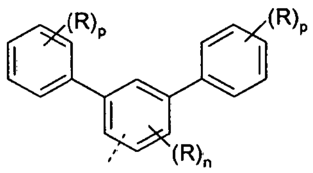 | 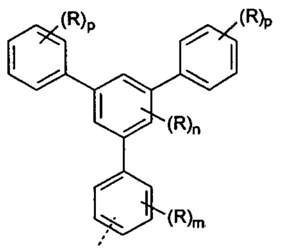 | 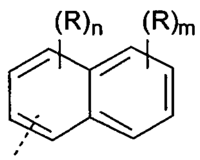 |
| E4 | E5 | E6 |
| 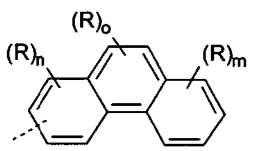 | 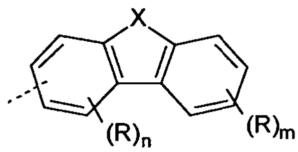 | 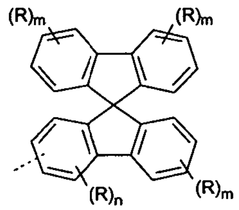 |
| E7 | E8 | E9 |
| 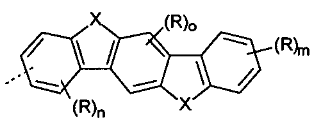 | 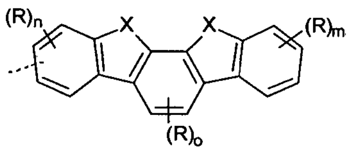 | 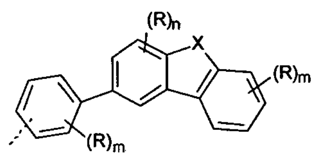 |
| E10 | E11 | E12 |

where R in formulae E1 to E12 can adopt the meaning indicated above for formula (I), X can adopt the meaning indicated for formulae (Ia) and/or (Ib), and the indices have the following meaning:

m = 0, 1, 2, 3 or 4;
n = 0, 1, 2 or 3;
o = 0, 1 or 2; and
p = 0, 1, 2, 3, 4 or 5.

Preference is given to mono- or polycyclic, aromatic or heteroaromatic groups $Ar^1$ and $Ar^2$ in formula (I), $Ar^6$, $Ar^7$ and $Ar^9$ in formula (VIIIa) and/or (VIIIb), which have the following formulae:

| | | |
|---|---|---|
| 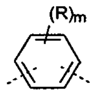 | 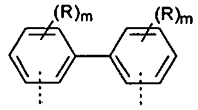 | 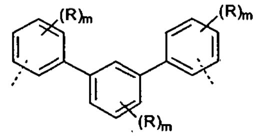 |
| M1 | M2 | M3 |
| 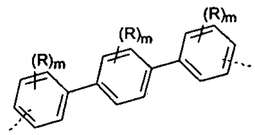 | 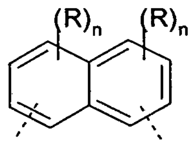 | 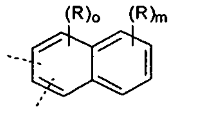 |
| M4 | M5 | M6 |
| 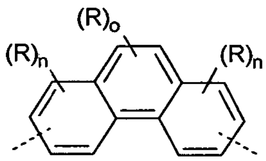 | 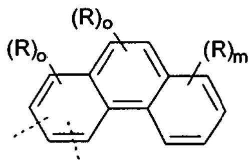 | 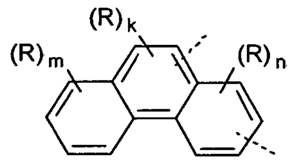 |
| M7 | M8 | M9 |
| 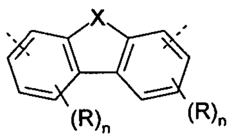 | 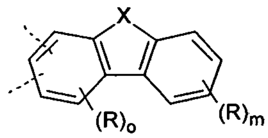 | 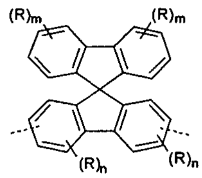 |
| M10 | M11 | M12 |
| 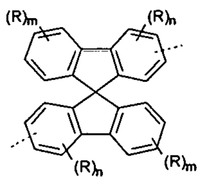 | 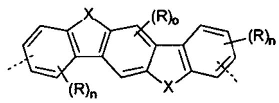 | 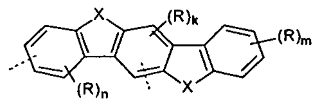 |
| M13 | M14 | M15 |
| 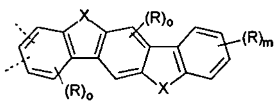 | 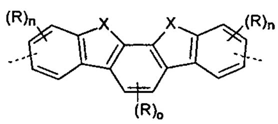 | 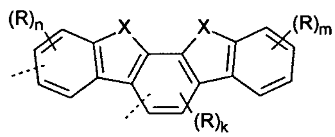 |
| M16 | M17 | M18 |
| 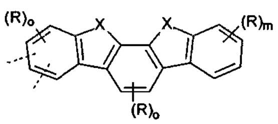 | 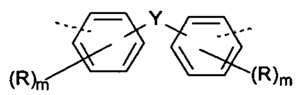 | |
| M19 | M20 | |

(continued)

| | | |
|---|---|---|
| 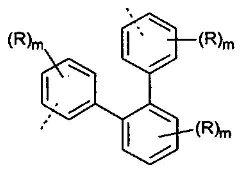 | 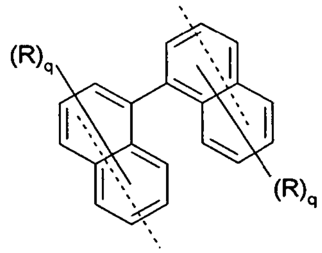 | 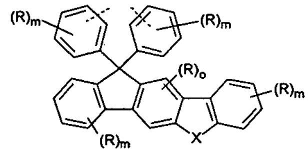 |
| M21 | M22 | M23 |

R in formulae M1 to M23 can adopt the meaning indicated for formula (I), X can adopt the meaning indicated for formulae (Ia) and/or (Ib).

Y can be $CR_2$, $SiR_2$, O, S, a straight or branched alkyl group having 1 to 20 C atoms, or an alkenyl or alkynyl group having 2 to 20 C atoms, which may in each case be substituted by one or more radicals $R^1$, where one or more non-adjacent $CH_2$ groups may be replaced by $Si(R^1)_2$, C=O, C=S, $C=NR^1$, $P(=O)(R^1)$, SO, $SO_2$, $NR^1$, O, S or $CONR^1$ or an aromatic or heteroaromatic ring system having 5 to 60 aromatic ring atoms, which may in each case be substituted by one or more radicals $R^1$, or an aryloxy or heteroaryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$, or a diarylamino group, diheteroarylamino group or arylheteroarylamino group having 10 to 40 aromatic ring atoms, which may be substituted by one or more radicals $R^1$, wherein R and $R^1$ can adopt the same meaning as indicated for formula (I).

The indices have the following meaning:

k = 0 or 1;
m = 0, 1, 2, 3 or 4;
n = 0, 1, 2 or 3;
o = 0, 1 or 2; and
q = 0, 1, 2, 3, 4, 5 or 6.

Particular preference is given to mono- or polycyclic, aromatic or heteroaromatic groups $Ar^3$ in formula (I), $Ar^4$ in formulae (Ia), (Ib), (II), (III), (IV), (V), (VI), (VII), (VIIIa), (VIIIb), (IX), (X), (XI), (XII), (XIII), (XIV), (XV) and/or (XVI); $Ar^5$ and $Ar^8$ in formulae (VIIIa) and/or (VIIIb), as well as the corresponding preferred embodiment of following formulae:

| | | |
|---|---|---|
| 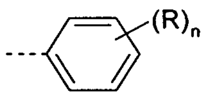 | | |
| E1a | | |
| 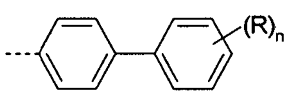 | 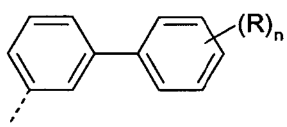 | 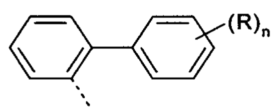 |
| E2a | E2b | E2c |
| 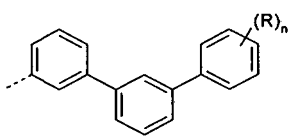 | 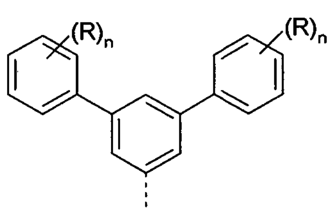 | 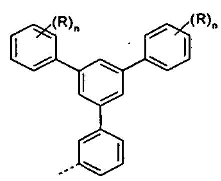 |
| E3a | E4a | E5a |

(continued)

| | | |
|---|---|---|
| 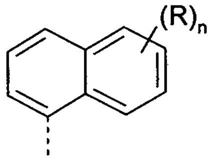 | 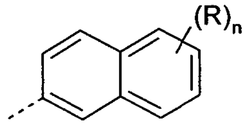 | 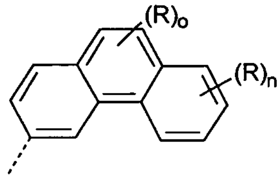 |
| E6a | E6b | E7a |
| 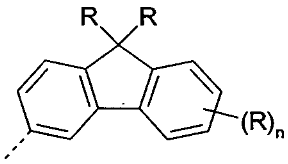 | 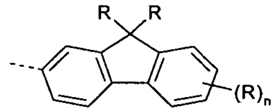 | 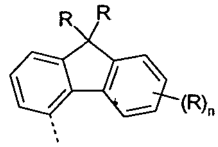 |
| E8a | E8b | E8c |
| 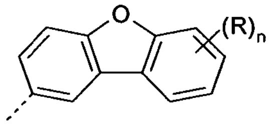 | 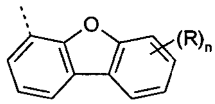 | 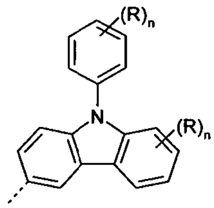 |
| E8d | E8e | E8f |
| 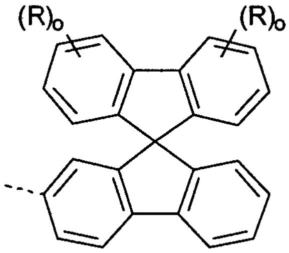 | 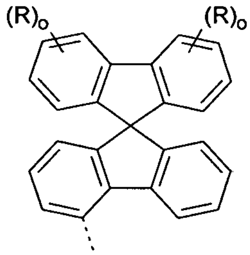 | |
| E9a | E9b | |
| 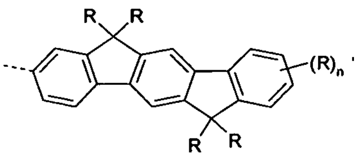 | 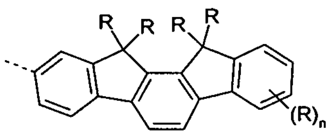 | 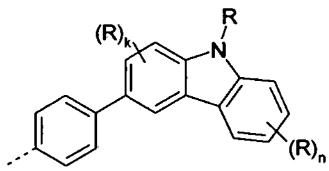 |
| E10a | E11a | E12a |

R in formulae E1a to E12a can adopt the same meaning as indicated for formula (I).

The indices have the following meaning:

o = 0 or 1; and
n = 0, 1, 2 or 3.

Particular preference is given to mono- or polycyclic, aromatic or heteroaromatic groups $Ar^2$ and $Ar^3$ in formula (I), $Ar^5$, $Ar^7$ and $Ar^8$ in formulae (IIa), $Ar^4$, $Ar^5$ und $Ar^8$ in formulae (IIb), as well as $Ar^9$ in formula (III), which have following formulae:

| | | |
|---|---|---|
| 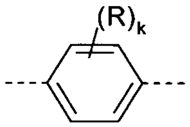 | 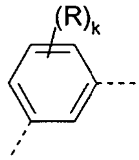 | 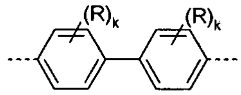 |
| M1a | M1b | M2a |
| 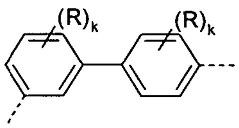 | 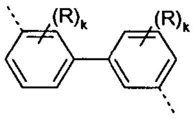 | 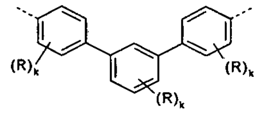 |
| M2b | M2c | M3a |
| 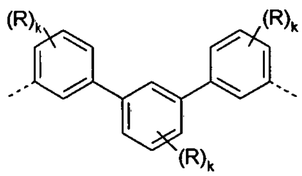 | | |
| M3b | | |
| 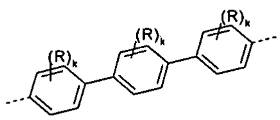 | 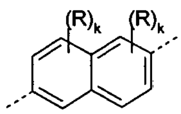 | 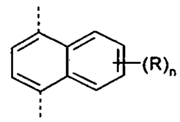 |
| M4a | M5a | M6a |
| 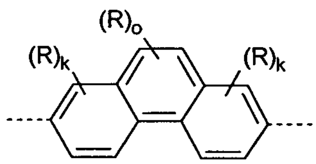 | 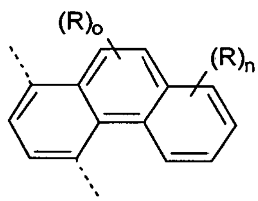 | 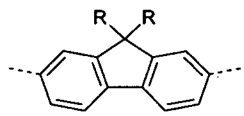 |
| M7a | M8a | M10a |
| 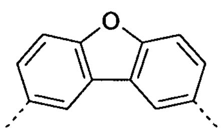 | 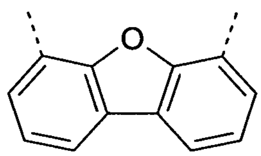 | 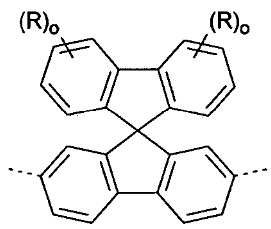 |
| M10b | M10c | M12a |
| 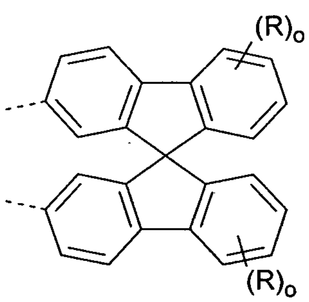 | 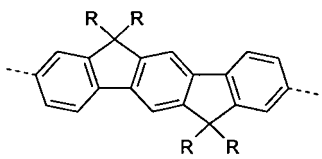 | 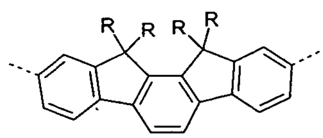 |

(continued)

| | | |
|---|---|---|
| M13a | M14a | M17a |
| 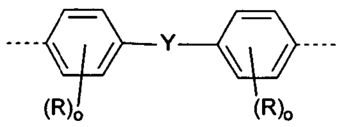 | 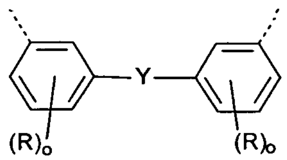 | 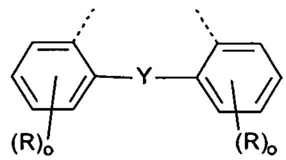 |
| M20a | M20b | M20c |
| 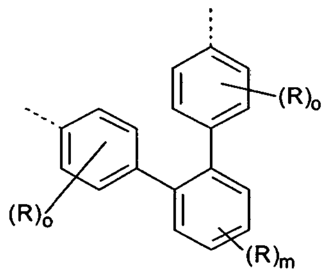 | 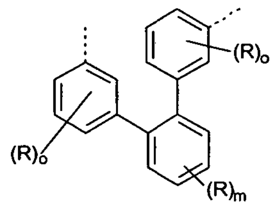 | 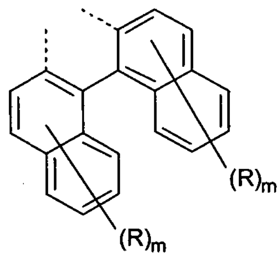 |
| M21a | M21b | M22a |
| 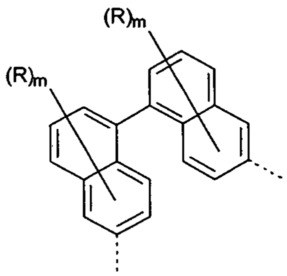 | 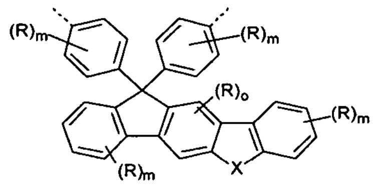 | 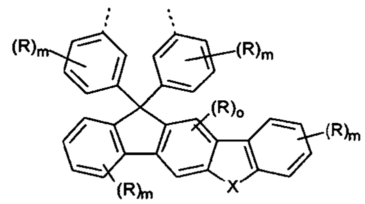 |
| M22b | M23a | M23b |

R in formulae M1a to M23b can adopt the meaning indicated for formula (I),
X can adopt the meaning indicated for formulae (Ia) and/or (Ib).

Y can be $CR_2$, $SiR_2$, O, S, a straight alkyl group having 1 to 10 C atoms, or an alkenyl or alkynyl group having 2 to 10 C atoms, which may in each case be substituted by one or more radicals $R^1$, where one or more non-adjacent $CH_2$ groups, CH-groups or C atoms of the alkyl, alkenyl or alkinyl group group may be replaced by $Si(R^1)_2$, C=O, C=$NR^1$, P(=O)($R^1$), $NR^1$, O, $CONR^1$ or an aromatic or heteroaromatic ring system having 5 to 30 aromatic ring atoms, which may in each case be substituted by one or more radicals $R^1$, or an aryloxy or heteroaryloxy group having 5 to 30 aromatic ring atoms, which may be substituted by one or more radicals $R^1$, or an aralkyl or heteroaralkyl group having 5 to 30 aromatic ring atoms, which may be substituted by one or more radicals $R^1$, or a diarylamino group, diheteroarylamino group or arylheteroarylamino group having 10 to 20 aromatic ring atoms, which may be substituted by one or more radicals $R^1$, wherein R and $R^1$ can adopt the same meaning as indicated for formula (I).

The indices have the following meaning:

k = 0 or 1;
m = 0, 1, 2, 3 or 4;
n = 0, 1, 2 or 3;
o = 0, 1 or 2.

The concentration of the polymer in the composition according to the invention is preferably in the range of from 40 to 99 wt.%, more preferably 50 to 98 wt.%, and most preferably from 70 to 97 wt.%, based on the total composition.

In another example, the hole-transport or/and one hole-injection material according to the invention is a low-molecular material having a molecular weight of ≤ 5000 g/mol, preferably ≤ 3000 g/mol, and more preferably ≤ 2000 g/mol.

Preferably, the low molecular hole-transport or/and one hole-injection material is a triarylamine compound

having three aromatic or heteroaromatic ring systems $Ar^1$, $Ar^2$, $Ar^3$, wherein at least one of $Ar^1$, $Ar^2$, $Ar^3$ is substituted by $Ar^4$ in at least one, preferably in one of the two ortho positions, where $Ar^4$ is a mono- or polycyclic , aromatic or heteroaromatic ring system having 5 to 60 aromatic ring atoms, which may be substituted by one or more radicals R.

According to the present invention, the triarylamine compound has the following formula (I'):

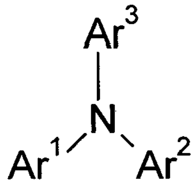

(I')

where the symbols and indices can adopt the same meaning as for formula (I).

In a preferred embodiment, $Ar^3$ according to formula (I') is in at least one, preferably in one of the two ortho-positions relating to the Nitrogen atom represented in formula (I'), substituted by $Ar^4$, where $Ar^4$ is a mono- or polycyclic, aromatic or heteroaromatic ring system with 5 to 60 aromatic ring atoms, which may be substituted by one or more radical R, where R can adopt the meanings indicated above.

$Ar^4$ here may either be linked directly, i.e. via a single bond, to $Ar^3$, or alternatively via a linking group X.

The compound of formula (I) thus preferably has the following formula (Ia').

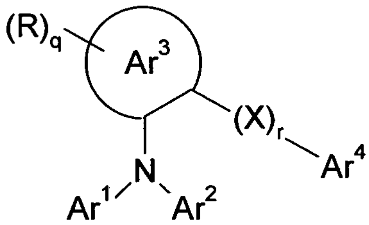

(Ia')

where $Ar^1$, $Ar^2$, $Ar^3$, $Ar^4$ and R can adopt the meanings indicated above,

q = 0, 1, 2, 3, 4, 5 or 6, preferably 0, 1, 2, 3 or 4,
X = $CR_2$, NR, $SiR_2$, O, S, C=O or P=O, preferably $CR_2$, NR, O or S, and
r = 0 or 1, preferably 0.

In another preferred embodiment of the present invention, the compound of formula (I') is characterised in that $Ar^3$ is substituted by $Ar^4$ in one of the two ortho positions, and $Ar^3$ is additionally linked to $Ar^4$ in the meta position that is adjacent to the substituted ortho position.

The compound of formula (I') thus preferably has the following formula (Ib'):

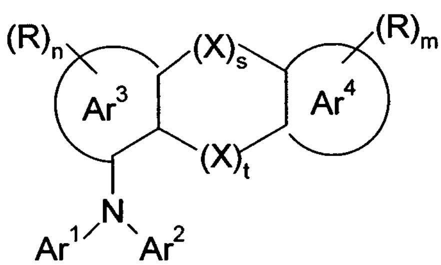

(Ib')

where $Ar^1$, $Ar^2$, $Ar^3$, $Ar^4$ and R can adopt the meanings indicated above,

m = 0, 1, 2, 3 or 4,
n = 0, 1, 2 or 3,
X = $CR_2$, NR, $SiR_2$, O, S, C=O or P=O, preferably $CR_2$, NR, O or S, and
s and t are each 0 or 1, where the sum (s + t) = 1 or 2, preferably 1.

In a first more preferred embodiment, the compound of formula (I') is selected from the following formulae (II'), (III') and (IV'):

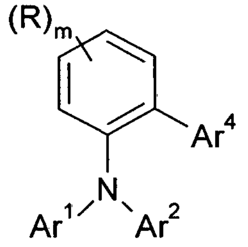

(II')

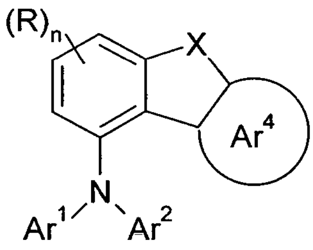

(III')

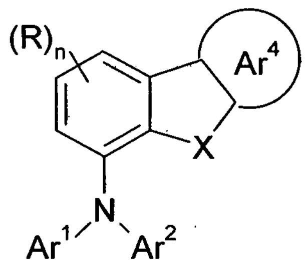

(IV')

where $Ar^1$, $Ar^2$, $Ar^4$ and R can adopt the meanings indicated above,

m = 0, 1, 2, 3 or 4,
n = 0, 1, 2 or 3, and
X = $CR_2$, NR, $SiR_2$, O, S, C=O or P=O, preferably $CR_2$, NR, O or S.

In a particularly preferred embodiment, the compound of formula (II') is selected from the following formula (V'):

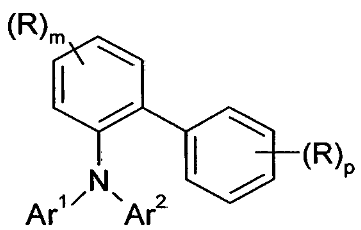

(V')

where $Ar^1$, $Ar^2$, R and m can adopt the meanings indicated above, and p = 0, 1, 2, 3, 4 or 5.

Examples of preferred compounds of formula (V') are depicted in the following table:

| | | |
|---|---|---|
| 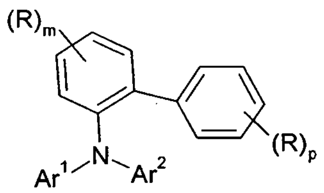 | 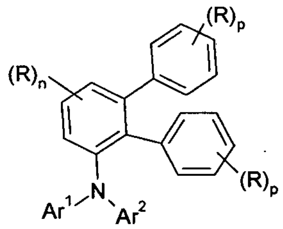 | 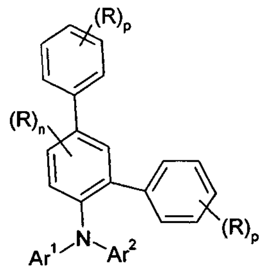 |
| (Va') | (Vb') | (Vc') |
| 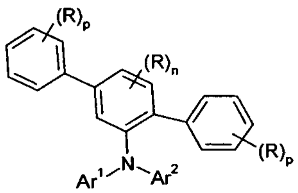 | 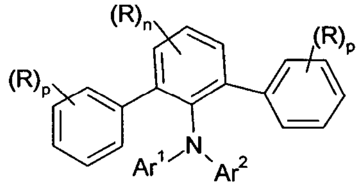 | 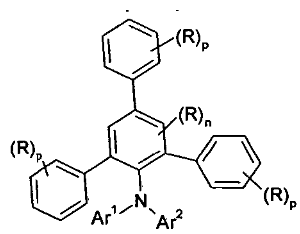 |
| (Vd') | (Ve') | (Vf') |
| 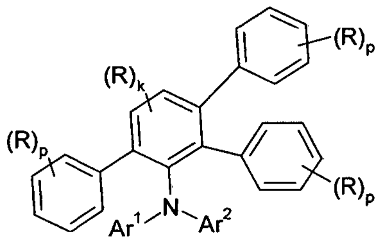 | 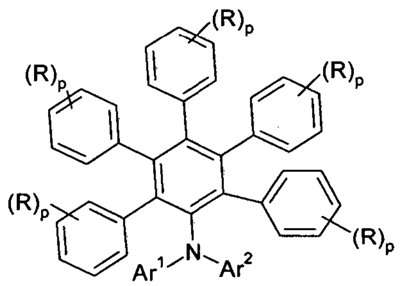 | |
| (Vg') | (Vh') | |

where $Ar^1$, $Ar^2$, R, m, n and p can adopt the meanings indicated above, and k = 0, 1 or 2.

In a further particularly preferred embodiment, the compound of formula (III') is selected from the following formula (VI'):

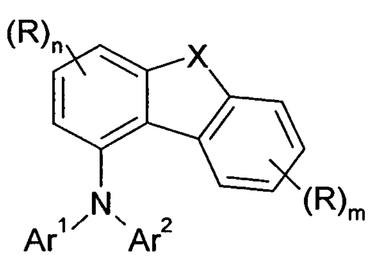

(VI')

where $Ar^1$, $Ar^2$, R, m and n can adopt the meanings indicated above.

Examples of preferred compounds of formula (VI') are depicted in the following table:

| | | |
|---|---|---|
| 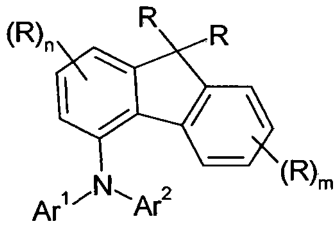 | 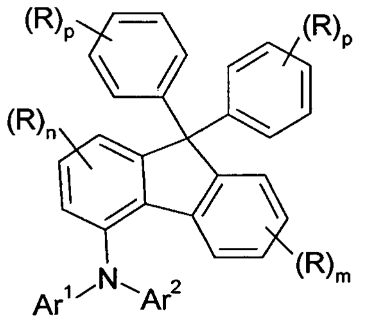 | 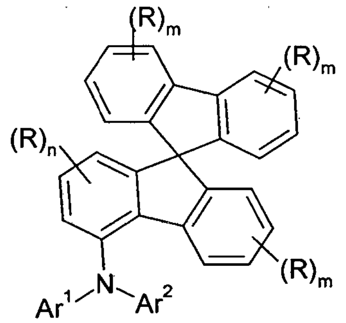 |
| (VIa') | (VIb') | (VIc') |
| 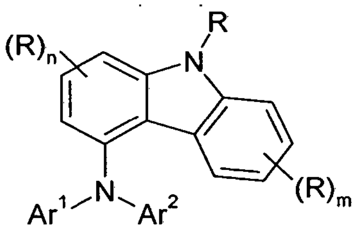 | 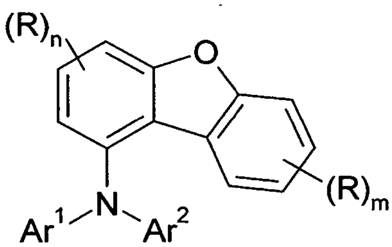 | 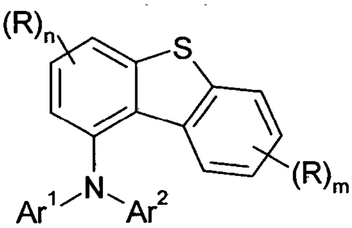 |
| (VId') | (VIe') | (VIf') |

where $Ar^1$, $Ar^2$, R, m, n and p can adopt the meanings indicated above.

In still a further particularly preferred embodiment, the compound of formula (IV') is selected from the following formula (VII'):

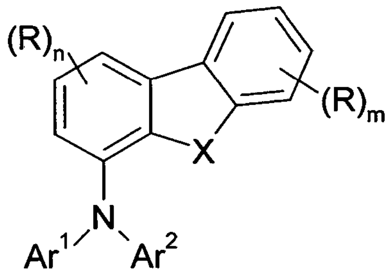

(VII´)

where $Ar^1$, $Ar^2$, R, m and n can adopt the meanings indicated above.

Examples of preferred compounds of formula (VII') are depicted in the following table:

| | | |
|---|---|---|
| 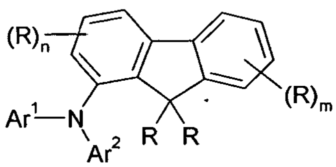 | 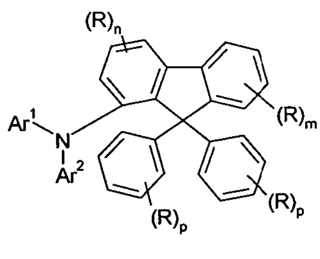 | 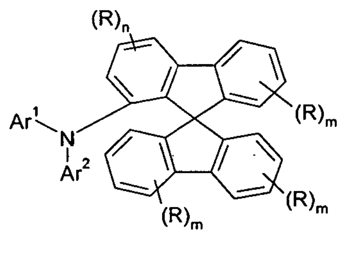 |
| (VIIa') | (VIIb') | (VIIc') |

(continued)

| | | |
|---|---|---|
| 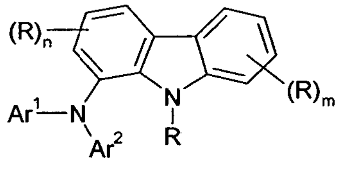 | 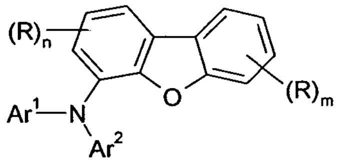 | 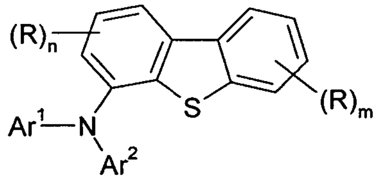 |
| (VIId') | (VIIe') | (VIIf') |

where $Ar^1$, $Ar^2$, R, m, n and p can adopt the meanings indicated above.

In a very particularly example, the compound of formula (V') is selected from the following formula (Vg'):

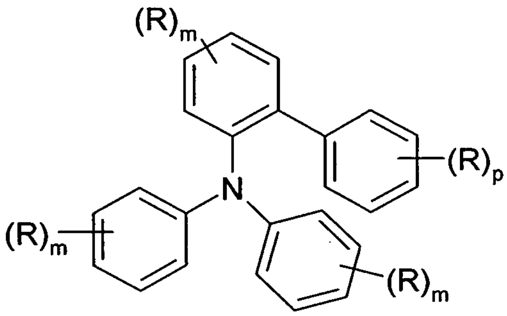

(Vg')

where R, m and p can adopt the meanings indicated above.

Examples of preferred compounds of formula (Vg') are depicted in the following table:

| | |
|---|---|
| 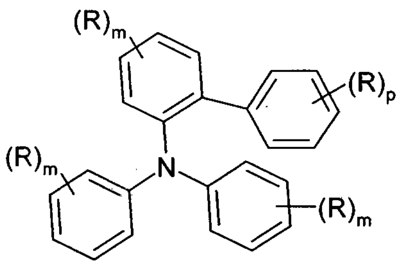 | 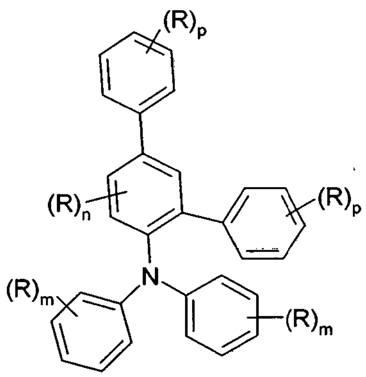 |
| (Vg)-1') | (Vg-2') |
| 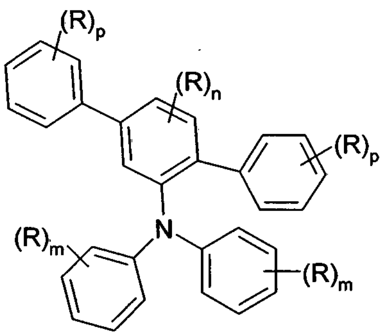 | 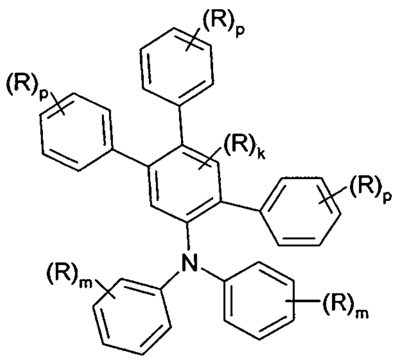 |
| (Vg-3') | (Vg-4') |

(continued)

| | |
|---|---|
| 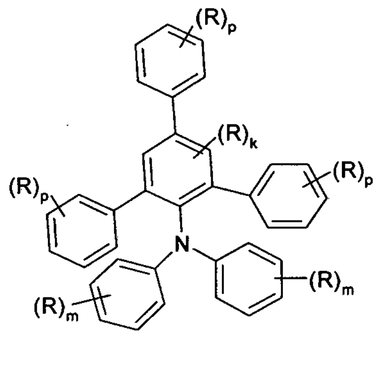 | 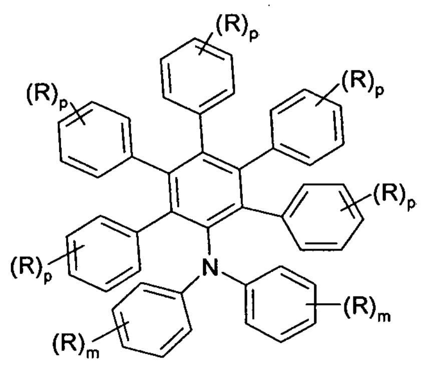 |
| (Vg-5') | (Vg-6') |
| 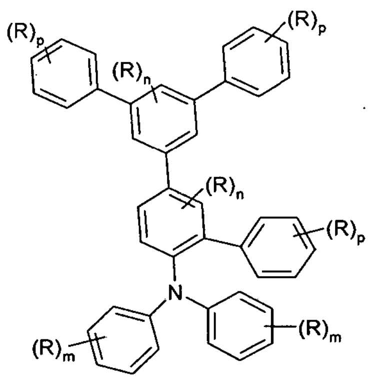 | 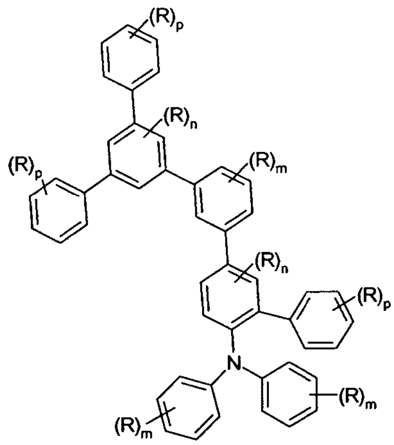 |
| (Vg-7') | (Vg-8') |

where R, k, m, n and p can adopt the meanings indicated above.

In a further very particularly preferred embodiment, the compound of formula (VI') is selected from the following formula (VIg'):

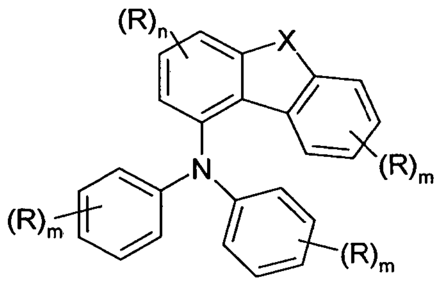

(VIg')

where R, X, m and n can adopt the meanings indicated above.

Examples of preferred compounds of formula (VIg') are depicted in the following table:

| | | |
|---|---|---|
| 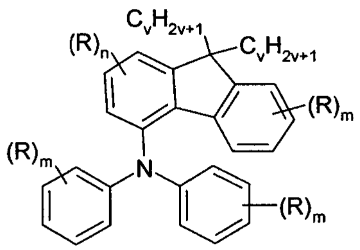 | 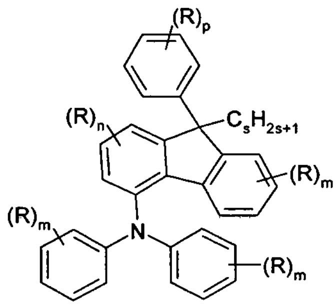 | |
| (VIg-1') | (VIg-2') | |
| 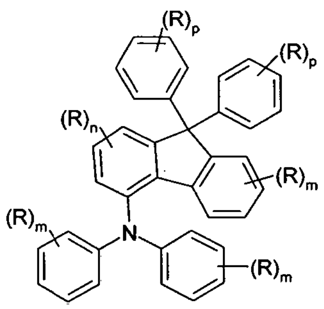 | 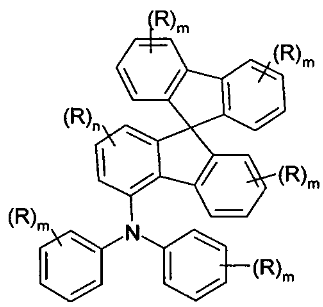 | |
| (VIg-3') | (VIg-4') | |
| 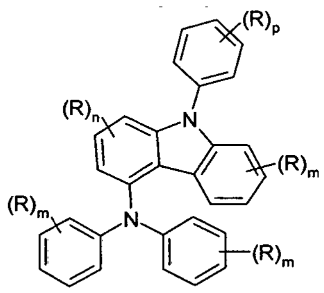 | 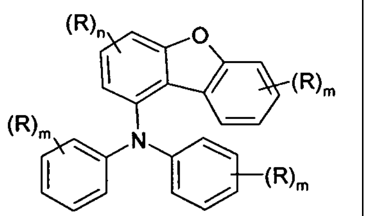 | 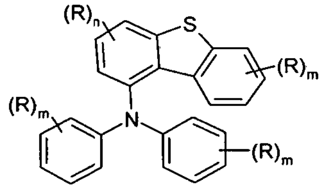 |
| (VIg-5') | (VIg-6') | (VIg-7') |

where R, m, n and p can adopt the meanings indicated above, and v = 1 to 20, preferably 1 to 10.

In still a further very particularly preferred embodiment, the compound of formula (VII') is selected from compounds of the following formula (VIIg'):

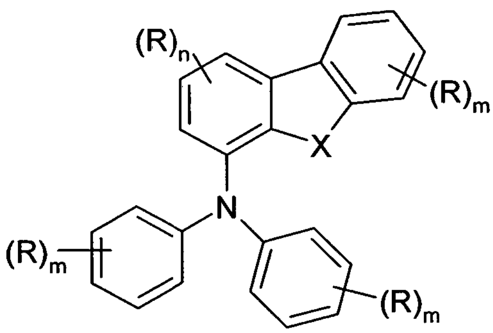

(VIIg')

where R, X, m and n can adopt the meanings indicated above.

Examples of preferred compounds of formula (VIIg') are depicted in the following table:

| | | |
|---|---|---|
| 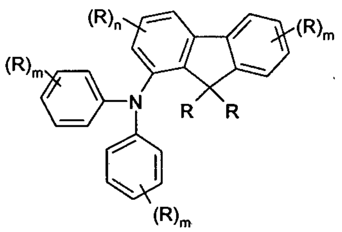 | 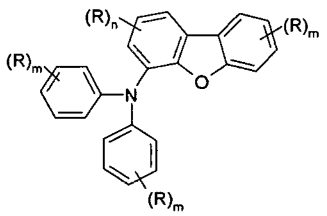 | 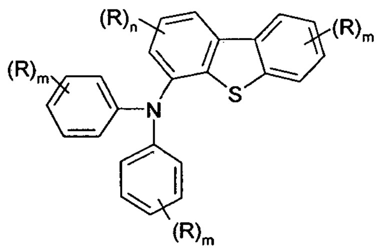 |
| (VIIg-1') | (VIIg-2') | (VIIg-3') |

where R, m and n can adopt the meanings indicated above.

The concentration of the at least one low molecular hole-transport or/and one hole-injection material according to the invention is preferably in the range of from 40 to 99 wt.%, more preferably 50 to 98 wt.%, and most preferably 85 to 97 wt.%, based on the total composition.

Advantageously, the weight ratio of the at least one hole-transport or/and one hole-injection material to the at least one metal complex in the composition according to the invention is from 1000:1 to 1:2, preferably from 400:1 to 1:1, more preferably from 100:1 to 3:2 and most preferably from 30:1 to 2:1. It is possible to use a higher or lower amount of metal complex, but the performance of the layer obtained from the composition according to the invention can decrease as a consequence.

Further object of the present invention is a formulation comprising at least one hole-transport or/and one hole-injection material, at least one metal complex of formula (MC-1) as a p-dopant and at least one solvent.

Besides the said components, the formulation according to the invention may comprise further additives and processing assistants. These include, inter alia, surface-active substances, surfactants, lubricants and greases, additives which increase the conductivity, dispersants, hydrophobicising agents, adhesion promoters, flow improvers, antifoams, deaerating agents, diluents, which may be reactive or unreactive, fillers, assistants, processing assistants, dyes, pigments, stabilisers, sensitisers, nanoparticles and inhibitors.

A composition in accordance with the present invention can be employed for the production of a layer or multilayered structure in which the organofunctional materials are present in layers, as required for the production of preferred electronic or opto-electronic components, such as OLEDs.

The composition of the present invention can preferably be employed for the formation of a functional layer comprising a hole-transport or/and one hole-injection material and a metal complex on a substrate or on one of the layers applied to the substrate.

Still further object of the invention is a process for the production of an electronic device, wherein at least one layer is obtained from the deposition of a composition according to the invention or from the application of a formulation according to the invention.

Still further object of the invention is a process for the production of an electronic device with a multilayer structure, wherein at least one layer is obtained from a composition of the present invention.

Another object of the invention is an electronic device obtainable by such a process for the production of an electronic device.

An electronic device is taken to mean a device which comprises an anode, a cathode and at least one functional layer in between.

In a preferred embodiment, the electronic device comprises at least one layer comprising a composition according to the invention, wherein the at leat one layer is a hole-transport layer.

In a further preferred embodiment, the electronic device comprises at least one layer comprising a composition according to the invention, wherein the at leat one layer is a hole-injection layer.

The electronic device is preferably an organic electroluminescent device (OLED), a polymeric electroluminescent device (PLED), an organic integrated circuit (O-IC), an organic field-effect transistor (O-FET), an organic thin-film transistor (O-TFT), an organic, light-emitting transistor (O-LET), an organic solar cell (O-SC), an organic, optical detector, an organic photoreceptor, an organic field-quench device (O-FQD), an organic electrical sensor, a light-emitting electrochemical cell (LEC) or an organic laser diode (O-laser). Preference is given to organic electroluminescent device (OLED).

The invention is explained in greater detail below with reference to working examples, but without being restricted thereby.

## Working Examples

### Part A: Metal complex

Following structures were used as dopants in compositions according to the invention.

| Metal complex | Structure | |
|---|---|---|
| D1 | 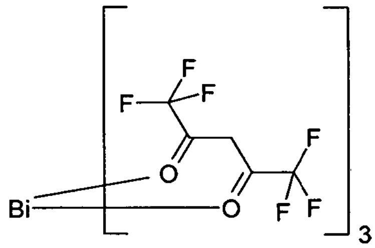 | CAS 141364-06-9 |
| D2 | 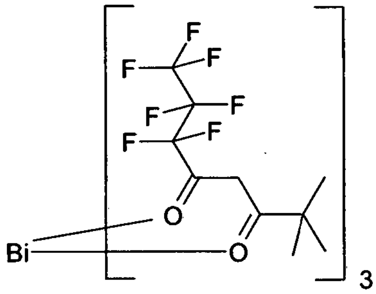 | CAS 141364-07-0 |
| D3 | 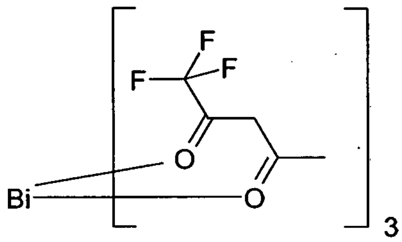 | CAS 157442-60-9 |

### Part B: Organic Semiconductor

The organic semiconductors (OS) used for the formation of the compositions according to the invention are already described in the prior art and are produced according to the literature instructions. They are represented in the table below:

| | Structure | Synthesis according to |
|---|---|---|
| OS1 | 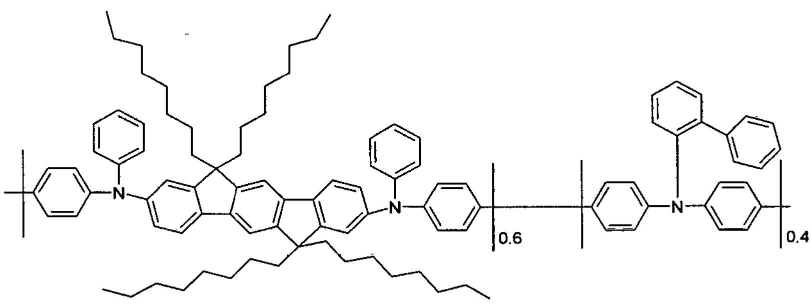 | WO2003/048225 |

(continued)

| | Structure | Synthesis according to |
|---|---|---|
| OS2 | 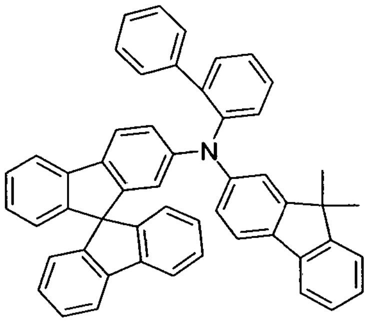 | WO2012034627 |

**Part C: Device examples**

The compositions of the present invention can be used in solution-based coating methods by preparing formulations comprising a solvent, an organic semiconductor and a metal complex according to the invention. The compositions of the present invention used in solution-based coating methods lead to OLEDs which are much easier to produce than OLEDs obtained from vacuum processes, and at the same time still exhibit good properties.

The production of solvent-based OLEDs has already been described in the literature, e.g. in WO 2004/037887 and in WO 2010/097155. The method is adapted to the conditions described below (layer thickness variation, materials).

The compositions according to the invention can be used in two different layer sequences:

Stack A is as follows:

- Substrate,
- ITO (50 nm),
- Hole injection layer (HIL) (100 nm),
- Cathode.

Stack B is as follows:

- Substrate,
- ITO (50 nm),
- HIL (20 nm),
- Hole transport layer (HTL) (40 nm)
- Emissive layer (EML) (30 nm)
- Electron transport layer (ETL) (20 nm),
- Cathode.

The substrate consists of glass platelets, which are coated with a structured 50 nm thick ITO (indium tin oxide) layer. The functional layers are then applied onto the coated substrate according to the structures of Stacks A and B.

For the preparation of the hole-injection layer, formulations according to the invention are prepared, which comprise one organic semiconductor, one metal complex and one solvent. The solvent consists in a mixture of Anisole: Xylene in the ratio 2:1. The typical solid content of such solutions is about 5-20 g/l, when film thicknesses of between 20 nm and 100 nm have to be achieved by means of spin coating. The layers were spin coated in an inert gas atmosphere, in this case argon, and heated for 60 minutes at 180 °C or 220 °C.

The hole-transport layer in Stack B is formed by thermal evaporation in a vacuum chamber. The materials used in this case are shown in Table C1.

Table C1:

| Structural formula of the hole-transport material (vacuum processed) | |
|---|---|
| 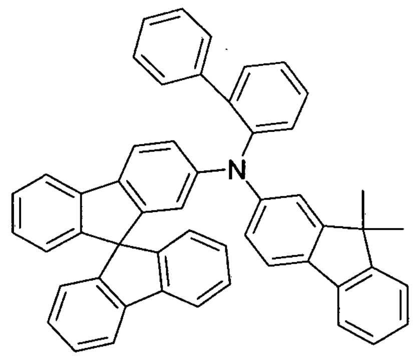 | |
| HT1 | |

The emissive layer in Stack B is formed by thermal evaporation in a vacuum chamber. In this case, the layer may consist of more than one material, which are deposited by means of co-evaporation in a given volume fraction. A reference such as MB1:SEB (95%:5%) in this case means that the materials MB1 and SEB are present in the layer in a volume fraction of 95%:5%.

The materials used in this case are shown in Table C2.

Table C2:

| Structural formulae of the materials used in the emissive layer | |
|---|---|
| 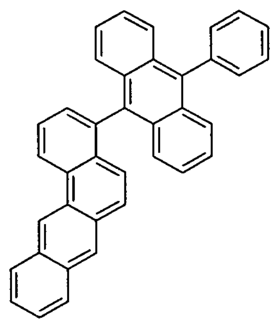 | 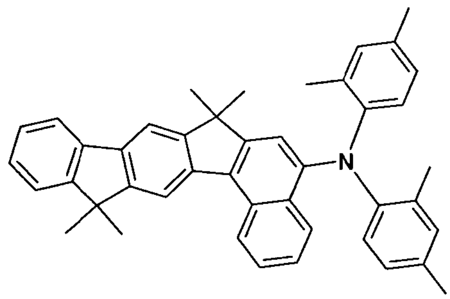 |
| MB1 | SEB |

The materials for the electron-transport layer are also thermally evaporated in a vacuum chamber and are shown in Table C3. The electron-transport layer consists of the two materials ETM1 and ETM2, which are deposited by means of co-evaporation in a volume fraction of 50%:50%.

Table C3:

| Structural formulae of the materials used in the hole-blocking and/or electron-transport layers | |
|---|---|
| 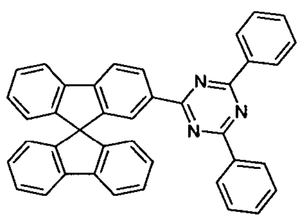 | 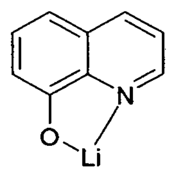 |
| ETM1 | ETM2 |

Furthermore, the cathode is formed by the deposition of a 100 nm thick aluminum layer by means of thermal

evaporation.

The exact structure of the OLEDs is shown in Table C4.

Table C4:

| Structure of the OLEDs | | | | | | | |
|---|---|---|---|---|---|---|---|
| Ex. | Stack | | | HIL | | HTL | EML |
| | | OS | metal complex (M) | weight-ratio (OS: M) | T [°C] | material | composition |
| C1 | B | OS1 | D1 | 85 : 15 | 180 | HT1 | MB1 95% SEB 5% |
| V1 | A | OS1 | - | - | 180 | - | - |
| C2 | A | OS1 | D1 | 70 : 30 | 180 | - | - |
| C3 | A | OS1 | D2 | 70 : 30 | 180 | - | - |
| C4 | A | OS1 | D3 | 70 : 30 | 180 | - | - |
| V2 | A | OS2 | - | - | 140 | - | - |
| C5 | A | OS2 | D1 | 70 : 30 | 140 | - | - |
| C6 | A | OS2 | D2 | 70 : 30 | 140 | - | - |
| C7 | A | OS2 | D3 | 70 : 30 | 140 | - | - |

The OLEDs are characterized by standard methods. For this purpose, the electroluminescence spectra, the current-voltage-luminance characteristics (IUL characteristics), assuming a Lambertian radiation pattern and in the case of Stack B, the operating lifetime are determined. Data like the operating voltage (in V) and the external quantum efficiency (in %) at a certain brightness are determined from the IUL characteristics. LD80@4000cd/$m^2$ corresponds to the lifetime until which the brightness of the OLED drops from an initial brightness of 4000 cd/$m^2$ to a brightness equal to 80% of the initial intensity, i.e. at 3600 cd/$m^2$.

The properties of the different OLEDs are summarized in Tables C5a and C5b. Examples V1 and V2 correspond to comparative examples, where the layers comprise no metal complex.

Table C5a shows results of hole-dominated components according to Stack A. In such components, the current is dominated by holes, which is why no recombination with electrons takes place that would lead to luminescence.

Table C5a:

| Ex. | Voltage at 1 mA/cm2 |
|---|---|
| | [V] |
| V1 | 5.5 |
| C2 | 1.5 |
| C3 | 1.3 |
| C4 | 1.6 |
| V2 | 6 |
| C5 | 1.6 |
| C6 | 1.2 |
| C7 | 1.4 |

The results in Table C5a show that the operating voltage of components obtained from compositions according to the invention is significantly lower than the operating voltage of components obtained from comparative compositions, which do not comprise a metal complex. Thus, the compositions according to the invention can be advantageously used for the preparation of hole-injection layers, which lead to a decrease of the operating voltage of the OLEDs.

Table C5b

| Ex. | Efficiency at 1000 cd/m2 | Voltage at 1000 cd/m2 | LD80 at 4000 cd/m2 |
|---|---|---|---|
| | % EQE | [V] | [h] |
| C1 | 7.8 | 5.2 | 245 |

Table C5b shows that the use of compositions according to the invention for the preparation of hole-injection layers leads to OLEDs with a good lifetime and efficiency.

## Claims

1. Composition comprising at least one hole-transport or/and one hole-injection material and at least one metal complex as a p-dopant, **characterized in that** the metal complex is a compound of formula (MC-1):

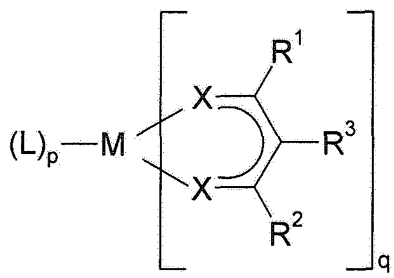

formula (MC-1)

where

M is selected from Ga, In, Ge, Sn, Pb, Sb, Bi, Se or Te;
X is O, $NR^0$ or S;
$R^0$ is selected from H, a straight-chain alkyl having 1 to 40 C atoms or a branched or cyclic alkylhaving 3 to 40 C atoms, each of which may be substituted by one or more radicals $R^4$, where one or more non-adjacent $CH_2$ groups may be replaced by $R^4C=CR^4$, C≡C, $Si(R^4)2$, C=O, C=S, $C=NR^4$, $P(=O)(R^4)$, SO, $SO_2$, $NR^4$, O, S or $CONR^4$ and where one or more H atoms may be replaced by D, F, Cl, Br, I or CN, or a mono- or polycyclic, aromatic or heteroaromatic ring system having 5 to 60 aromatic ring atoms, which may in each case be substituted by one or more radicals $R^4$;
L is a neutral ligand;
$R^1$, $R^2$ are on each occurrence, identically or differently, F, Cl, Br, I, CN, $NO_2$, a straight-chain alkyl group having 2 to 40 C atoms, a branched or cyclic alkyl group having 3 to 40 C atoms, a straight-chain fluoroalkyl group having 1 to 40 C atoms, or a branched or cyclic fluoroalkyl group having 3 to 40 C atoms, each of which may be substituted by one or more radicals $R^4$, where one or more non-adjacent $CH_2$ groups may be replaced by $R^4C=CR^4$, C≡C, $Si(R^4)2$, C=O, C=S, $C=NR^4$, $P(=O)(R^4)$, SO, $SO_2$, $NR^4$, O, S or $CONR^4$ and where one or more H atoms may be replaced by D, Cl, Br, I or CN, or a mono- or polycyclic, aromatic or heteroaromatic ring system having 5 to 60 aromatic ring atoms, which may in each case be substituted by one or more radicals $R^4$, where the radicals $R^1$ and $R^3$ or the radicals $R^2$ and $R^3$ may form a mono- or polycyclic, aliphatic, aromatic and/or benzo-fused ring system with one another;
$R^3$ is selected from the group consisting of H, D, a straight-chain alkyl group having 1 to 40 C atoms or a branched or cyclic alkyl having 3 to 40 C atoms, each of which may be substituted by one or more radicals $R^4$, where one or more non-adjacent $CH_2$ groups may be replaced by $R^4C=CR^4$, C=C, $Si(R^4)2$, C=O, C=S, $C=NR^4$, $P(=O)(R^4)$, SO, $SO_2$, $NR^4$, O, S or $CONR^4$ and where one or more H atoms may be replaced by D, F, Cl, Br, I or CN, or a mono- or polycyclic, aromatic or heteroaromatic ring system having 5 to 60 aromatic ring atoms, which may in each case be substituted by one or more radicals $R^4$;
$R^4$ is on each occurrence, identically or differently, H, D, F or an aliphatic, aromatic or heteroaromatic organic radical having 1 to 20 C atoms, in which, in addition, one or more H atoms may be replaced by D or F; two or

more substituents $R^5$ here may be linked -to one another and may form a ring;

p is 0, 1 or 2;

q is a number equal to 1, 2, 3 or 4, which correspond to the oxidation number of M; and the at least one hole-transport or/and one hole-injection material is a polymer comprising at least one structural unit of the following formula (I) or a compound of formula (I'):

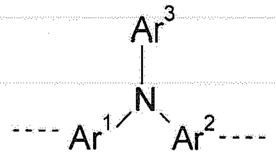 (I) 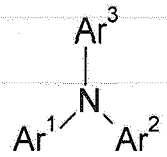 (I')

where

$Ar^1$ to $Ar^3$ is on each occurrence, in each case identically or differently, a mono- or polycyclic, aromatic or heteroaromatic ring system having 5 to 60 aromatic ring atoms, which may be substituted by one or more radicals $R^5$;

$R^5$ is on each occurrence, identically or differently, H, D, F, Cl, Br, I, $N(R^6)_2$, CN, $NO_2$, $Si(R^6)_3$, $B(OR^6)_2$, $C(=O)R^6$, $P(=O)(R^6)_2$, $S(=O)R^6$, $S(=O)_2R^6$, $OSO_2R^6$, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^6$, where one or more non-adjacent $CH_2$ groups may be replaced by $R^6C=CR^6$, C=C, $Si(R^6)_2$, C=O, C=S, $C=NR^6$, $P(=O)(R^6)$, SO, $SO_2$, $NR^6$, O, S or $CONR^6$ and where one or more H atoms may be replaced by D, F, Cl, Br, I or CN, or a mono- or polycyclic, aromatic or heteroaromatic ring system having 5 to 60 aromatic ring atoms, which may in each case be substituted by one or more radicals $R^6$, or an aryloxy or hetero-aryloxy group having 5 to 60 aromatic ring atoms, which may be substituted by one or more radicals $R^6$, or an aralkyl or heteroaralkyl group having 5 to 60 aromatic ring atoms, which may be substituted by one or more radicals $R^6$, or a diarylamino group, diheteroarylamino group or arylheteroarylamino group having 10 to 40 aromatic ring atoms, which may be substituted by one or more radicals $R^6$, where two or more radicals $R^5$ may also form a mono- or polycyclic, aliphatic, aromatic and/or benzo-fused ring system with one another;

$R^6$ is on each occurrence, identically or differently, H, D, F or an aliphatic hydrocarbon radical having 1 to 20 C atoms, an aromatic and/or a heteroaromatic hydrocarbon radical having 5 to 20 C atoms, in which, in addition, one or more H atoms may be replaced by F; where two or more substituents $R^6$ may also form a mono- or polycyclic, aliphatic or aromatic ring system with one another; and

the dashed lines in formula (I) represent bonds to adjacent structural units in the polymer, and where at least one of $Ar^1$, $Ar^2$ and/or $Ar^3$ is substituted by a radical $R^5$ comprising at least 2 C atoms.

**2.** Composition according to claim 1, wherein M is selected from Sn, Bi and Te, more preferably Bi.

**3.** Composition according to claim 1, wherein the neutral ligand L is selected from bipyridine, phenanthroline, phosphine oxide, phosphonimido ligands and sulfoxide, each of which may be substituted by one or more radicals $R^4$ as defined in claim 1.

**4.** Composition according to one or more of the preceding claims, wherein at least one of the radicals $R^1$ and $R^2$ is selected from the group consisting of F, CN, $NO_2$, a straight-chain fluoroalkyl group having 1 to 40 C atoms or a branched or cyclic fluoroalkyl group having 3 to 40 C atoms, each of which may be substituted by one or more radicals $R^4$, or an aryl or heteroaryl group having 5 to 30 aromatic ring atoms, which may in each case be substituted by one or more radicals $R^4$.

**5.** Composition according to one or more of the preceding claims, wherein at least one of the radicals $R^1$ and $R^2$ is selected from the group consisting of F, CN, $NO_2$, a straight-chain perfluoroalkyl group having 1 to 14 C atoms or a branched or cyclic perfluoroalkyl group having 3 to 14 C atoms, or an aryl or heteroaryl group having 5 to 14 aromatic ring atoms, which may in each case be substituted by one or more radicals $R^4$.

**6.** Composition according to one or more of the preceding claims, wherein $R^3$ is selected from the group consisting of H, D, a straight-chain alkyl group having 1 to 4 C atoms or a branched or cyclic alkyl having 3 to 4 C atoms, each of which may be substituted by one or more radicals $R^4$, or an aryl or heteroaryl group having 5 to 14 aromatic ring atoms, which may in each case be substituted by one or more radicals $R^4$.

**7.** Composition according to one or more of the preceding claims, wherein the at least one hole-transport or/and one hole-injection material is a polymer of formula (I) comprising at least one structural unit of one the following formula (II), (III) or (IV):

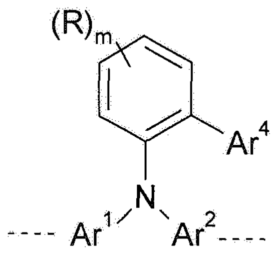
(II)

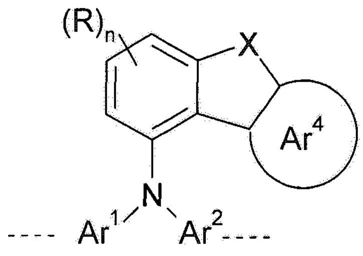
(III)

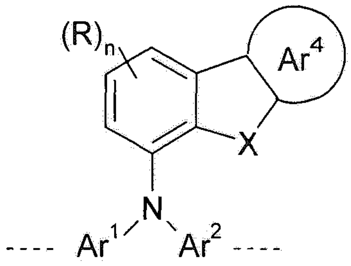
(IV)

or the at least one hole-transport or/and one hole-injection material is a compound of formula (I') selected from the following formula (II'), (III') or (IV'):

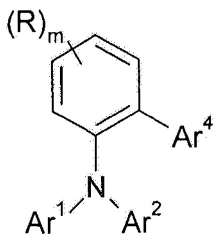
(II′)

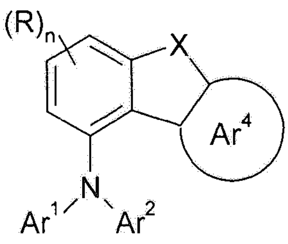
(III′)

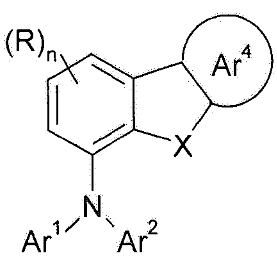
(IV′)

where $Ar^1$, $Ar^2$ can adopt the meaning indicated in claim 1,
$Ar^4$ is a mono- or polycyclic, aromatic or heteroaromatic ring system having 5 to 60 aromatic ring atoms, which may be substituted by one or more radicals R,
R is on each occurrence, identically or differently, H, D, F, Cl, Br, I, $N(R^1)_2$, CN, $NO_2$, $Si(R^1)_3$, $B(OR^1)_2$, $C(=O)R^1$, $P(=O)(R^1)_2$, $S(=O)R^1$, $S(=O)_2R^1$, $OSO_2R^1$, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^1$, where one or more non-adjacent $CH_2$ groups may be replaced by $R^1C=CR^1$, C=C, $Si(R^1)_2$, C=O, C=S, $C=NR^1$, $P(=O)(R^1)$, SO, $SO_2$, $NR^1$, O, S or $CONR^1$ and where one or more H atoms may be replaced by D, F, Cl, Br, I or CN, or a mono- or polycyclic, aromatic or heteroaromatic ring system having 5 to 60 aromatic ring atoms, which may in each case be substituted by one or more radicals $R^1$, or an aryloxy or heteroaryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$, or a diarylamino group, diheteroarylamino group or arylheteroarylamino group having 10 to 40 aromatic ring atoms, which may be substituted by one or more radicals $R^1$, or a crosslinkable group Q, where two or more radicals R may also form a mono- or polycyclic, aliphatic, aromatic and/or benzo-fused ring system with one another and $R^1$ can adopt the meaning indicated in claim 1,

m = 0, 1, 2, 3 or 4,
n = 0, 1, 2 or 3, and
X = $CR_2$, NR, $SiR_2$, O, S, C=O or P=O, preferably $CR_2$, NR, O or S.

**8.** Use of a metal complex of formula (MC-1) as defined in claim 1 as p dopant in an electronic device, preferably in an organic electroluminescent device, an organic field-effect transistor, an organic integrated circuit, an organic thin-film transistors, an organic light-emitting transistor, an organic solar cell, an organic optical detector, an organic photoreceptors, an organic field-quench device, a light-emitting electrochemical cell or an organic laser diode.

**9.** Formulation comprising at least one hole-transport or/and one hole-injection material of formula (I) or (I') as defined

in claim 1, at least one metal complex of formula (MC-1) as defined in claim 1 as a p-dopant and at least one solvent.

**10.** Process for the production of an electronic device, wherein at least one layer is obtained from the deposition of a composition according to one of the preceding claims 1 to 7 or from the application of a formulation according to claim 9.

**11.** Electronic device comprising a multilayer structure, wherein at least one layer comprises a composition as defined in one of the preceding claims 1 to 7.

**12.** Electronic device according to claim 11, wherein the electronic device is selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells, organic laser diodes and preferably organic light-emitting diodes.

**Patentansprüche**

**1.** Zusammensetzung, umfassend mindestens ein Lochtransport- oder/und ein Lochinjektionsmaterial und mindestens einen Metallkomplex als p-Dotand, **dadurch gekennzeichnet, dass** es sich bei dem Metallkomplex um eine Verbindung der Formel (MC-1) handelt:

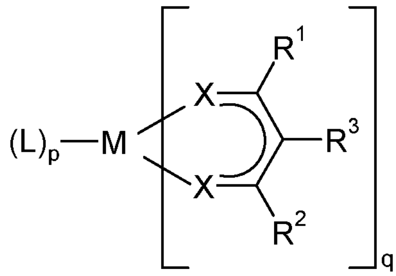

Formel (MC-1)

wobei

M aus Ga, In, Ge, Sn, Pb, Sb, Bi, Se oder Te ausgewählt ist;
X für O, $NR^0$ oder S steht;
$R^0$ aus H, einem geradkettigen Alkyl mit 1 bis 40 C-Atomen oder einem verzweigten oder cyclischen Alkyl mit 3 bis 40 C-Atomen, wobei jede dieser Gruppen durch einen oder mehrere Reste $R^4$ substituiert sein kann, wobei eine oder mehrere nicht benachbarte $CH_2$-Gruppen durch $R^4C=CR^4$, C=C, $Si(R^4)_2$, C=O, C=S, $C=NR^4$, $P(=O)(R^4)$, SO, $SO_2$, $NR^4$, O, S oder $CONR^4$ ersetzt sein können und wobei ein oder L mehrere H-Atome durch D, F, Cl, Br, I oder CN ersetzt sein können, oder einem mono- oder polycyclischen, aromatischen oder heteroaromatischen Ringsystem mit 5 bis 60 aromatischen Ringatomen, das jeweils durch einen oder mehrere Reste $R^4$ substituiert sein kann, ausgewählt ist; für einen neutralen Liganden steht;
$R^1$, $R^2$ bei jedem Auftreten gleich oder verschieden für F, Cl, Br, I, CN, $NO_2$, eine geradkettige Alkylgruppe mit 2 bis 40 C-Atomen, eine verzweigte oder cyclische Alkylgruppe mit 3 bis 40 C-Atomen, eine geradkettige Fluoralkylgruppe mit 1 bis 40 C-Atomen oder eine verzweigte oder cyclische Fluoralkylgruppe mit 3 bis 40 C-Atomen, wobei jede dieser Gruppen durch einen oder mehrere Reste $R^4$ substituiert sein kann, wobei eine oder mehrere nicht benachbarte $CH_2$-Gruppen durch $R^4C=CR^4$, C=C, $Si(R^4)2$, C=O, C=S, $C=NR^4$, P(=O) $(R^4)$, SO, $SO_2$, $NR^4$, O, S oder $CONR^4$ ersetzt sein können und wobei ein oder mehrere H-Atome durch D, Cl, Br, I oder CN ersetzt sein können, oder ein mono- oder polycyclisches, aromatisches oder heteroaromatisches Ringsystem mit 5 bis 60 aromatischen Ringatomen, das jeweils durch einen oder mehrere Reste $R^4$ substituiert sein kann, steht, wobei die Reste $R^1$ und $R^3$ oder die Reste $R^2$ und $R^3$ miteinander ein mono- oder polycyclisches, aliphatisches, aromatisches und/oder benzoanneliertes Ringsystem bilden können;
$R^3$ aus der Gruppe bestehend aus H, D, einer geradkettigen Alkylgruppe mit 1 bis 40 C-Atomen oder einem verzweigten oder cyclischen Alkyl mit 3 bis 40 C-Atomen, wobei jede dieser Gruppen durch einen oder mehrere Reste $R^4$ substituiert sein kann, wobei eine oder mehrere nicht benachbarte $CH_2$-Gruppen durch $R^4C=CR^4$,

C=C, $Si(R^4)_2$, C=O, C=S, $C=NR^4$, $P(=O)(R^4)$, SO, $SO_2$, $NR^4$, O, S oder $CONR^4$ ersetzt sein können und wobei ein oder mehrere H-Atome durch D, F, Cl, Br, I oder CN ersetzt sein können, oder einem mono- oder polycyclischen, aromatischen oder heteroaromatischen Ringsystem mit 5 bis 60 aromatischen Ringatomen, das jeweils durch einen oder mehrere Reste $R^4$ substituiert sein kann, ausgewählt ist;
$R^4$ bei jedem Auftreten gleich oder verschieden für H, D, F oder einen aliphatischen, aromatischen oder heteroaromatischen organischen Rest mit 1 bis 20 C-Atomen steht, in dem zusätzlich ein oder mehrere H-Atome durch D oder F ersetzt sein können; zwei oder mehr Substituenten $R^5$ hier miteinander verknüpft sein können und einen Ring bilden können;
p für 0, 1 oder 2 steht;
q für eine Zahl mit einem Wert von 1, 2, 3 oder 4 steht, die der Oxidationszahl von M entspricht; und

es sich bei dem mindestens einen Lochtransportoder/und einen Lochinjektionsmaterial um ein Polymer, das mindestens eine Struktureinheit der folgenden Formel (I) umfasst, oder eine Verbindung der Formel (I') handelt:

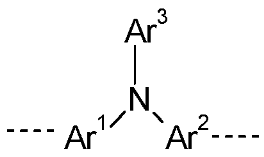
(I)

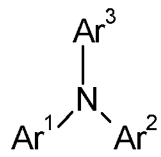
(I´)

wobei
$Ar^1$ bis $Ar^3$ bei jedem Auftreten jeweils gleich oder verschieden für ein mono- oder polycyclisches, aromatisches oder heteroaromatisches Ringsystem mit 5 bis 60 aromatischen Ringatomen, das durch einen oder mehrere Reste $R^5$ substituiert sein kann, stehen;
$R^5$ bei jedem Auftreten gleich oder verschieden für H, D, F, Cl, Br, I, $N(R^6)_2$, CN, $NO_2$, $Si(R^6)_3$, $B(OR^6)_2$, $C(=O)R^6$, $P(=O)(R^6)_2$, $S(=O)R^6$, $S(=O)_2R^6$, $OSO_2R^6$, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, wobei jede dieser Gruppen durch einen oder mehrere Reste $R^6$ substituiert sein kann, wobei eine oder mehrere nicht benachbarte $CH_2$-Gruppen durch $R^6C=CR^6$, C=C, $Si(R^6)_2$, C=O, C=S, $C=NR^6$, $P(=O)(R^6)$, SO, $SO_2$, $NR^6$, O, S oder $CONR^6$ ersetzt sein können und wobei ein oder mehrere H-Atome durch D, F, Cl, Br, I oder CN ersetzt sein können, oder ein mono- oder polycyclisches, aromatisches oder heteroaromatisches Ringsystem mit 5 bis 60 aromatischen Ringatomen, das jeweils durch einen oder mehrere Reste $R^6$ substituiert sein kann, oder eine Aryloxy- oder Heteroaryloxygruppe mit 5 bis 60 aromatischen Ringatomen, die durch einen oder mehrere Reste $R^6$ substituiert sein kann, oder eine Aralkyl- oder Heteroaralkylgruppe mit 5 bis 60 aromatischen Ringatomen, die jeweils durch einen oder mehrere Reste $R^6$ substituiert sein kann, oder eine Diarylaminogruppe, Diheteroarylaminogruppe oder Arylheteroarylaminogruppe mit 10 bis 40 aromatischen Ringatomen, die durch einen oder mehrere Reste $R^6$ substituiert sein kann, steht, wobei zwei oder mehr Reste $R^5$ auch miteinander ein mono- oder polycyclisches, aliphatisches, aromatisches und/oder benzoanelliertes Ringsystem bilden können;
$R^6$ bei jedem Auftreten gleich oder verschieden für H, D, F oder einen aliphatischen Kohlenwasserstoffrest mit 1 bis 20 C-Atomen, einen aromatischen und/oder einen heteroaromatischen Kohlenwasserstoffrest mit 5 bis 20 C-Atomen, in dem außerdem ein oder mehrere H-Atome durch F ersetzt sein können, steht; wobei zwei oder mehr Substituenten $R^6$ auch miteinander ein mono- oder polycyclisches, aliphatisches oder aromatisches Ringsystem bilden können; und
die gestrichelten Linien in Formel (I) Bindungen an die benachbarten Struktureinheiten in dem Polymer darstellen, und wobei mindestens eines von $Ar^1$, $Ar^2$ und/oder $Ar^3$ durch einen Rest $R^5$ mit mindestens 2 C-Atomen substituiert ist.

2. Zusammensetzung nach Anspruch 1, wobei M aus Sn, Bi und Te, weiter bevorzugt Bi, ausgewählt ist.

3. Zusammensetzung nach Anspruch 1, wobei der neutrale Ligand L aus Bipyridin, Phenanthrolin, Phosphinoxid, Phosphonimido-Liganden und Sulfoxid, die jeweils durch einen oder mehrere Reste $R^4$ gemäß Anspruch 1 substituiert sein können, ausgewählt ist.

4. Zusammensetzung nach einem oder mehreren der vorhergehenden Ansprüche, wobei mindestens einer der Reste $R^1$ und $R^2$ aus der Gruppe bestehend aus F, CN, $NO_2$, einer geradkettigen Fluoralkylgruppe mit 1 bis 40 C-Atomen oder einer verzweigten oder cyclischen Fluoralkylgruppe mit 3 bis 40 C-Atomen, wobei jede dieser Gruppen durch einen oder mehrere Reste $R^4$ substituiert sein kann, oder einer Aryloder Heteroarylgruppe mit 5 bis 30 aromatischen Ringatomen, die jeweils durch einen oder mehrere Reste $R^4$ substituiert sein kann, ausgewählt ist.

5. Zusammensetzung nach einem oder mehreren der vorhergehenden Ansprüche, wobei mindestens einer der Reste $R^1$ und $R^2$ aus der Gruppe bestehend aus F, CN, $NO_2$, einer geradkettigen Perfluoralkylgruppe mit 1 bis 14 C-Atomen oder einer verzweigten oder cyclischen Perfluoralkylgruppe mit 3 bis 14 C-Atomen oder einer Aryl- oder Heteroarylgruppe mit 5 bis 14 aromatischen Ringatomen, die jeweils durch einen oder mehrere Reste $R^4$ substituiert sein kann, ausgewählt ist.

6. Zusammensetzung nach einem oder mehreren der vorhergehenden Ansprüche, wobei $R^3$ aus der Gruppe bestehend aus H, D, einer geradkettigen Alkylgruppe mit 1 bis 4 C-Atomen oder einem verzweigten oder cyclischen Alkyl mit 3 bis 4 C-Atomen, wobei jede dieser Gruppen durch einen oder mehrere Reste $R^4$ substituiert sein kann, oder einer Aryl- oder Heteroarylgruppe mit 5 bis 14 aromatischen Ringatomen, die jeweils durch einen oder mehrere Reste $R^4$ substituiert sein kann, ausgewählt ist.

7. Zusammensetzung nach einem oder mehreren der vorhergehenden Ansprüche, wobei es sich bei dem mindestens einen Lochtransport- oder/und einen Lochinjektionsmaterial um ein Polymer der Formel (I) handelt, das mindestens eine Struktureinheit einer der folgenden Formeln (II), (III) oder (IV) umfasst:

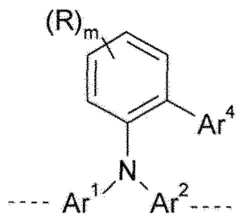
(II)

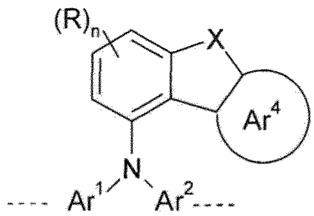
(III)

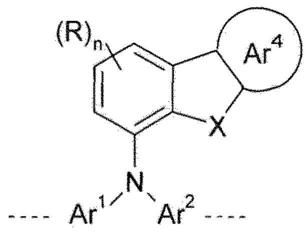
(IV)

oder es sich bei dem mindestens einen Lochtransportoder/und einen Lochinjektionsmaterial um eine Verbindung der Formel (I') handelt, die aus den folgenden Formeln (II'), (III') oder (IV') ausgewählt ist:

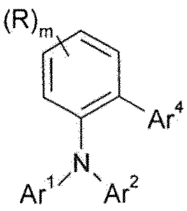
(II')

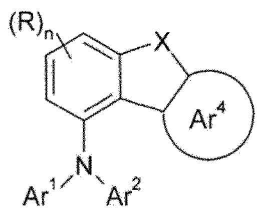
(III')

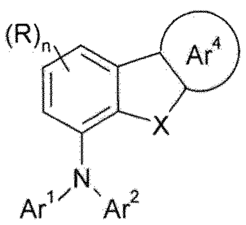
(IV')

wobei $Ar^1$ und $Ar^2$ die in Anspruch 1 angegebene Bedeutung annehmen können,
$Ar^4$ für ein mono- oder polycyclisches, aromatisches oder heteroaromatisches Ringsystem mit 5 bis 60 aromatischen Ringatomen, das durch einen oder mehrere Reste R substituiert ist, steht,
R bei jedem Auftreten gleich oder verschieden für H, D, F, Cl, Br, I, $N(R^1)_2$, CN, $NO_2$, $Si(R^1)_3$, $B(OR^1)_2$, $C(=O)R^1$, $P(=O)(R^1)_2$, $S(=O)R^1$, $S(=O)_2R^1$, $OSO_2R^1$, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, wobei jede dieser Gruppen durch einen oder mehrere Reste $R^1$ substituiert sein kann, wobei eine oder mehrere nicht benachbarte $CH_2$-Gruppen durch $R^1C=CR^1$, C=C, $Si(R^1)_2$, C=O, C=S, $C=NR^1$, P(=O) $(R^1)$, SO, $SO_2$, $NR^1$, O, S oder $CONR^1$ ersetzt sein können und wobei ein oder mehrere H-Atome durch D, F, Cl, Br, I oder CN ersetzt sein können, oder ein mono- oder polycyclisches, aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 60 aromatischen Ringatomen, die durch einen oder mehrere Reste $R^1$ substituiert sein kann, oder eine Aralkyl- oder Heteroaralkylgruppe mit 5 bis 60 aromatischen Ringatomen, die jeweils durch einen oder mehrere Reste $R^1$ substituiert sein kann, oder eine Diarylaminogruppe, Diheteroarylaminogruppe oder Arylheteroarylaminogruppe mit 10 bis 40 aromatischen Ringatomen, die durch einen oder mehrere Reste $R^1$ substituiert sein kann, oder eine vernetzbare Gruppe Q steht, wobei zwei oder mehr Reste R auch miteinander ein mono- oder polycyclisches, aliphatisches, aromatisches und/oder benzoanelliertes Ringsystem bilden können und $R^1$ die in Anspruch 1 angegebene Bedeutung annehmen kann,

m = 0, 1, 2, 3 oder 4,
n = 0, 1, 2 oder 3 und
X = $CR_2$, NR, $SiR_2$, O, S, C=O oder P=O, vorzugsweise $CR_2$, NR, O oder S.

**8.** Verwendung eines Metallkomplexes der Formel (MC-1) gemäß Anspruch 1 als p-Dotand in einer elektronischen Vorrichtung, vorzugsweise in einer organischen Elektrolumineszenzvorrichtung, einem organischen Feldeffekttransistor, einer organischen integrierten Schaltung, einem organischen Dünnfilmtransistor, einem organischen lichtemittierenden Transistor, einer organischen Solarzelle, einem organischen optischen Detektor, einem organischen Photorezeptor, einer organischen Feld-Quench-Vorrichtung, einer lichtemittierenden elektrochemischen Zelle oder einer organischen Laserdiode.

**9.** Formulierung, umfassend mindestens ein Lochtransport- oder/und ein Lochinjektionsmaterial der Formel (I) oder (I') gemäß Anspruch 1, mindestens einen Metallkomplex der Formel (MC-1) gemäß Anspruch 1 als p-Dotand und mindestens ein Lösungsmittel.

**10.** Verfahren zur Herstellung einer elektronischen Vorrichtung, wobei mindestens eine Schicht durch Abscheiden einer Zusammensetzung nach einem der vorhergehenden Ansprüche 1 bis 7 oder durch Aufbringen einer Zusammensetzung nach Anspruch 9 erhalten wird.

**11.** Elektronische Vorrichtung mit Mehrschichtstruktur, wobei mindestens eine Schicht eine Zusammensetzung gemäß einem der vorhergehenden Ansprüche 1 bis 7 umfasst.

**12.** Elektronische Vorrichtung nach Anspruch 11, wobei die elektronische Vorrichtung aus organischen Elektrolumineszenzvorrichtungen, organischen integrierten Schaltungen, organischen Feldeffekttransistoren, organischen Dünnfilmtransistoren, organischen lichtemittierenden Transistoren, organischen Solarzellen, organischen optischen Detektoren, organischen Photorezeptoren, organischen Feld-Quench-Vorrichtungen, lichtemittierenden elektrochemischen Zellen, organischen Laserdioden und vorzugsweise organischen Leuchtdioden ausgewählt ist.

## Revendications

**1.** Composition comprenant au moins un matériau de transport de trous et/ou un matériau d'injection de trous et au moins un complexe métallique en tant que dopant p, **caractérisée en ce que** le complexe métallique est un composé de formule (MC-1) :

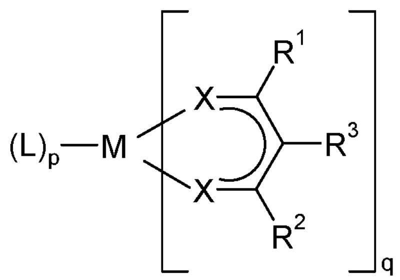

formule (MC-1)

dans laquelle
M est choisi parmi Ga, In, Ge, Sn, Pb, Sb, Bi, Se et Te ;
X est O, $NR^0$ ou S ;
$R^0$ est choisi parmi H, un alkyle à chaîne droite possédant 1 à 40 atomes de C ou un alkyle ramifié ou cyclique possédant 3 à 40 atomes de C, chacun desquels pouvant être substitué par un ou plusieurs radicaux $R^4$, dans lesquels un ou plusieurs groupes $CH_2$ non adjacents peuvent être remplacés par $R^4C=CR^4$, C=C, $Si(R^4)2$, C=O, C=S, $C=NR^4$, P(=O) ($R^4$), SO, $SO_2$, $NR^4$, O, S ou $CONR^4$ et dans lesquels un ou plusieurs atomes de H peuvent être remplacés par D, F, Cl, Br, I ou CN, ou un système cyclique monocyclique ou polycyclique, aromatique ou hétéroaromatique possédant 5 à 60 atomes de cycle aromatique, qui peut en chaque cas être substitué par un ou plusieurs radicaux $R^4$ ;
L est un ligand neutre ;

$R^1$, $R^2$ sont en chaque occurrence, de manière identique ou différente, F, Cl, Br, I, CN, $NO_2$, un groupe alkyle à chaîne droite possédant 2 à 40 atomes de C, un groupe alkyle ramifié ou cyclique possédant 3 à 40 atomes de C, un groupe fluoroalkyle à chaîne droite possédant 1 à 40 atomes de C, ou un groupe fluoroalkyle ramifié ou cyclique possédant 3 à 40 atomes de C, chacun desquels pouvant être substitué par un ou plusieurs radicaux $R^4$, dans lesquels un ou plusieurs groupes $CH_2$ non adjacents peuvent être remplacés par $R^4C=CR^4$, C=C, $Si(R^4)2$, C=O, C=S, $C=NR^4$, $P(=O) (R^4)$, SO, $SO_2$, $NR^4$, O, S ou $CONR^4$ et dans lesquels un ou plusieurs atomes de H peuvent être remplacés par D, Cl, Br, I ou CN, ou un système cyclique monocyclique ou polycyclique, aromatique ou hétéroaromatique possédant 5 à 60 atomes de cycle aromatique, qui peut en chaque cas être substitué par un ou plusieurs radicaux $R^4$, dans lesquels les radicaux $R^1$ et $R^3$ ou les radicaux $R^2$ et $R^3$ peuvent former un système cyclique monocyclique ou polycyclique, aliphatique, aromatique et/ou benzocondensé l'un avec l'autre ;

$R^3$ est choisi dans le groupe constitué par H, D, un groupe alkyle à chaîne droite possédant 1 à 40 atomes de C ou un alkyle ramifié ou cyclique possédant 3 à 40 atomes de C, chacun desquels pouvant être substitué par un ou plusieurs radicaux $R^4$, dans lesquels un ou plusieurs groupes $CH_2$ non adjacents peuvent être remplacés par $R^4C=CR^4$, C=C, $Si(R^4)2$, C=O, C=S, $C=NR^4$, $P(=O) (R^4)$, SO, $SO_2$, $NR^4$, O, S ou $CONR^4$ et dans lesquels un ou plusieurs atomes de H peuvent être remplacés par D, F, Cl, Br, I ou CN, ou un système cyclique monocyclique ou polycyclique, aromatique ou hétéroaromatique possédant 5 à 60 atomes de cycle aromatique, qui peut en chaque cas être substitué par un ou plusieurs radicaux $R^4$;

$R^4$ est en chaque occurrence, de manière identique ou différente, H, D, F ou un radical organique aliphatique, aromatique ou hétéroaromatique possédant 1 à 20 atomes de C, dans lequel, de plus, un ou plusieurs atomes de H peuvent être remplacés par D ou F ; deux substituants $R^5$ ou plus pouvant ici être liés l'un à l'autre et pouvant former un cycle ;

p est 0, 1 ou 2 ;

q est un nombre égal à 1, 2, 3 ou 4, qui correspond au nombre d'oxydation de M ; et

l'au moins un matériau de transport de trous et/ou un matériau d'injection de trous étant un polymère comprenant au moins un motif structural de la formule suivante (I) ou un composé de formule (I') :

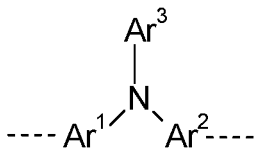

(I)

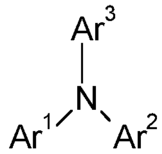

(I′)

dans lesquelles

$Ar^1$ à $Ar^3$ sont en chaque occurrence, en chaque cas de manière identique ou différente, un système cyclique monocyclique ou polycyclique, aromatique ou hétéroaromatique possédant 5 à 60 atomes de cycle aromatique, qui peut être substitué par un ou plusieurs radicaux $R^5$ ;

$R^5$ est en chaque occurrence, de manière identique ou différente, H, D, F, Cl, Br, I, $N(R^6)_2$, CN, $NO_2$, $Si (R^6)_3$, $B(OR^6)_2$, $C(=O)R^6$, $P(=O)(R^6)_2$, $S(=O)R^6$, $S(=O)_2R^6$, $OSO_2R^6$, un groupe alkyle, alcoxy ou thioalcoxy à chaîne droite possédant 1 à 40 atomes de C ou un groupe alkyle, alcoxy ou thioalcoxy ramifié ou cyclique possédant 3 à 40 atomes de C, chacun desquels pouvant être substitué par un ou plusieurs radicaux $R^6$, dans lesquels un ou plusieurs groupes $CH_2$ non adjacents peuvent être remplacés par $R^6C=CR^6$, C≡C, $Si(R^6)_2$, C=O, C=S, $C=NR^6$, $P(=O) (R^6)$, SO, $SO_2$, $NR^6$, O, S ou $CONR^6$ et dans lesquels un ou plusieurs atomes de H peuvent être remplacés par D, F, Cl, Br, I ou CN, ou un système cyclique monocyclique ou polycyclique, aromatique ou hétéroaromatique possédant 5 à 60 atomes de cycle aromatique, qui peut en chaque cas être substitué par un ou plusieurs radicaux $R^6$, ou un groupe aryloxy ou hétéroaryloxy possédant 5 à 60 atomes de cycle aromatique, qui peut être substitué par un ou plusieurs radicaux $R^6$, ou un groupe aralkyle ou hétéroaralkyle possédant 5 à 60 atomes de cycle aromatique, qui peut être substitué par un ou plusieurs radicaux $R^6$, ou un groupe diarylamino, un groupe dihétéroarylamino ou un groupe arylhétéroarylamino possédant 10 à 40 atomes de cycle aromatique, qui peut être substitué par un ou plusieurs radicaux $R^6$, dans lesquels deux radicaux $R^5$ ou plus peuvent également former un système cyclique monocyclique ou polycyclique, aliphatique, aromatique et/ou benzocondensé l'un avec l'autre ;

$R^6$ est en chaque occurrence, de manière identique ou différente, H, D, F ou un radical hydrocarboné aliphatique possédant 1 à 20 atomes de C, un radical hydrocarboné aromatique et/ou un radical hydrocarboné hétéroaromatique possédant 5 à 20 atomes de C, dans lesquels, de plus, un ou plusieurs atomes de H peuvent être remplacés par F ; dans lesquels deux substituants $R^6$ ou plus peuvent également former un système cyclique monocyclique ou polycyclique, aliphatique ou aromatique l'un avec l'autre ; et

les lignes en pointillés dans la formule (I) représentent des liaisons aux motifs structuraux adjacents dans le polymère, et dans lesquelles au moins l'un parmi $Ar^1$, $Ar^2$ et/ou $Ar^3$ est substitué par un radical $R^5$ comprenant au moins 2 atomes de C.

**2.** Composition selon la revendication 1, M étant choisi parmi Sn, Bi et Te, plus préférablement Bi.

**3.** Composition selon la revendication 1, le ligand neutre L étant choisi parmi des ligands bipyridine, phénanthroline, oxyde de phosphine, phosphonimido et sulfoxyde, chacun desquels pouvant être substitué par un ou plusieurs radicaux $R^4$ tels que définis dans la revendication 1.

**4.** Composition selon l'une ou plusieurs des revendications précédentes, au moins un parmi les radicaux $R^1$ et $R^2$ étant choisi dans le groupe constitué par F, CN, $NO_2$, un groupe fluoroalkyle à chaîne droite possédant 1 à 40 atomes de C ou un groupe fluoroalkyle ramifié ou cyclique possédant 3 à 40 atomes de C, chacun desquels pouvant être substitué par un ou plusieurs radicaux $R^4$, ou un groupe aryle ou hétéroaryle possédant 5 à 30 atomes de cycle aromatique, qui peut en chaque cas être substitué par un ou plusieurs radicaux $R^4$.

**5.** Composition selon l'une ou plusieurs des revendications précédentes, au moins un parmi les radicaux $R^1$ et $R^2$ étant choisi dans le groupe constitué par F, CN, $NO_2$, un groupe (per)fluoroalkyle à chaîne droite possédant 1 à 14 atomes de C ou un groupe perfluoroalkyle ramifié ou cyclique possédant 3 à 14 atomes de C, ou un groupe aryle ou hétéroaryle possédant 5 à 14 atomes de cycle aromatique, qui peut en chaque cas être substitué par un ou plusieurs radicaux $R^4$.

**6.** Composition selon l'une ou plusieurs des revendications précédentes, $R^3$ étant choisi dans le groupe constitué par H, D, un groupe alkyle à chaîne droite possédant 1 à 4 atomes de C ou un alkyle ramifié ou cyclique possédant 3 à 4 atomes de C, chacun desquels pouvant être substitué par un ou plusieurs radicaux $R^4$, ou un groupe aryle ou hétéroaryle possédant 5 à 14 atomes de cycle aromatique, qui peut en chaque cas être substitué par un ou plusieurs radicaux $R^4$.

**7.** Composition selon l'une ou plusieurs des revendications précédentes, l'au moins un matériau de transport de trous et/ou un matériau d'injection de trous étant un polymère de formule (I) comprenant au moins un motif structural de l'une des formules suivantes (II), (III) et (IV) :

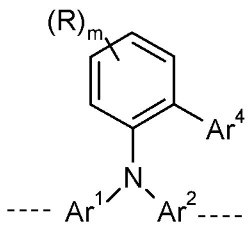
(II)

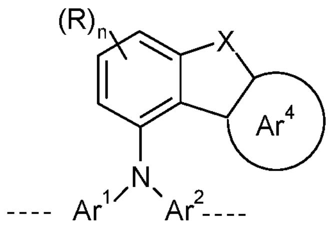
(III)

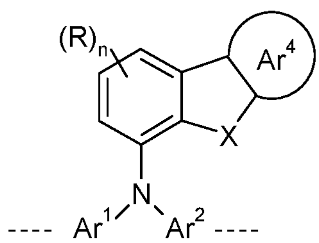
(IV)

ou l'au moins un matériau de transport de trous et/ou un matériau d'injection de trous étant un composé de formule (I') choisi parmi la formule suivante (II'), (III') ou (IV') :

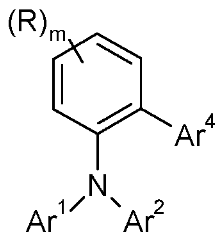
(II´)

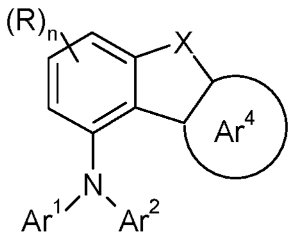
(III´)

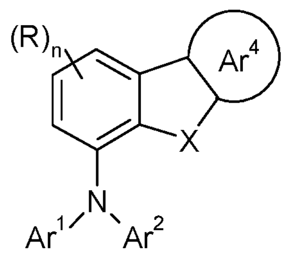
(IV´)

dans lesquelles $Ar^1$, $Ar^2$ peuvent adopter la signification indiquée dans la revendication 1,
$Ar^4$ est un système cyclique monocyclique ou polycyclique, aromatique ou hétéroaromatique possédant 5 à 60 atomes de cycle aromatique, qui peut être substitué par un ou plusieurs radicaux R, R est en chaque occurrence,

de manière identique ou différente, H, D, F, Cl, Br, I, $N(R^1)_2$, CN, $NO_2$, $Si(R^1)_3$, $B(OR^1)_2$, $C(=O)R^1$, $P(=O)(R^1)_2$, $S(=O)R^1$, $S(=O)_2R^1$, $OSO_2R^1$, un groupe alkyle, alcoxy ou thioalcoxy à chaîne droite possédant 1 à 40 atomes de C ou un groupe alkyle, alcoxy ou thioalcoxy ramifié ou cyclique possédant 3 à 40 atomes de C, chacun desquels pouvant être substitué par un ou plusieurs radicaux $R^1$, dans lesquels un ou plusieurs groupes $CH_2$ non adjacents peuvent être remplacés par $R^1C=CR^1$, C≡C, $Si(R^1)_2$, C=O, C=S, $C=NR^1$, $P(=O)(R^1)$, SO, $SO_2$, $NR^1$, O, S ou $CONR^1$ et dans lesquels un ou plusieurs atomes de H peuvent être remplacés par D, F, Cl, Br, I ou CN, ou un système cyclique monocyclique ou polycyclique, aromatique ou hétéroaromatique possédant 5 à 60 atomes de cycle aromatique, qui peut en chaque cas être substitué par un ou plusieurs radicaux $R^1$, ou un groupe aryloxy ou hétéroaryloxy possédant 5 à 60 atomes de cycle aromatique, qui peut être substitué par un ou plusieurs radicaux $R^1$, ou un groupe aralkyle ou hétéroaralkyle possédant 5 à 60 atomes de cycle aromatique, qui peut être substitué par un ou plusieurs radicaux $R^1$, ou un groupe diarylamino, un groupe dihétéroarylamino ou un groupe arylhétéroarylamino possédant 10 à 40 atomes de cycle aromatique, qui peut être substitué par un ou plusieurs radicaux $R^1$, ou un groupe réticulable Q, dans lequel deux radicaux R ou plus peuvent également former un système cyclique monocyclique ou polycyclique, aliphatique, aromatique et/ou benzocondensé l'un avec l'autre et $R^1$ peut adopter la signification indiquée dans la revendication 1,

m = 0, 1, 2, 3 ou 4,
n = 0, 1, 2 ou 3, et
X = $CR_2$, NR, $SiR_2$, O, S, C=O ou P=O, préférablement $CR_2$, NR, ° ou S.

**8.** Utilisation d'un complexe métallique de formule (MC-1) tel que défini dans la revendication 1 en tant que dopant p dans un dispositif électronique, préférablement dans un dispositif électroluminescent organique, un transistor organique à effet de champ, un circuit intégré organique, des transistors organiques en films minces, un transistor organique luminescent, une cellule solaire organique, un détecteur optique organique, un photorécepteur organique, un dispositif organique d'extinction de champ, une cellule électrochimique luminescente ou une diode laser organique.

**9.** Formulation comprenant au moins un matériau de transport de trous et/ou un matériau d'injection de trous de formule (I) ou (I') tel que défini dans la revendication 1, au moins un complexe métallique de formule (MC-1) tel que défini dans la revendication 1 en tant que dopant p et au moins un solvant.

**10.** Procédé pour la production d'un dispositif électronique, au moins une couche étant obtenue par le dépôt d'une composition selon l'une des revendications précédentes 1 à 7 ou par l'application d'une formulation selon la revendication 9.

**11.** Dispositif électronique comprenant une structure multicouche, au moins une couche comprenant une composition telle que définie dans l'une des revendications précédentes 1 à 7.

**12.** Dispositif électronique selon la revendication 11, le dispositif électronique étant choisi dans le groupe constitué par des dispositifs électroluminescents organiques, des circuits intégrés organiques, des transistors organiques à effet de champ, des transistors organiques en films minces, des transistors organiques luminescents, des cellules solaires organiques, des détecteurs optiques organiques, des photorécepteurs organiques, des dispositifs organiques d'extinction de champ, des cellules électrochimiques luminescentes, des diodes laser organiques, et préférablement des diodes luminescentes organiques.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- WO 2009021107 A1
- WO 2010006680 A1
- WO 2013182389 A
- WO 2005061654 A1
- WO 2003048225 A
- WO 2012034627 A
- WO 2004037887 A
- WO 2010097155 A

### Non-patent literature cited in the description

- *CHEMICAL ABSTRACTS,* 141364-06-9
- *CHEMICAL ABSTRACTS,* 141364-07-0
- *CHEMICAL ABSTRACTS,* 157442-60-9